# EUROPEAN PATENT SPECIFICATION

(11) **EP 3 909 964 B1**
(45) Date of publication and mention of the grant of the patent: **08.10.2025**
(21) Application number: 21173643.4
(22) Date of filing: 12.05.2021
(51) Int. Cl.: C07F 15/00, C09K 11/06, H10K 85/30

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHES GERÄT MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 14.05.2020 KR 20200057820
(43) Date of publication of application: 17.11.2021
(73) Proprietor: Samsung Display Co., Ltd., Yongin-si, Gyeonggi-do 17113 (KR)
(72) Inventor: CHOI, Jongwon, 16678 Gyeonggi-do (KR); CHO, Yongsuk, 16678 Gyeonggi-do (KR); KWAK, Seungyeon, 16678 Gyeonggi-do (KR); KIM, Sangdong, 16678 Gyeonggi-do (KR); KIM, Soyeon, 16678 Gyeonggi-do (KR); ARATANI, Sukekazu, 16678 Gyeonggi-do (KR); LEE, Sunghun, 16678 Gyeonggi-do (KR); LEE, Jiyoun, 16678 Gyeonggi-do (KR); KRAVCHUK, Dmitry, 16678 Gyeonggi-do (KR)
(74) Representative: Marks & Clerk LLP

(56) References cited:
- EP-A1- 3 301 088
- EP-A1- 3 398 953
- EP-A1- 3 644 384
- EP-A1- 3 778 614
- EP-A1- 3 842 444
- WO-A1-2019/109886
- WO-A1-2019/221445
- WO-A1-2019/221446
- US-A1- 2018 097 187
- US-A1- 2018 240 988
- US-A1- 2019 237 683
- US-A1- 2019 248 818
- US-A1- 2019 280 213

## Description

### FIELD OF THE INVENTION

One or more embodiments relate to an organometallic compound, an organic light-emitting device including the same, and an electronic apparatus including the organic light-emitting device.

### BACKGROUND OF THE INVENTION

Organic light-emitting devices are self-emission devices, which have improved characteristics in terms of viewing angles, response time, brightness, driving voltage, and response speed, and produce full-color images.

In an example, an organic light-emitting device includes an anode, a cathode, and an organic layer located between the anode and the cathode, wherein the organic layer includes an emission layer. A hole transport region may be between the anode and the emission layer, and an electron transport region may be between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons transition from an excited state to a ground state to thereby generate light (for example, visible light).

US 2019/280213 discloses compounds useful as the host material in an EML suitable for red emitters having deep HOMO levels.

EP 3 644 384, WO 2019/221446 and US 2019/248818 disclose organic light emitting diodes (OLEDs).

EP 3 398 953 discloses ligands for cyclometalated complexes that provide near-infrared emission.

WO 2019/109886 discloses an organic electroluminescent compound for use in an OLED.

EP 3 301 088 and US 2019/237683 disclose phosphorescent metal complexes useful as emitters in OLEDs.

### SUMMARY OF THE INVENTION

One or more embodiments relate to an organometallic compound, an organic light-emitting device including the same, and an electronic apparatus including the organic light-emitting device.

Additional aspects will be set forth in part in the description which follows and, in part, will be apparent from the description, or may be learned by practice of the presented embodiments of the disclosure.

According to one aspect of the invention, an organometallic compound is provided in accordance with claim 1.

According to an embodiment, provided is an organic light-emitting device including a first electrode, a second electrode, and an organic layer including an emission layer located between the first electrode and the second electrode, wherein the organic layer includes at least one organometallic compound represented by Formula 1.

The organometallic compound may be included in an emission layer of the organic layer, and the organometallic compound included in the emission layer may act as a dopant.

Another embodiment of the present invention provides an electronic apparatus including the organic light-emitting device.

### BRIEF DESCRIPTION OF THE DRAWING

The above and other aspects, features, and advantages of certain embodiments of the disclosure will be more apparent from the following description taken in conjunction with the accompanying drawing, in which
FIGURE which shows a schematic cross-sectional view of an organic light-emitting device according to an embodiment.

### DETAILED DESCRIPTION OF THE EMBODIMENTS

An aspect of the present disclosure provides an organometallic compound represented by Formula 1 below:

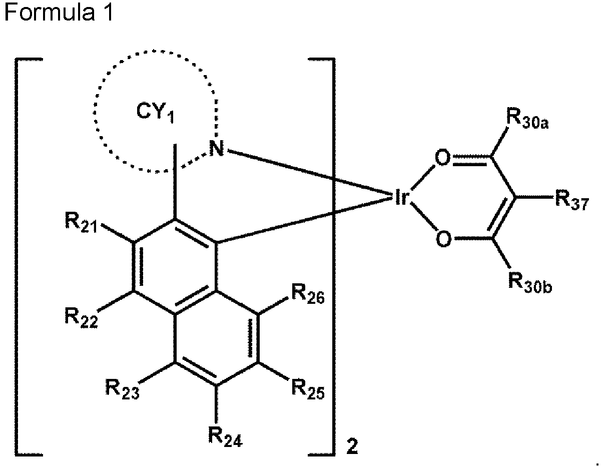

Ring CY₁ in Formula 1 is a group represented by one of Formulae CY1-1 to CY1-9: 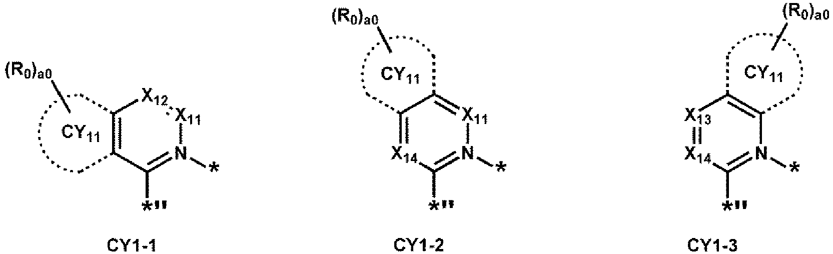 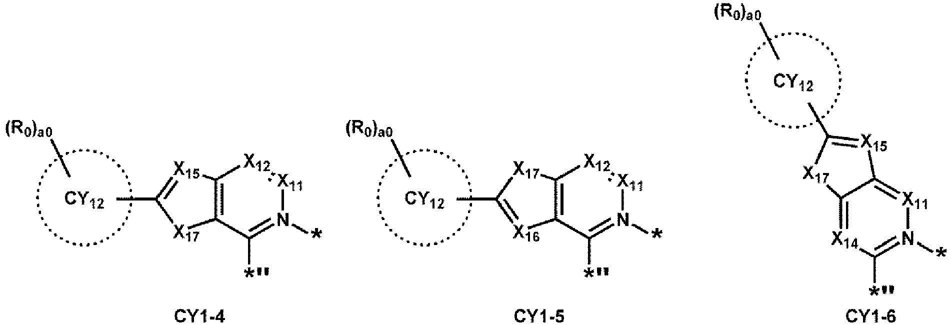 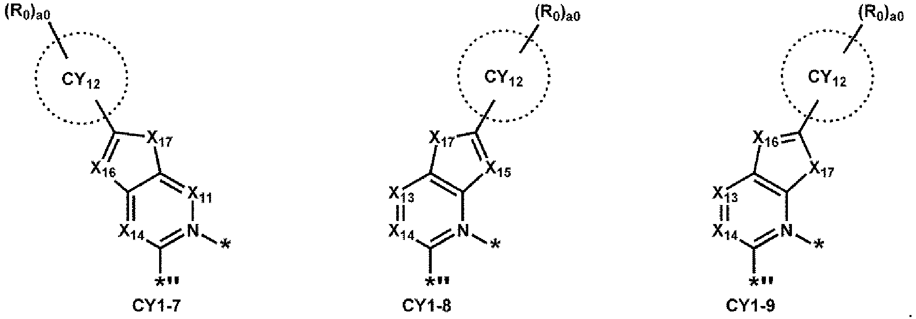 * in Formulae CY1-1 to CY1-9 indicates a binding site to Ir in Formula 1, and *" indicates a binding site to a neighboring carbon atom.

Ring CY₁₁ in Formulae CY1-1 to CY1-3 is a polycyclic group in which two or more cyclic groups are condensed with each other, and the cyclic group and ring CY₁₂ in Formulae CY1-4 to CY1-9 are each a C₅-C₃₀ carbocyclic group or a C₁-C₃₀ heterocyclic group.

In an embodiment, ring CY₁₁ in Formulae CY1-1 to CY1-3 may be a) a condensed cyclic group in which two or more first rings are condensed with each other, b) a condensed cyclic group in which two or more second rings are condensed with each other, or c) a condensed cyclic group in which at least one first ring is condensed with at least one second ring,
ring CY₁₂ in Formulae CY1-4 to CY1-9 may be i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
the first ring may be a cyclopentane group, a cyclopentene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring may be an adamantane group, a norbornane group(or, bicyclo[2.2.1]heptane group), a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

In an embodiment, ring CY₁₁ in Formulae CY1-1 to CY1-3 may be a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a quinoline group, an isoquinoline group, a quinoxaline group, a quinazoline group, a phenanthroline group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group.

In one or more embodiments, ring CY₁₁ in Formulae CY1-1 to CY1-3 may be a naphthalene group, an anthracene group, a phenanthrene group, a triphenylene group, a pyrene group, a chrysene group, a 1,2,3,4-tetrahydronaphthalene group, a quinoline group, an isoquinoline group, a quinoxaline group, a quinazoline group, a phenanthroline group, a 5,6,7,8-tetrahydroisoquinoline group, or a 5,6,7,8-tetrahydroquinoline group.

In one or more embodiments, ring CY₁₁ in Formulae CY1-1 to CY1-3 may be a naphthalene group or a phenanthrene group.

**In** one or more embodiments, ring CY₁₂ in Formulae CY1-4 to CY1-9 may be a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a thiophene group, a furan group, a pyrrole group, a cyclopentadiene group, a silole group, a borole group, a phosphole group, a selenophene group, a germole group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, a 5,6,7,8-tetrahydroquinoline group, an adamantane group, a norbornane group, or a norbornene group.

In one or more embodiments, ring CY₁₂ in Formulae CY1-4 to CY1-9 may be a benzene group, a naphthalene group, an anthracene group, a phenanthrene group, a triphenylene group, a pyrene group, a chrysene group, a 1,2,3,4-tetrahydronaphthalene group, a thiophene group, a dibenzothiophene group, a dibenzofuran group, a carbazole group, a fluorene group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, or a phenanthroline group.

In one or more embodiments, ring CY₁₂ in Formulae CY1-4 to CY1-9 may be a benzene group, a thiophene group, or a pyridine group.

In one or more embodiments, ring CY₁ in Formula 1 may be a benzoquinoline group, a benzoisoquinoline group, a naphthoquinoline group, a naphthoisoquinoline group, a pyridofuran group, or a pyridothiophene group.

Regarding Formulae CY1-1 to CY1-9, X₁₁ is C(R₁₁) or N, X₁₂ is C(R₁₂) or N, X₁₃ is C(R₁₃) or N, X₁₄ is C(R₁₄) or N, X₁₅ is C(R₁₅) or N, X₁₆ is C(R₁₆) or N, and X₁₇ is O, S, N(R₁₇), C(R₁₈)(R₁₉) or Si(R₁₈)(R₁₉).

Regarding Formulae CY1-1 to CY1-9, X₁₁ may be C(R₁₁), X₁₂ may be C(R₁₂), X₁₃ may be C(R₁₃), X₁₄ may be C(R₁₄), X₁₅ may be C(R₁₅), X₁₆ may be C(R₁₆). In one embodiment, X₁₇ may be O or S.

R₃₀ₐ in Formula 1 is a group represented by *-C(R₃₁)(R₃₂)(R₃₃), a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group. R₃₁ to R₃₃ are the same as described in the present specification.

In one or more embodiments, R₃₀ₐ in Formula 1 may be a group represented by *-C(R₃₁)(R₃₂)(R₃₃).

In one or more embodiments, R₃₀ₐ in Formula 1 may be a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₂-C₂₀ alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof.

R_{30b} is a group represented by *-C(R₃₄)(R₃₅)(R₃₆).

R₀, R₁₁ to R₁₉, R₂₁ to R₂₆, and R₃₁ to R₃₆ in the formulae above are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), - B(Q₆)(Q₇), -P(=O)(Q₈)(Q₉), or -P(Q₈)(Q₉), and each of R₃₁ to R₃₆ is not hydrogen. Q₁ to Q₉ are the same as described in the present specification.

In one or more embodiments, each of R₃₁ to R₃₃ may not be hydrogen and deuterium.

For example, R₀, R₁₁ to R₁₉, R₂₁ to R₂₆, and R₃₁ to R₃₃ may each independently be:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, -SF₅, C₁-C₂₀ alkyl group, a C₂-C₂₀ alkenyl group, a C₁-C₂₀ alkoxy group, or a C₁-C₂₀ alkylthio group;
a C₁-C₂₀ alkyl group, a C₂-C₂₀ alkenyl group, a C₁-C₂₀ alkoxy group, or a C₁-C₂₀ alkylthio group, each substituted with deuterium, -F, -Cl, -Br, -I, -CD₃, -CD₂H, - CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a pyridinyl group, a pyrimidinyl group, or any combination thereof;
a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group or azadibenzothiophenyl group, each unsubstituted or substituted with deuterium, -F, - Cl, -Br, -I, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a deuterated C₂-C₂₀ alkyl group, a C₁-C₂₀ alkoxy group, a cyclopentyl group, a cyclohexyl group, a cycloheptyl group, a cycloctyl group, an adamantanyl group, a norbornanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.2]octyl group, a (C₁-C₂₀ alkyl)cyclopentyl group, a (C₁-C₂₀ alkyl)cyclohexyl group, a (C₁-C₂₀ alkyl)cycloheptyl group, a (C₁-C₂₀ alkyl)cycloctyl group, a (C₁-C₂₀ alkyl)adamantanyl group, a (C₁-C₂₀ alkyl)norbornanyl group, a (C₁-C₂₀ alkyl)norbornenyl group, a (C₁-C₂₀ alkyl)cyclopentenyl group, a (C₁-C₂₀ alkyl)cyclohexenyl group, a (C₁-C₂₀ alkyl)cycloheptenyl group, a (C₁-C₂₀ alkyl)bicyclo[1.1.1]pentyl group, a (C₁-C₂₀ alkyl)bicyclo[2.1.1]hexyl group, a (C₁-C₂₀ alkyl)bicyclo[2.2.2]octyl group, a phenyl group, a (C₁-C₂₀ alkyl)phenyl group, a biphenyl group, a terphenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or any combination thereof; or
-N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉);
wherein, each of R₃₁ to R₃₃ is not hydrogen,
wherein Q₁ to Q₉ may each independently be selected from:
   deuterium, -F, -CH₃, -CD₃, -CD₂H, -CDH₂, -CH₂CH₃, -CH₂CD₃, -CH₂CD₂H, - CH₂CDH₂, -CHDCH₃, -CHDCD₂H, -CHDCDH₂, -CHDCD₃, -CD₂CD₃, -CD₂CD₂H, - CD₂CDH₂, -CF₃, -CF₂H, -CFH₂, -CH₂CF₃, -CH₂CF₂H, -CH₂CFH₂, -CHFCH₃, - CHFCF₂H, -CHFCFH₂, -CHFCF₃, -CF₂CF₃, -CF₂CF₂H, or -CF₂CFH₂; or
   an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with deuterium, -F, C₁-C₁₀ alkyl group, a phenyl group, or any combination thereof.

In one embodiment, R₀, R₁₁ to R₁₉, R₂₁ to R₂₆, and R₃₁ to R₃₃ may each independently be:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or

   -Si(Q₃)(Q₄)(Q₅), or -Ge(Q₃)(Q₄)(Q₅) ;
wherein each of R₃₁ to R₃₃ is not hydrogen.
R₃₇ in Formula 1 is hydrogen, deuterium, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In an embodiment, at least one of R₀(s) in the number of a0, at least one of R₁₁ to R₁₄, at least one of R₂₁ to R₂₆, R₃₀ₐ, R₃₇, or any combination thereof may each independently be:
deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or

   -Si(Q₃)(Q₄)(Q₅), or -Ge(Q₃)(Q₄)(Q₅).

In one or more embodiments, R₃₀ₐ may each independently be -CD₃, -CD₂H, - CDH₂, -CF₃, -CF₂H, -CFH₂, C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-237, a group represented by one of Formulae 9-201 to 9-237 in which at least one hydrogen is substituted with deuterium, a group represented by one of Formulae 9-201 to 9-237 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F.

In one or more embodiments, R₀, R₁₁ to R₁₉, R₂₁ to R₂₆, and R₃₁ to R₃₃ may each independently be hydrogen, deuterium, -F, -CH₃, -CD₃, -CD₂H, -CDH₂, -CF₃, - CF₂H, -CFH₂, C₂-C₁₀ alkenyl group, a C₁-C₁₀ alkoxy group, a C₁-C₁₀ alkylthio group, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-237, a group represented by one of Formulae 9-201 to 9-237 in which at least one hydrogen is substituted with deuterium, a group represented by one of Formulae 9-201 to 9-237 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, a group represented by one of Formulae 10-201 to 10-350 in which at least one hydrogen is substituted with -F, -Si(Q₃)(Q₄)(Q₅), or -Ge(Q₃)(Q₄)(Q₅) (Q₃ to Q₅ are the same as described in the present specification).

In one or more embodiments, R₃₇ may be hydrogen, deuterium, -CH₃, -CD₃, - CD₂H, -CDH₂, -CF₃, -CF₂H, -CFH₂, a group represented by one of Formulae 9-1 to 9-39, a group represented by one of Formulae 9-1 to 9-39 in which at least one hydrogen is substituted with deuterium, a group represented by one of Formulae 9-1 to 9-39 in which at least one hydrogen is substituted with -F, a group represented by one of Formulae 9-201 to 9-237, a group represented by one of Formulae 9-201 to 9-237 in which at least one hydrogen is substituted with deuterium, a group represented by one of Formulae 9-201 to 9-237 in which at least one hydrogen is substituted with -F, a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F.

In one or more embodiments, the group represented by 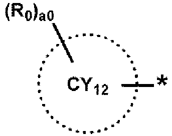 in Formulae CY1-4 to CY1-9 may be a group represented by one of Formulae 10-1 to 10-129, a group represented by one of Formulae 10-1 to 10-129 in which at least one hydrogen is substituted with deuterium, a group represented by one of Formulae 10-1 to 10-129 in which at least one hydrogen is substituted with -F, a group represented by one of Formulae 10-201 to 10-350, a group represented by one of Formulae 10-201 to 10-350 in which at least one hydrogen is substituted with deuterium, or a group represented by one of Formulae 10-201 to 10-350 in which at least one hydrogen is substituted with -F. 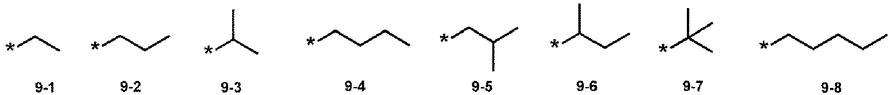 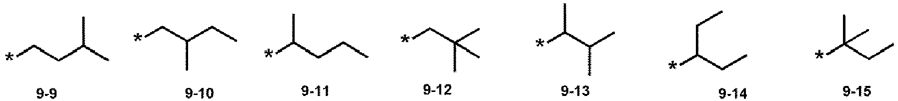 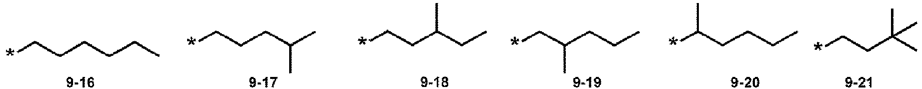 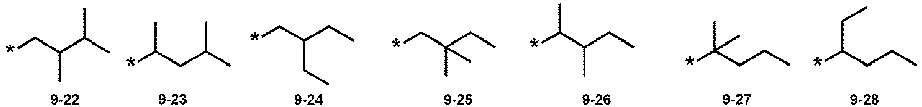 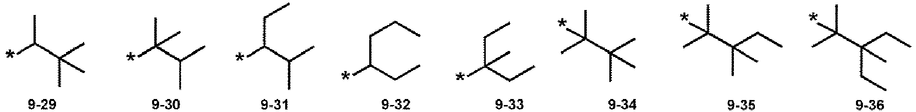 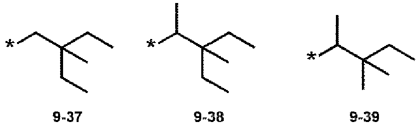 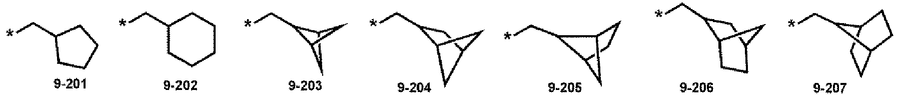 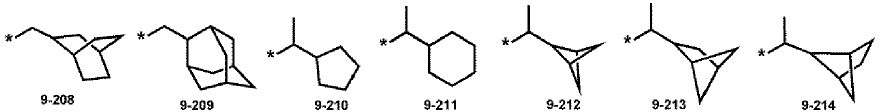 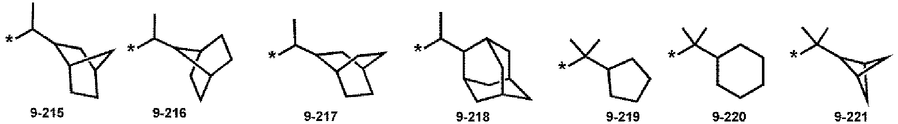 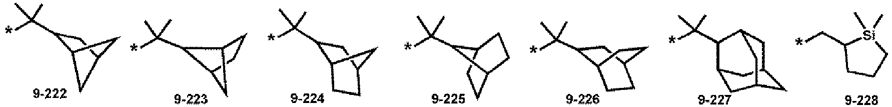 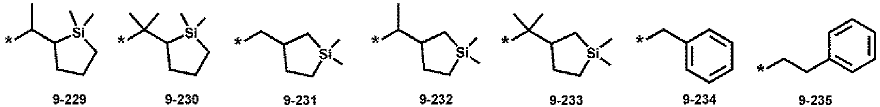 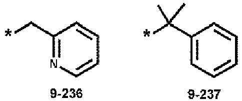 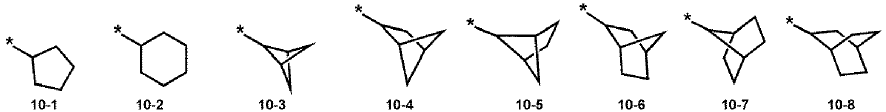 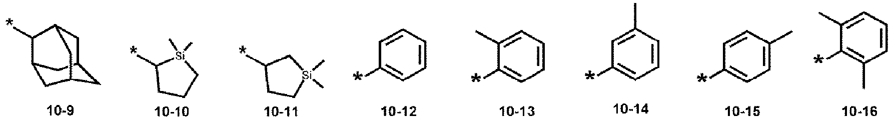 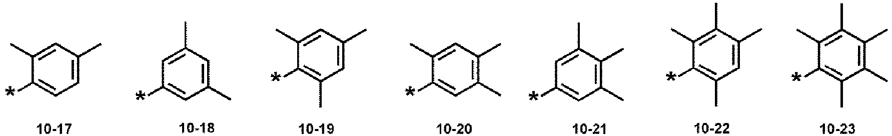 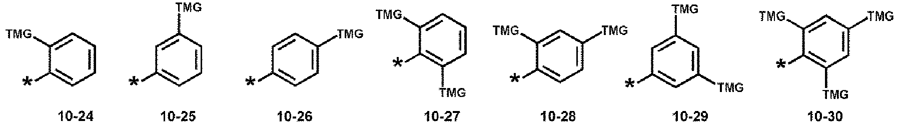 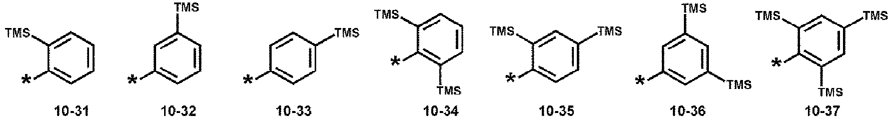 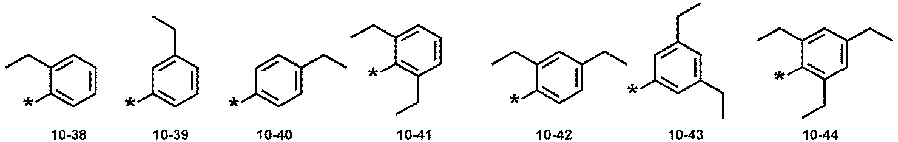 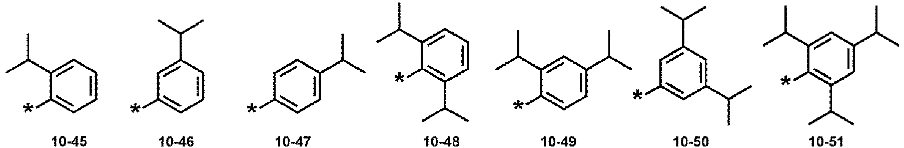 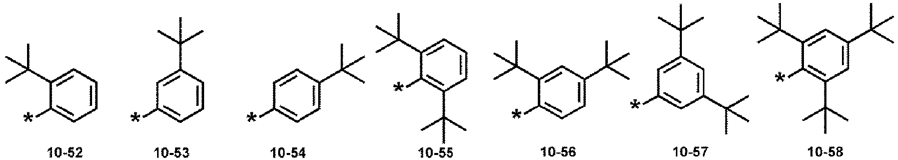 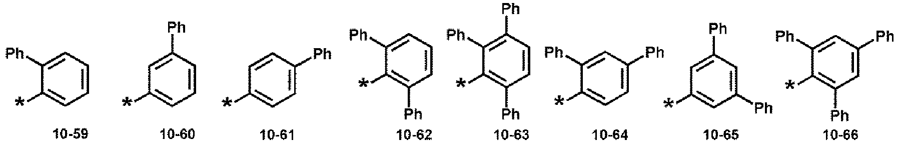 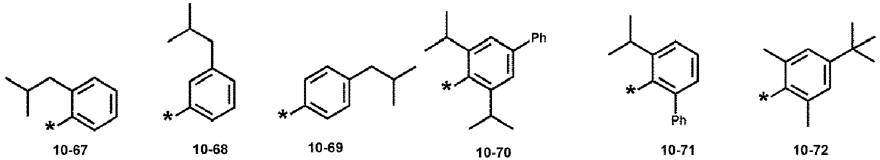 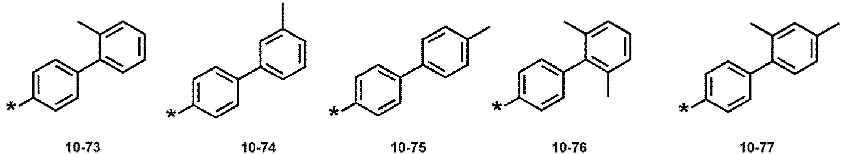 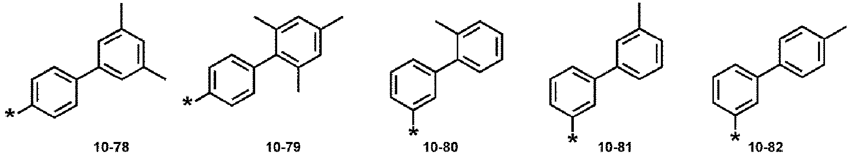 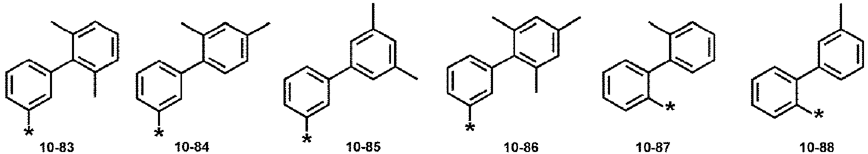 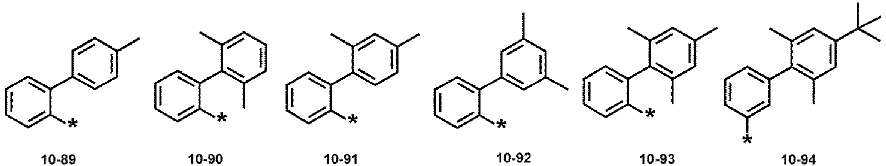 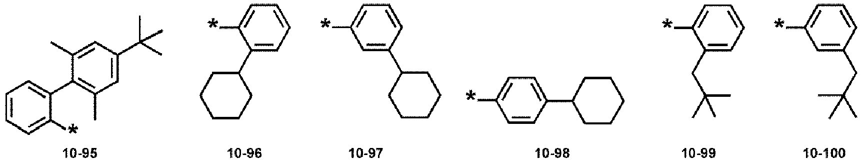 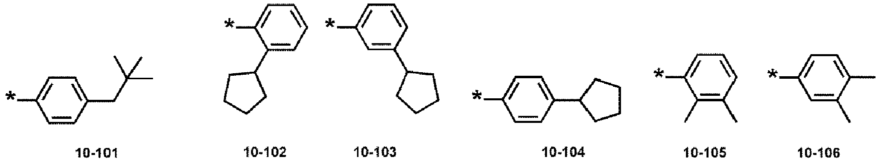 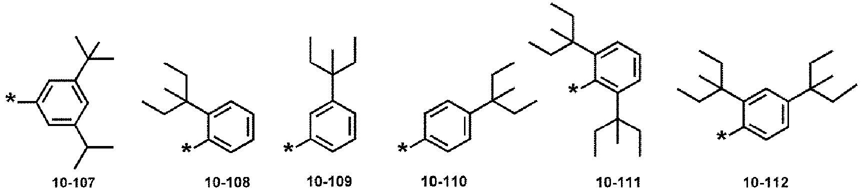 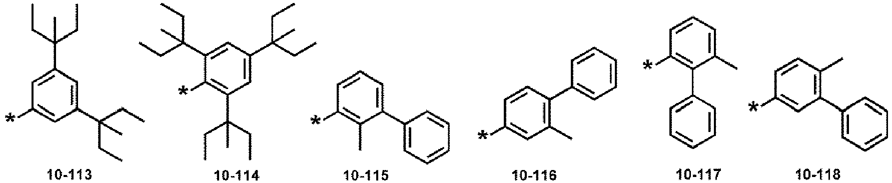 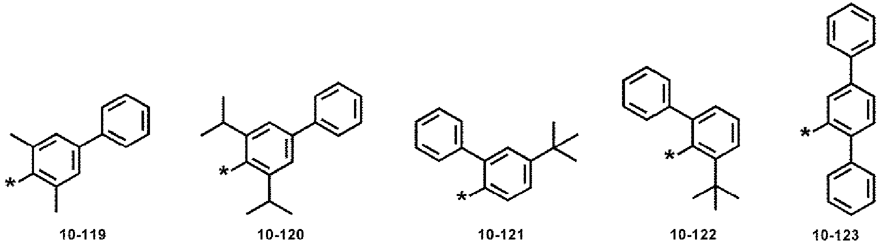 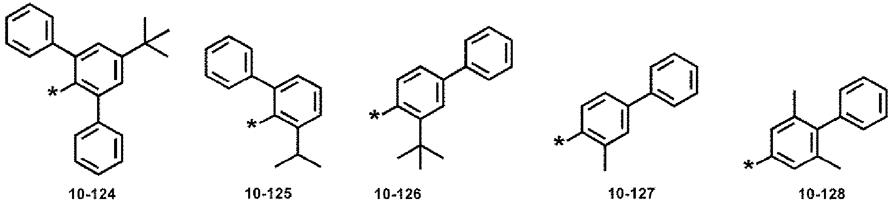 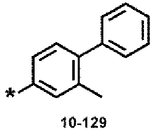 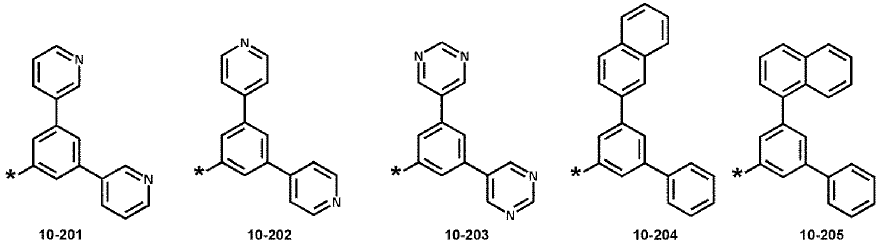 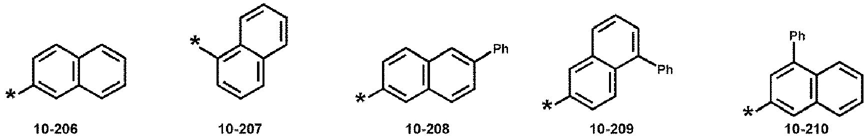 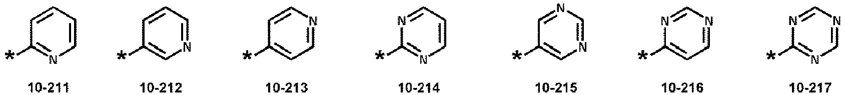 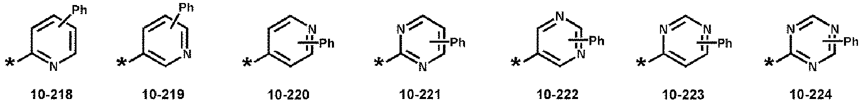 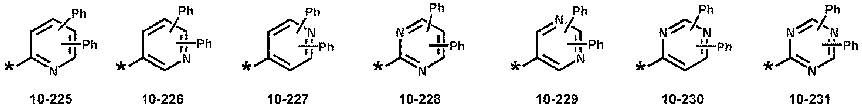 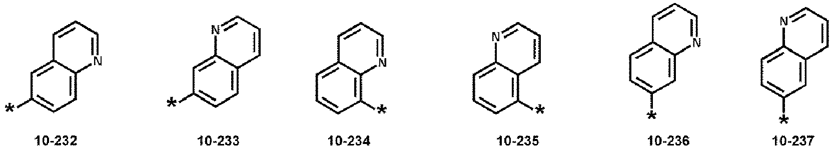 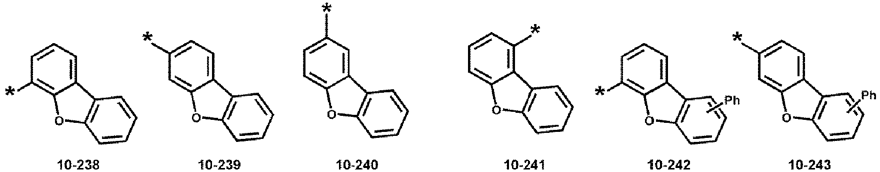 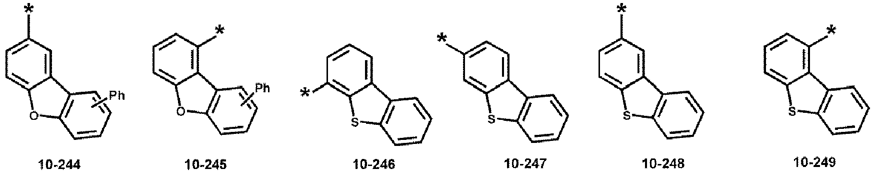 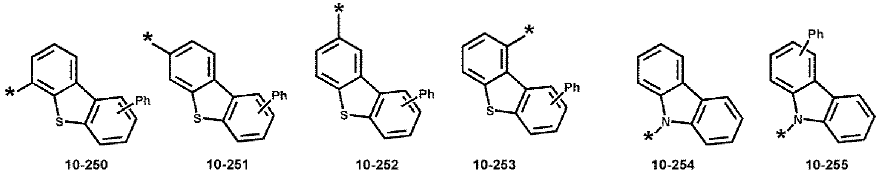 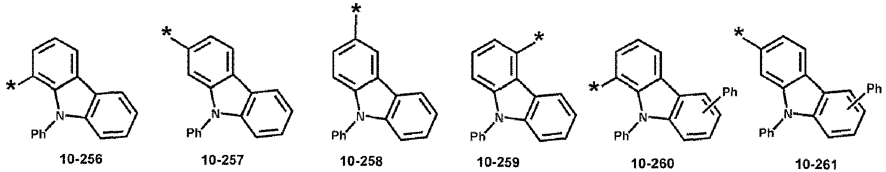 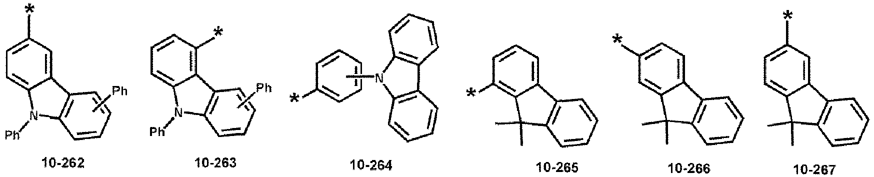 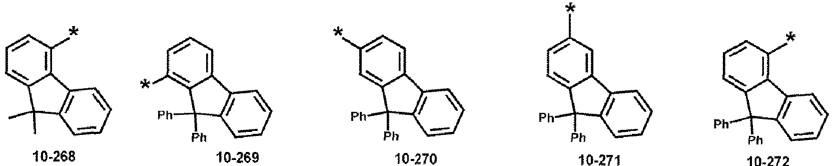 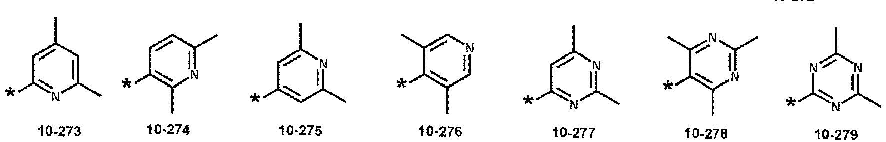 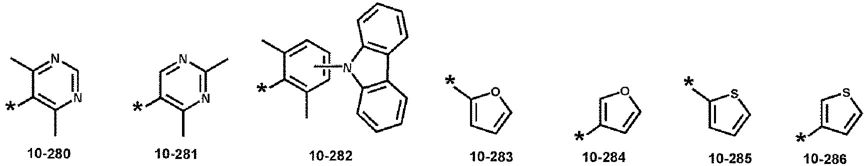 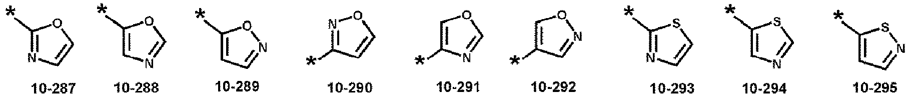 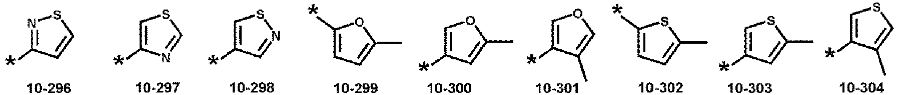 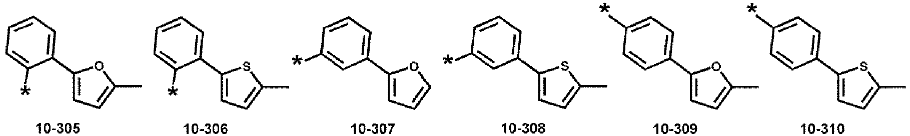 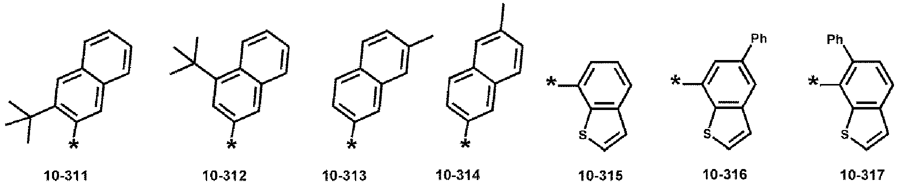 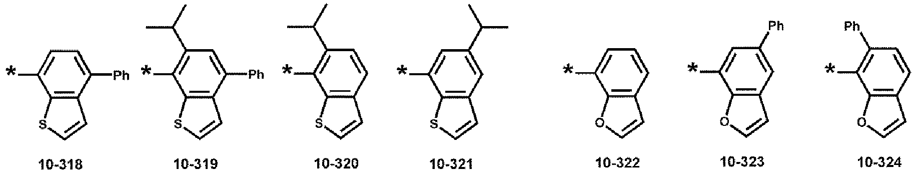 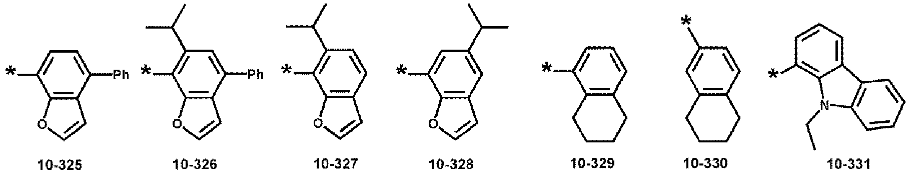 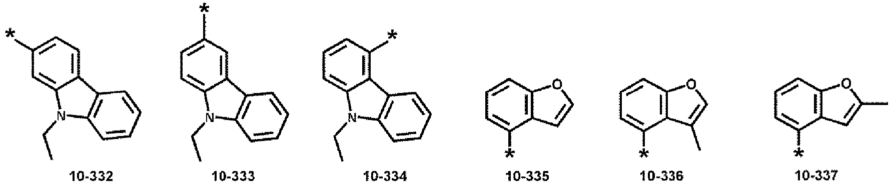 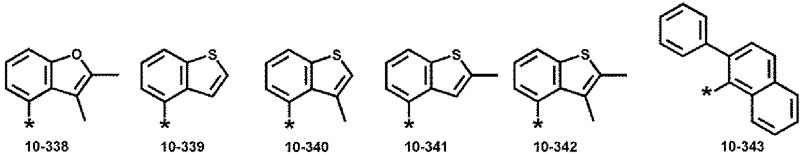 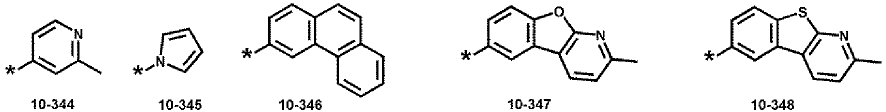 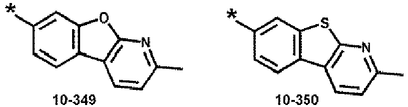 * in Formula 9-1 to 9-39, 9-201 to 9-237, 10-1 to 10-129 and 10-201 to 10-350 indicates a binding site to a neighboring atom, Ph is a phenyl group, TMS is a trimethylsilyl group, and TMG is a trimethylgermyl.

The "group represented by one of Formulae 9-1 to 9-39 in which at least one hydrogen is substituted with deuterium" and "the group represented by one of Formulae 9-201 to 9-237 in which at least one hydrogen is substituted with deuterium" may be, for example, a group represented by one of Formulae 9-501 to 9-514 and 9-601 to 9-636:

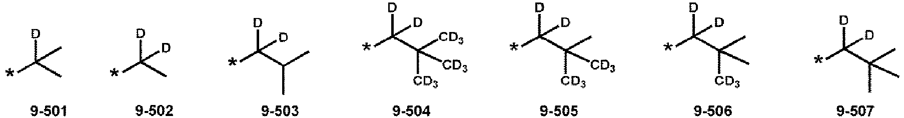

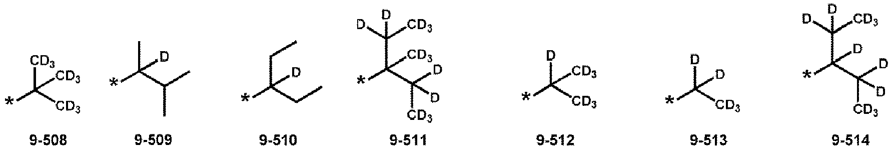

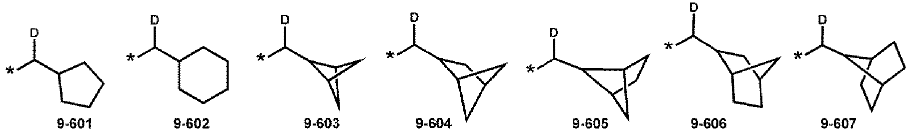

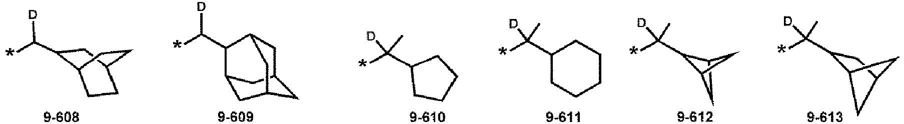

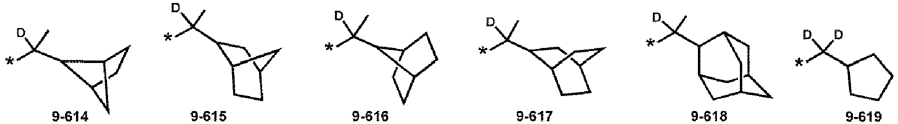

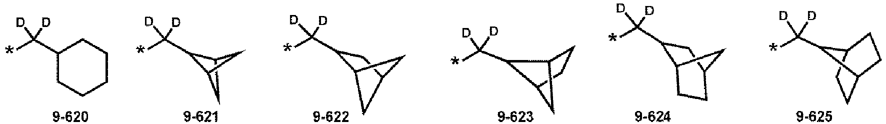

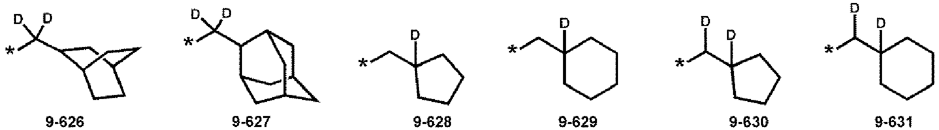

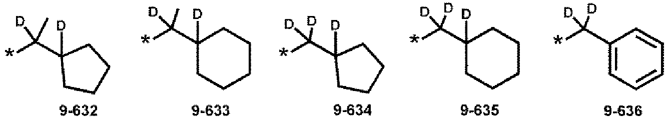

The "group represented by one of Formulae 9-1 to 9-39 in which at least one hydrogen is substituted with -F" and the "group represented by one of Formulae 9-201 to 9-236 in which at least one hydrogen is substituted with -F" may be, for example, a group represented by one of Formulae 9-701 to 9-710:

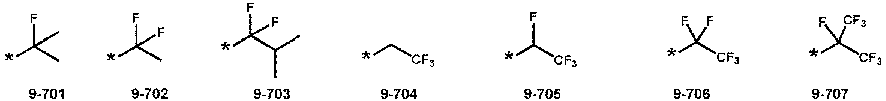

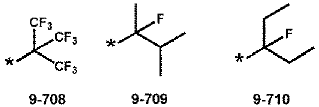

The "group represented by one of Formulae 10-1 to 10-129 in which at least one hydrogen is substituted with deuterium" and "the group represented by one of Formulae 10-201 to 10-350 in which at least one hydrogen is substituted with deuterium" may be, for example, a group represented by one of Formulae 10-501 to 10-553:

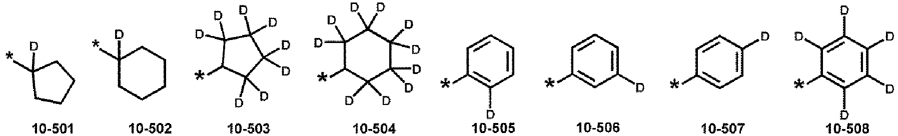

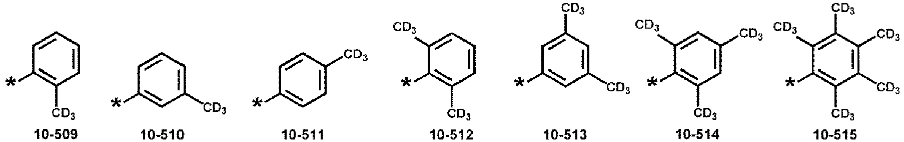

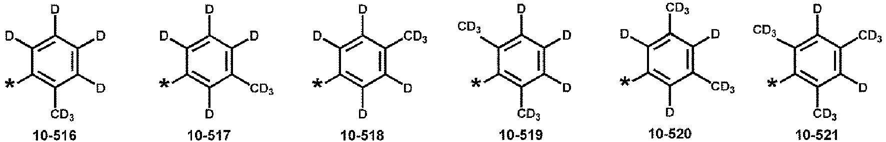

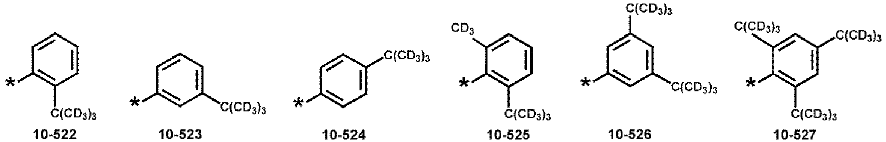

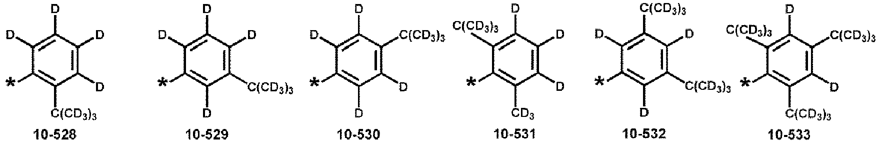

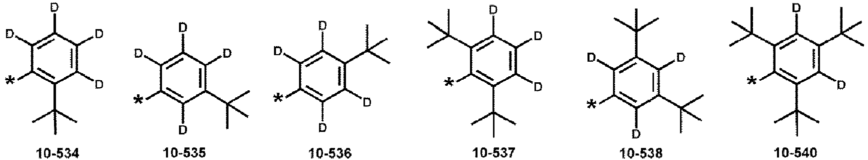

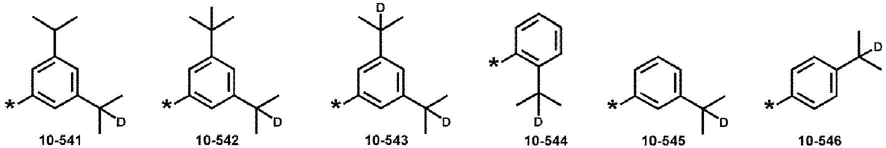

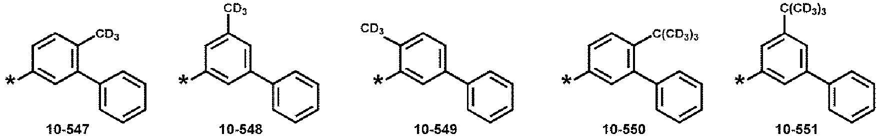

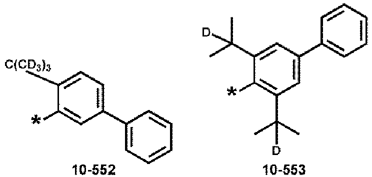

The "group represented by one of Formulae 10-1 to 10-129 in which at least one hydrogen is substituted with -F" and "the group represented by one of Formulae 10-201 to 10-350 in which at least one hydrogen is substituted with -F" may be, for example, a group represented by one of Formulae 10-601 to 10-617: 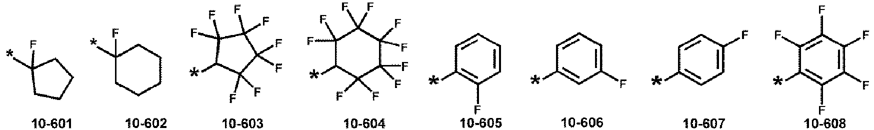 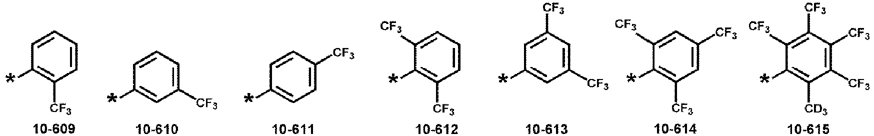 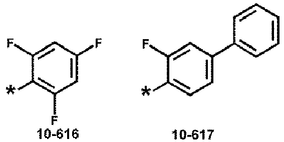 a₀ indicates the number of R₀ in Formulae CY1-1 to CY1-9, and may be an integer from 0 to 20. When a0 is 2 or more, two or more of R₀(s) may be identical to or different from each other. For example, a0 may be an integer from 0 to 8.

In an embodiment, at least one of R₂₁ to R₂₆ of Formula 1 may not be hydrogen.

In an embodiment, at least one of R₂₃ to R₂₆ of Formula 1 may not be hydrogen.

In an embodiment, at least one of R₂₁ to R₂₆ of Formula 1 may each independently be:
deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or

   -Si(Q₃)(Q₄)(Q₅), or -Ge(Q₃)(Q₄)(Q₅).

In an embodiment, at least one of R₂₃ to R₂₆ of Formula 1 may each independently be -Si(Q₃)(Q₄)(Q₅), or -Ge(Q₃)(Q₄)(Q₅).

In one or more embodiments, ring CY₁ in Formula 1 may be a group represented by one of Formulae CY1-1 to CY1-3, at least one of R₀(s) in the number of a0 of Formulae CY1-1 to CY1-3 may each independently be deuterium, -F, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, ring CY₁ in Formula 1 may be a group represented by one of Formulae CY1-1 to CY1-3, and at least one of R₂₃ to R₂₆ may not be hydrogen.

In one or more embodiments, ring CY₁ in Formula 1 may be a group represented by Formula CY1-4, CY1-5 or CY1-7. For example, X₁₇ in Formulae CY1-4, CY1-5 and CY1-7 may be O, S or Se.

In one or more embodiments, ring CY₁ in Formula 1 may be a group represented by Formula CY1-4 or CY1-5. For example, X₁₇ in Formulae CY1-4 and CY1-5 may be O or S. In an embodiment, regarding Formulae CY1-4 and CY1-5, X₁₁ may be C(R₁₁), and X₁₂ may be C(R₁₂).

In one or more embodiments, a group represented by one of Formulae CY1-1 to CY1-3 may be a group represented by one of Formulae CY1(1) to CY1(15): 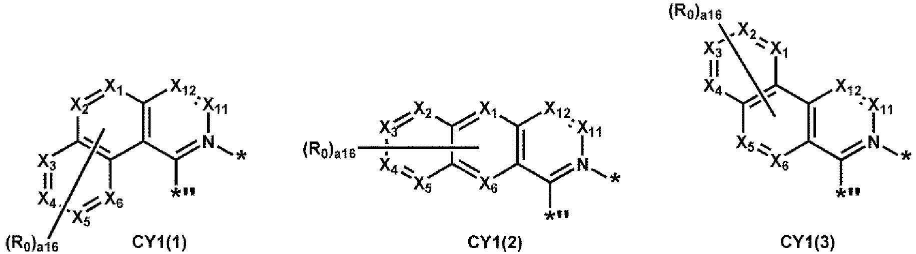 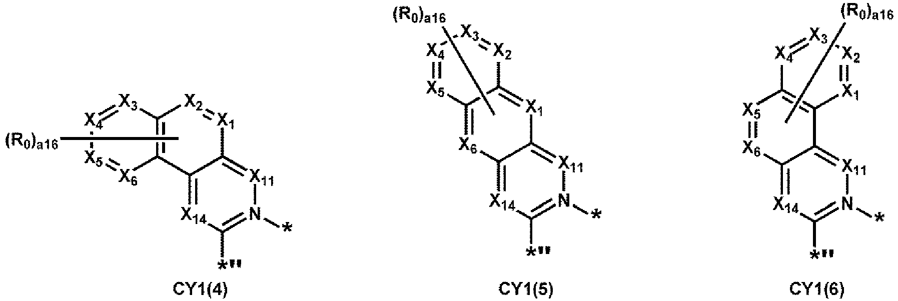 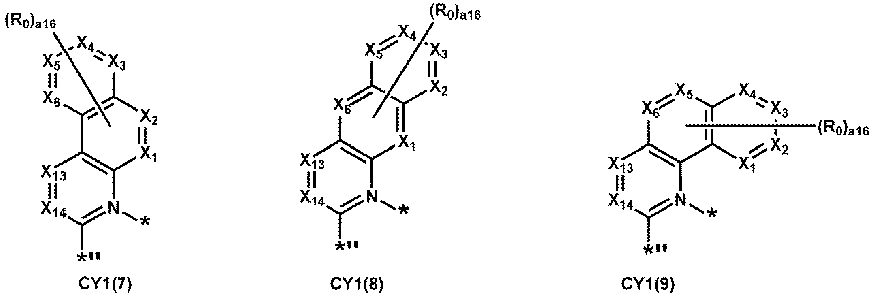 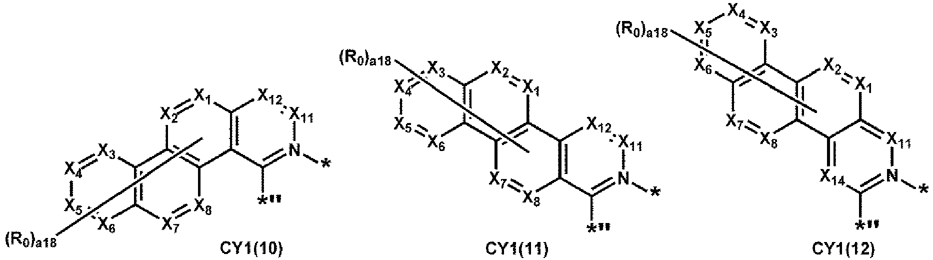 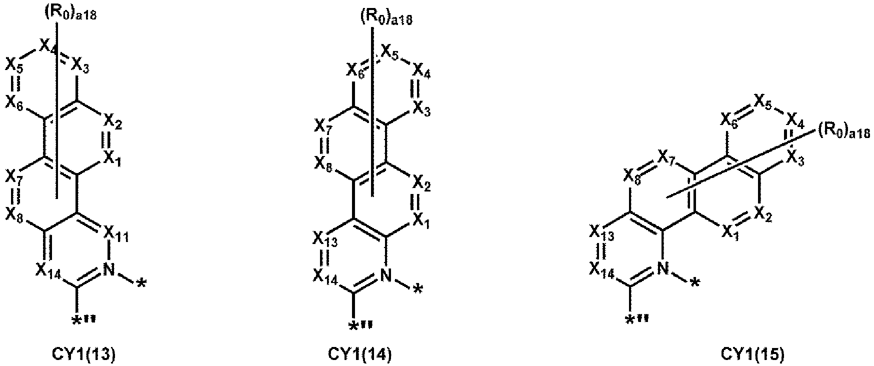 wherein, in Formulae CY1(1) to CY1(15),
X₁₁ to X₁₄ and R₀ are the same as described above,
X₁ to X₈ may each independently be C or N, at least one of X₁ to X₆ of Formulae CY1(1) to CY1(9) may be C, and at least one of X₁ to X₈ of Formulae CY1(10) to CY1(15) may be C,
a16 may be an integer from 0 to 6,
a18 may be an integer from 0 to 8,
* is a binding site to Ir in Formula 1, and
*" is a binding site to a neighboring carbon atom in Formula 1.

For example, X₁ to X₆ of Formulae CY1(1) to CY1(9) may be C, and X₁ to X₈ of Formulae CY1(10) to CY1(15) may be C.

In one or more embodiments, a group represented by one of Formulae CY1-1 to CY1-3 may be a group represented by one of Formulae 3-1 to 3-210: 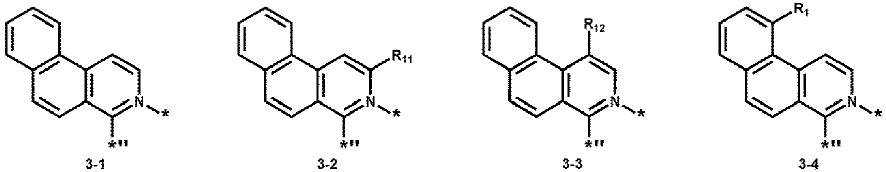 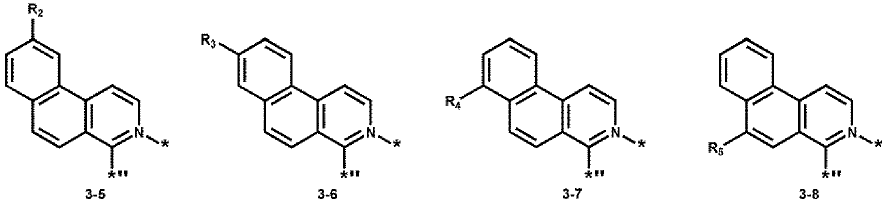 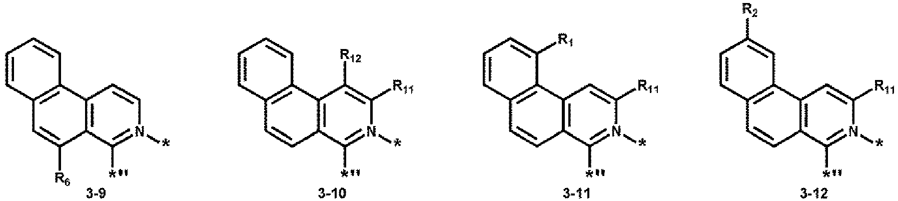 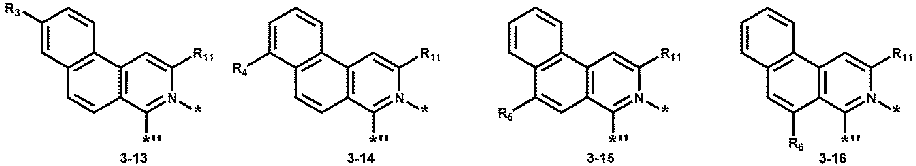 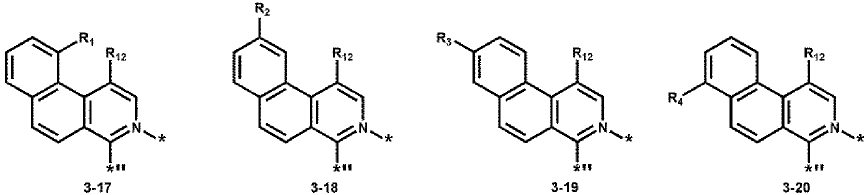 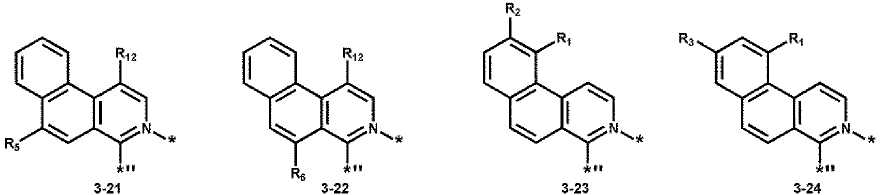 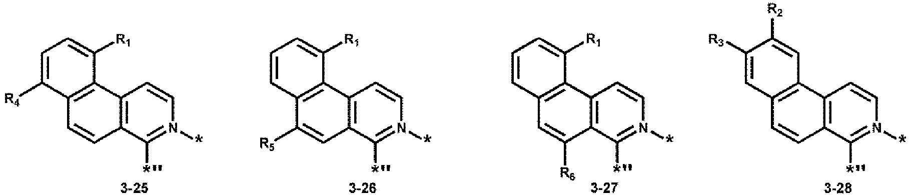 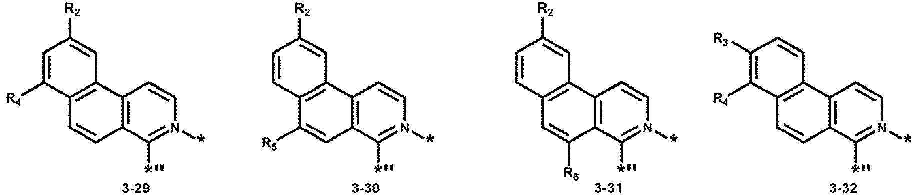 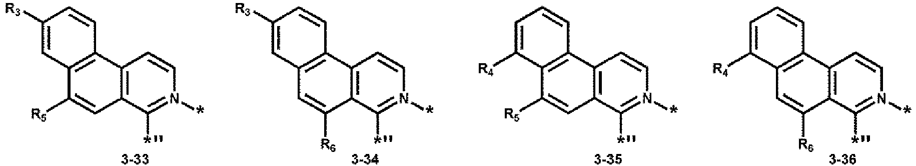 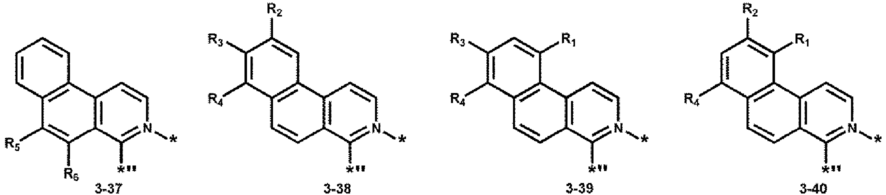 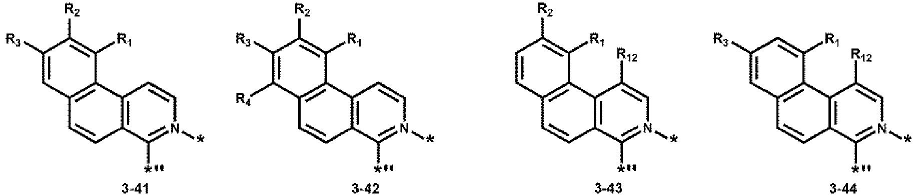 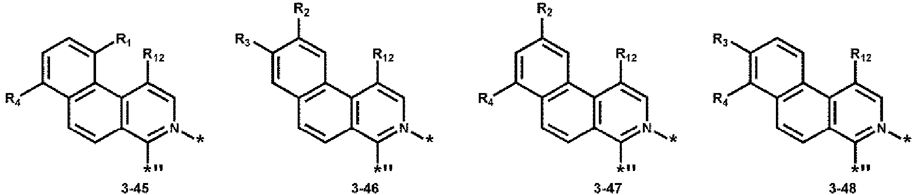 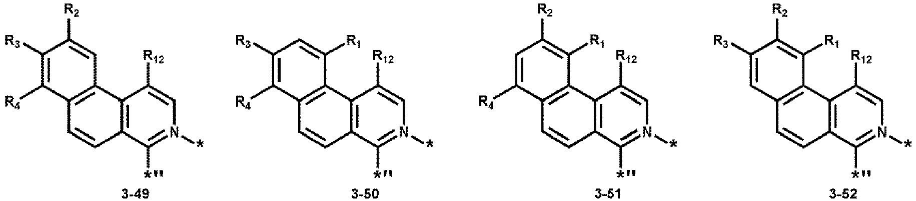 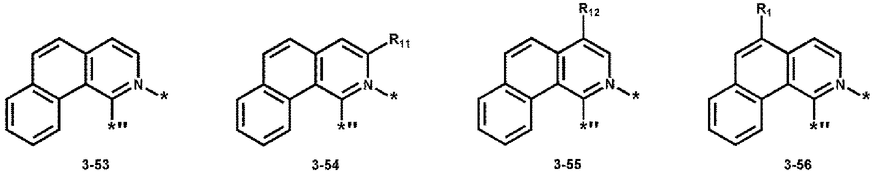 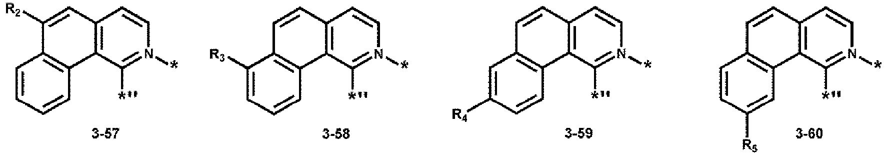 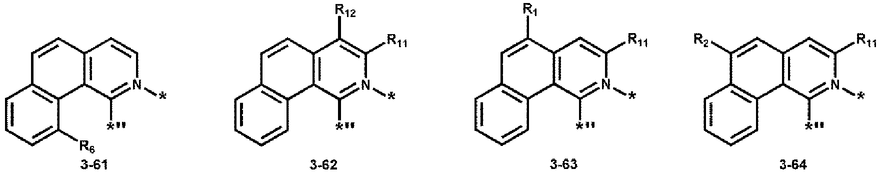 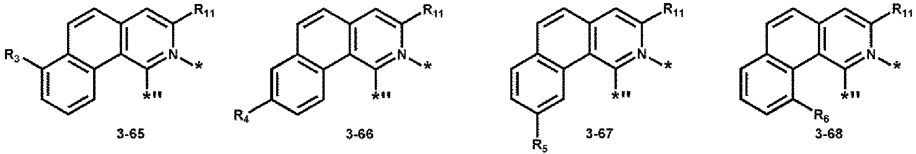 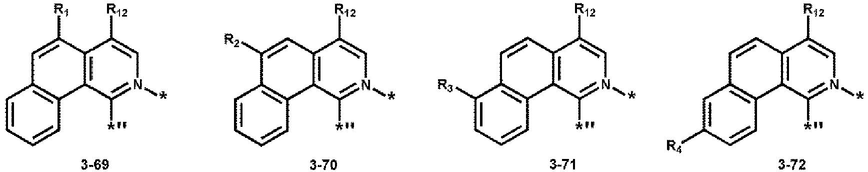 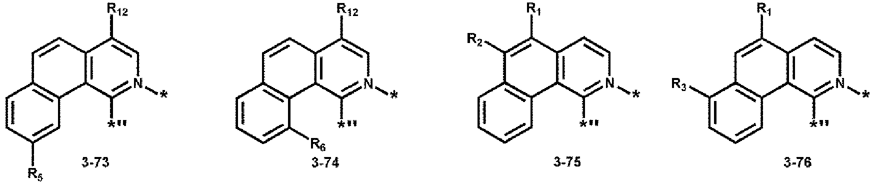 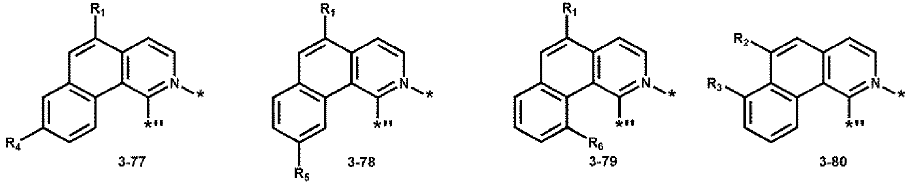 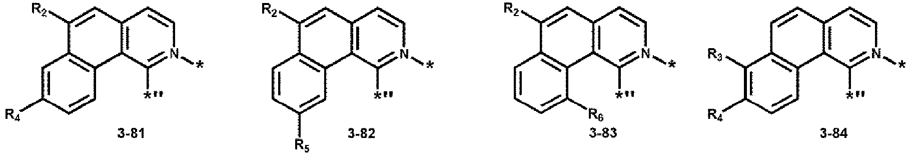 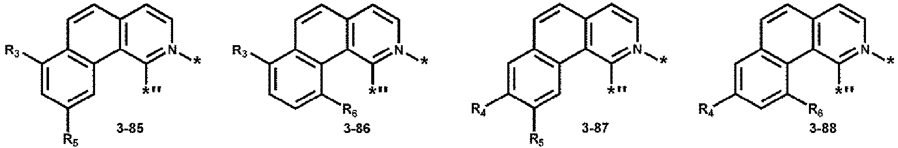 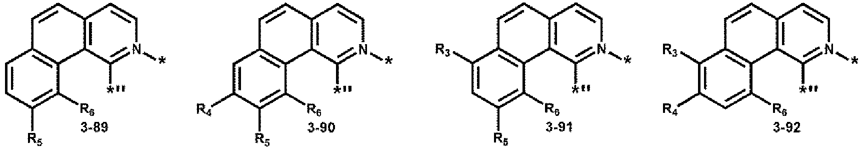 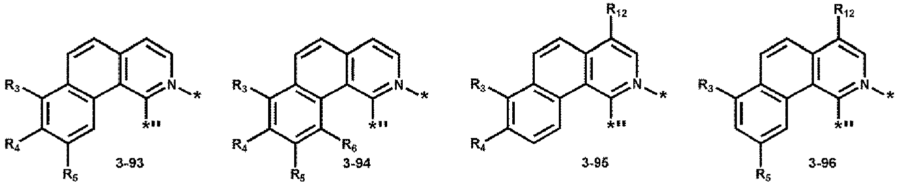 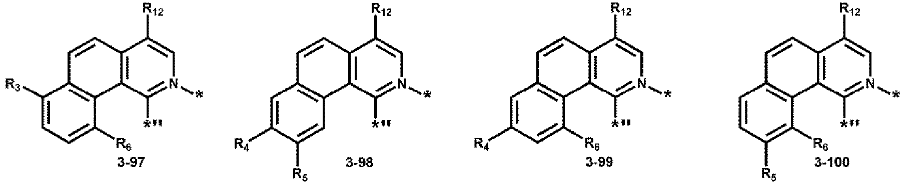 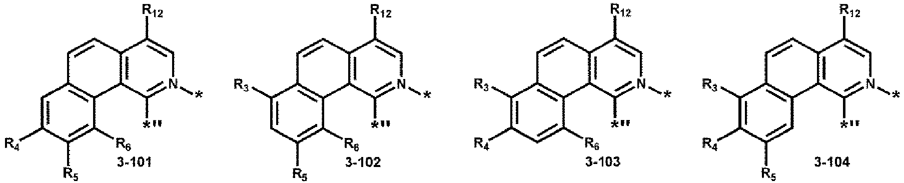 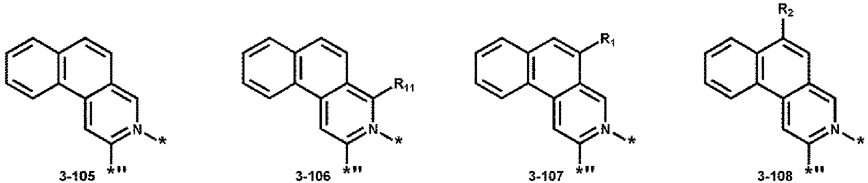 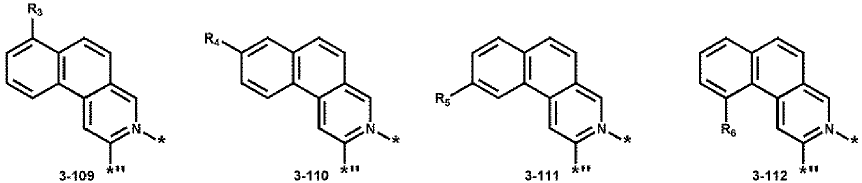 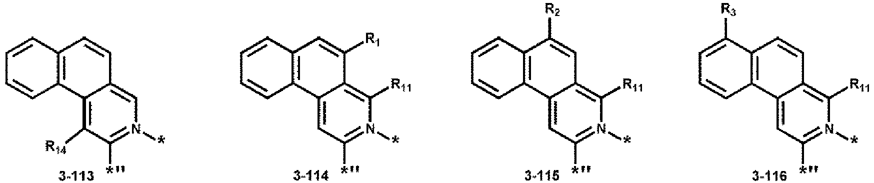 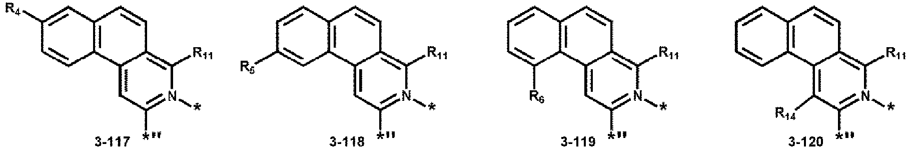 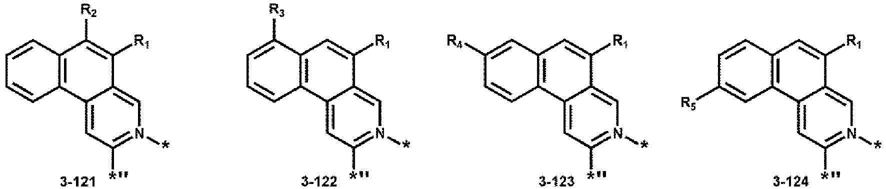 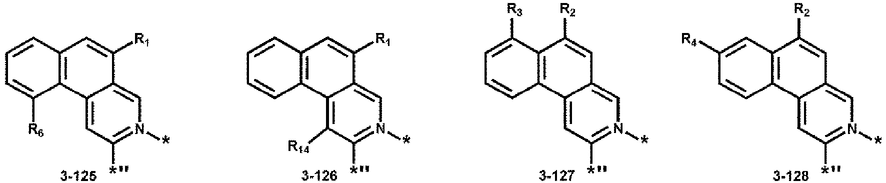 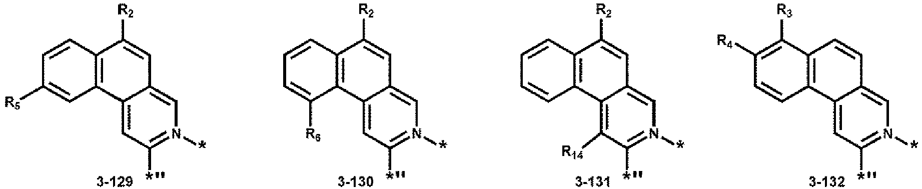 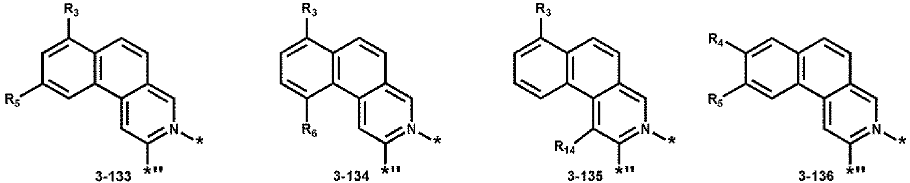 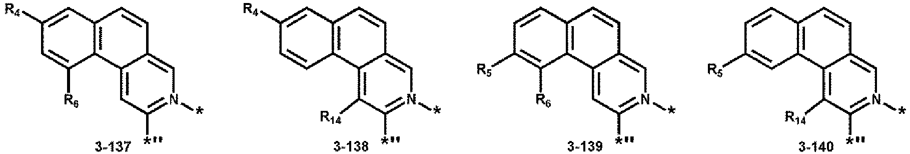 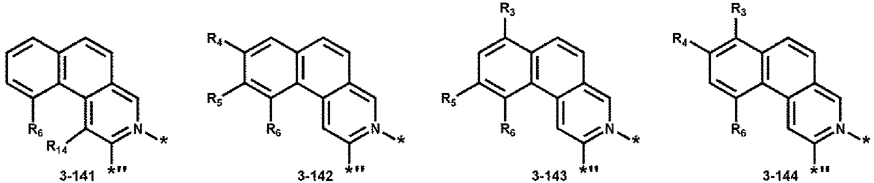 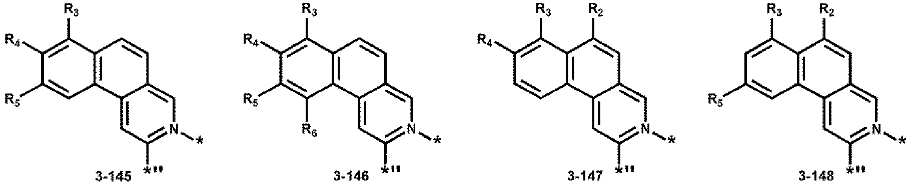 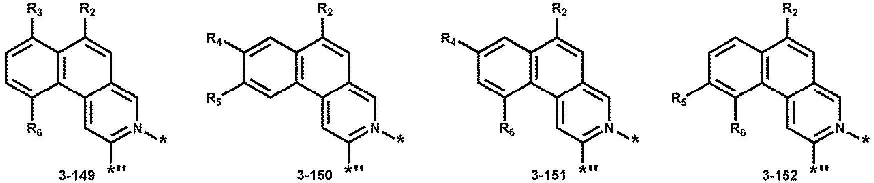 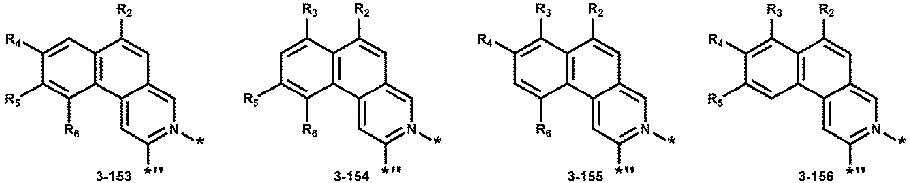 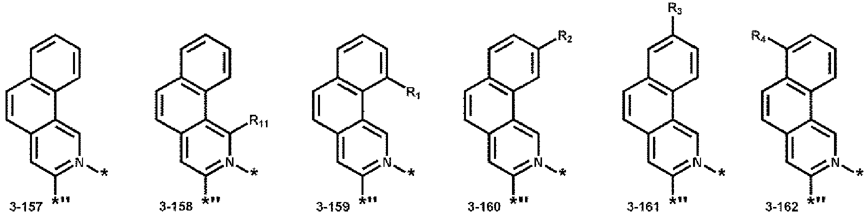 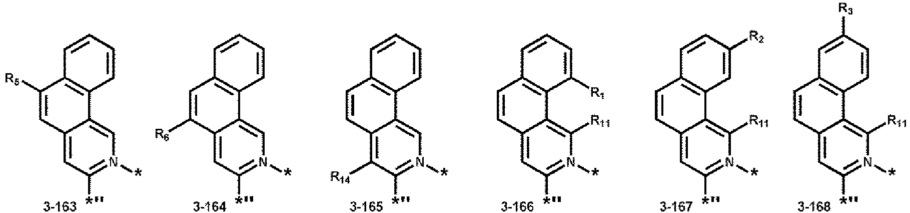 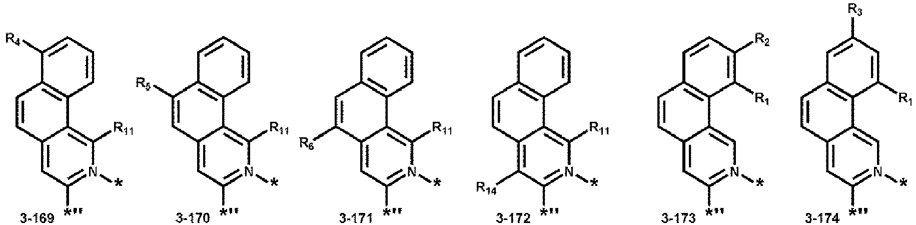 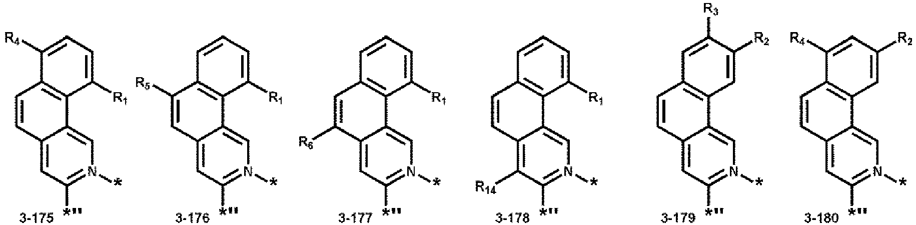 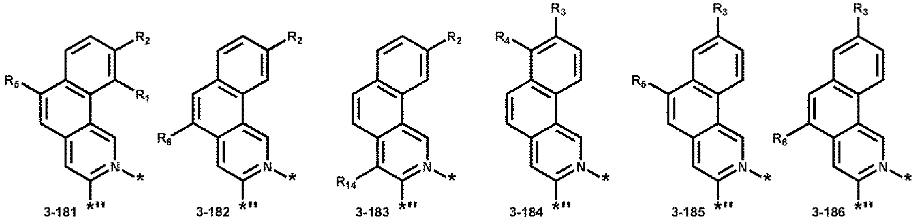 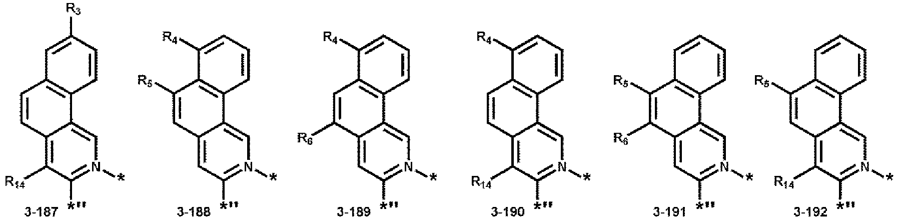 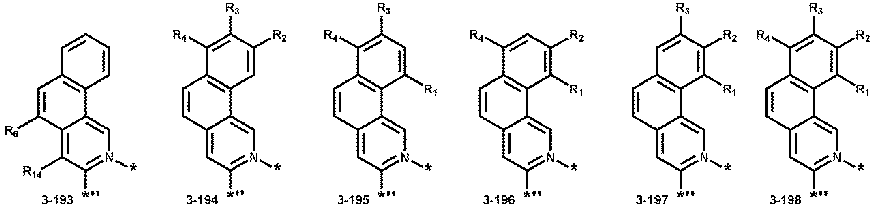 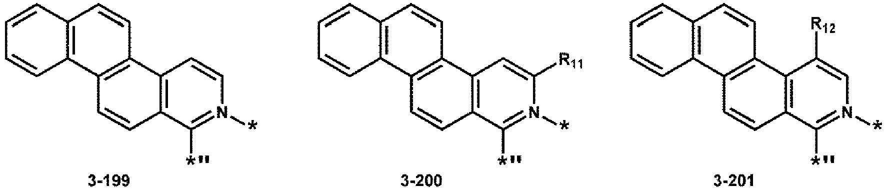 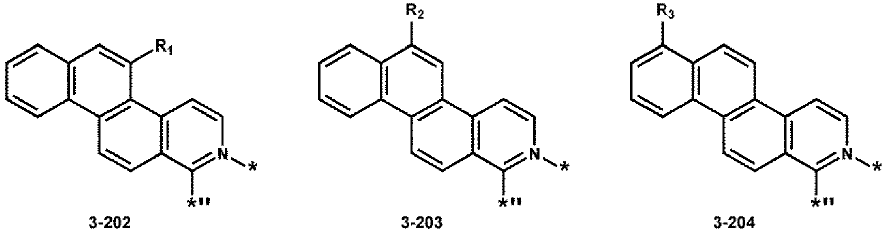 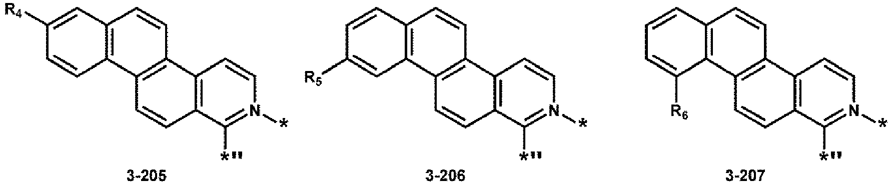 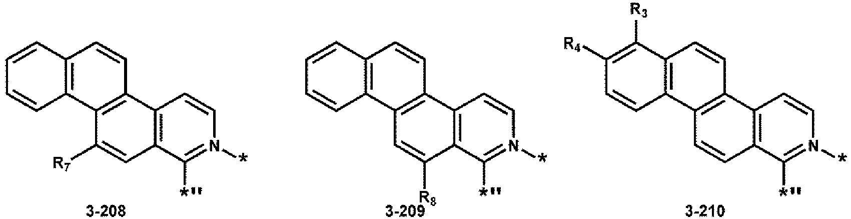 wherein, in Formulae 3-1 to 3-210,
R₁₁ to R₁₄ are the same as described above, and R₁ to R₈ are the same as described in connection with R₀, wherein each of R₁₁ to R₁₄ and R₁ to R₈ is not hydrogen,
* is a binding site to Ir in Formula 1, and
*" is a binding site to a neighboring carbon atom in Formula 1.

For example, R₁₁ to R₁₄ and R₁ to R₈ in Formulae 3-1 to 3-210 may each independently be:
deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or

   -Si(Q₃)(Q₄)(Q₅), or -Ge(Q₃)(Q₄)(Q₅).

In one or more embodiments, a group represented by 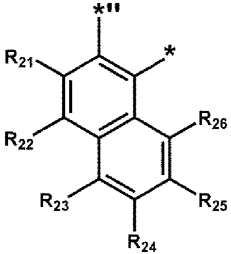 in Formula 1 may be a group represented by one of Formulae CY2-1 to CY2-59: 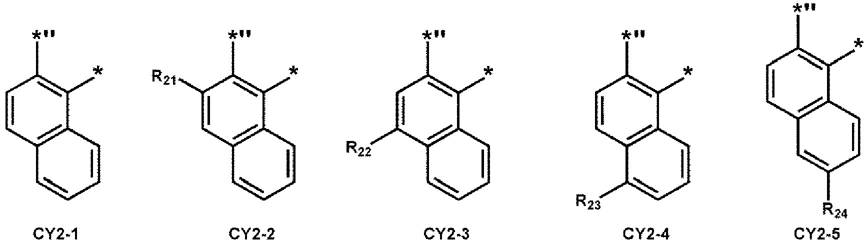 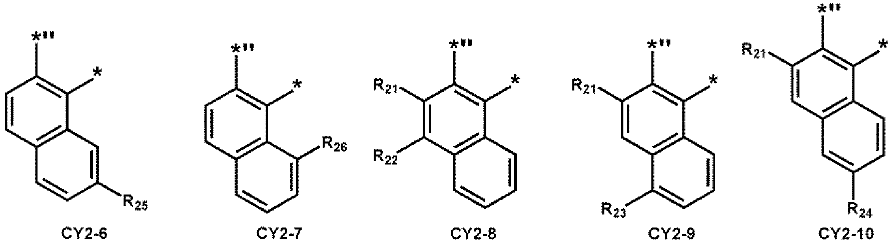 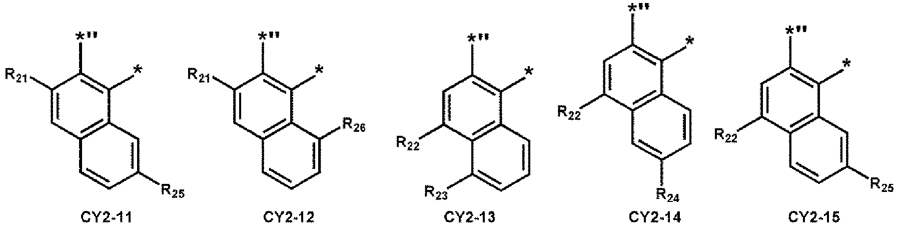 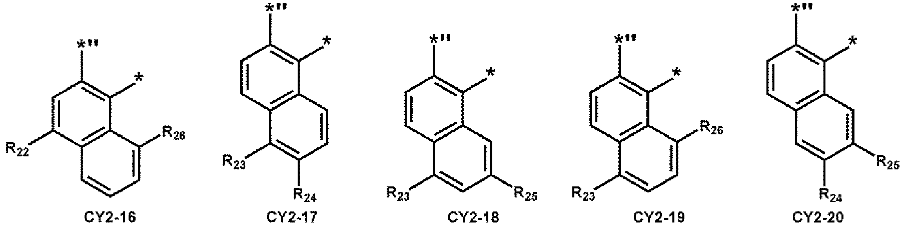 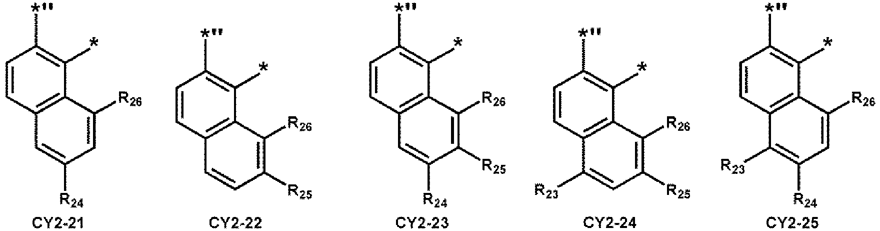 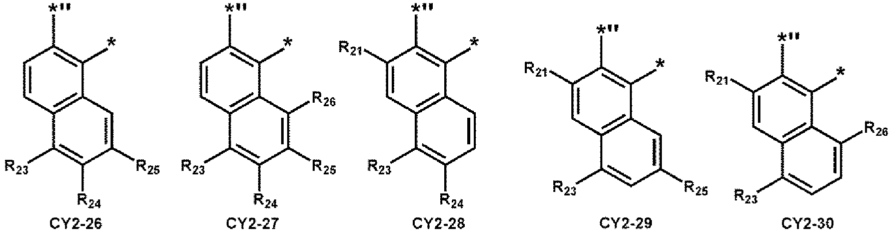 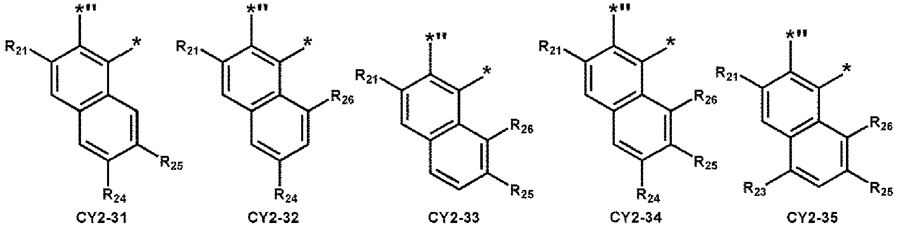 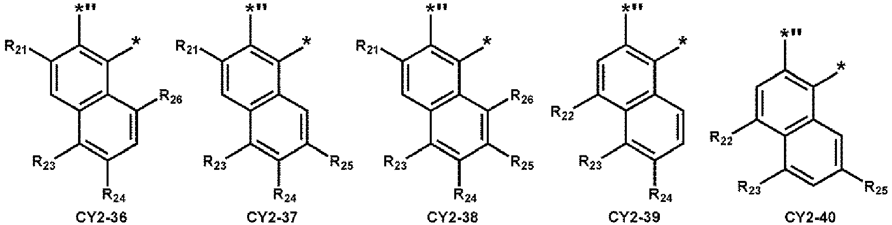 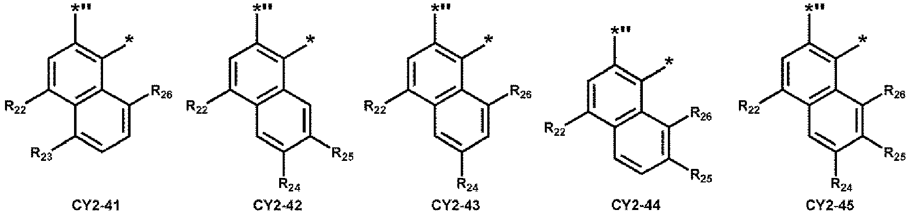 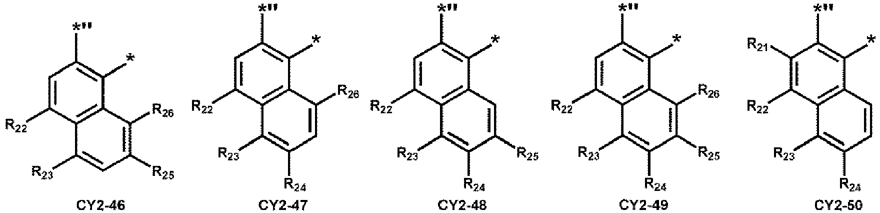 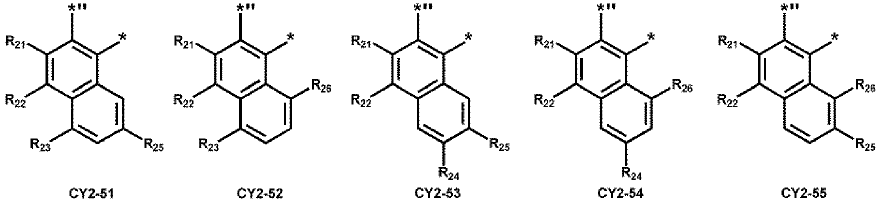 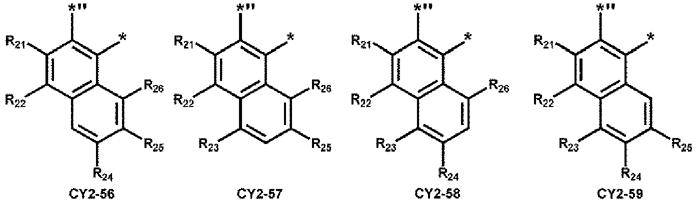 wherein, in Formulae CY2-1 to CY2-59,
R₂₁ to R₂₆ are the same as described above, and each of R₂₁ to R₂₆ may not be hydrogen,
* is a binding site to Ir in Formula 1, and
*" is a binding site to a neighboring atom in Formula 1.

For example, R₂₁ to R₂₆ in CY2-1 to CY2-59 may each independently be:
deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or

   -Si(Q₃)(Q₄)(Q₅), or -Ge(Q₃)(Q₄)(Q₅).

In one or more embodiments, a group represented by 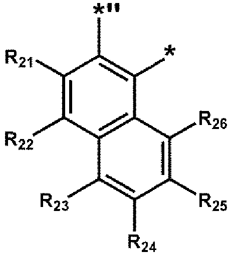 in Formula 1 may be a group represented by one of Formulae 4-1 to 4-3: 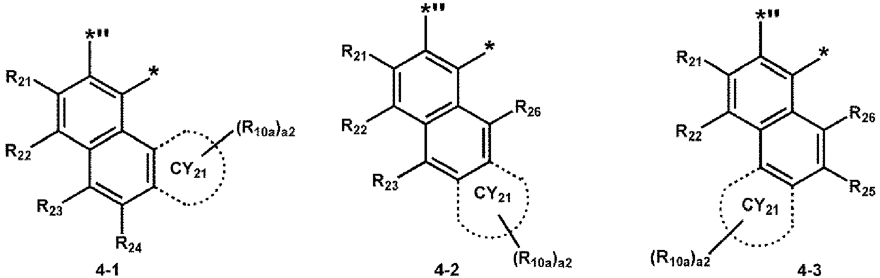 wherein, in Formulae 4-1 to 4-3,
R₂₁ to R₂₆ and R₁₀ₐ are the same as described above,
ring CY₂₁ may be a C₅-C₃₀ carbocyclic group or a C₁-C₃₀ heterocyclic group,
a2 may be an integer from 0 to 20,
* is a binding site to **Ir** in Formula 1, and
*" is a binding site to a neighboring atom in Formula 1.

For example, at least one of R₂₁ and R₂₂ in Formulae 4-1 to 4-3 may not be hydrogen.

For example, ring CY₂₁ in Formula 4-1 to 4-3 may be a benzene group, a naphthalene group, a pyridine group, a pyrimidine group, a quinoline group, or an isoquinoline group.

Meanwhile, the number of carbon included in R₃₀ₐ and R_{30b} in Formula 1 may each independently be 4 or more, 5 or more, or 6 or more.

In one or more embodiments, R₃₀ₐ in Formula 1 may not be a tert-butyl group.

In one or more embodiments, R_{30b} in Formula 1 may not be a tert-butyl group.

In one or more embodiments, each of R₃₀ₐ and R_{30b} in Formula 1 may not be a tert-butyl group, simultaneously.

In one or more embodiments, at least one of R₃₄ to R₃₆ (for example, all of R₃₄ to R₃₆) may not be hydrogen and deuterium.

In one or more embodiments, R₃₀ₐ in Formula 1 may be a group represented by *-C(R₃₁)(R₃₂)(R₃₃), and at least one of R₃₁ to R₃₃ may not be a methyl group.

In one or more embodiments, R₃₀ₐ in Formula 1 may be a group represented by *-C(R₃₁)(R₃₂)(R₃₃), R_{30b} is a group represented by *-C(R₃₄)(R₃₅)(R₃₆), each of R₃₄ to R₃₆ may not be hydrogen, and at least one of R₃₁ to R₃₆ may not be a methyl group.

In one or more embodiments, R₃₀ₐ in Formula 1 may be a group represented by *-C(R₃₁)(R₃₂)(R₃₃), R_{30b} is a group represented by *-C(R₃₄)(R₃₅)(R₃₆), each of R₃₄ to R₃₆ may not be hydrogen and deuterium, and at least one of R₃₁ to R₃₆ may not be a methyl group.

In one or more embodiments, the organometallic compound represented by Formula 1 may satisfy at least one of <Condition A1> to <Condition A3>, or each of <Condition A1 > and <Condition A2>:
<Condition A1>
   R₃₀ₐ may be a group represented by *-C(R₃₁)(R₃₂)(R₃₃), and
   R₃₁ to R₃₃ may each independently be a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
<Condition A2>
   R₃₀ₐ may be a group represented by *-C(R₃₁)(R₃₂)(R₃₃), and
   at least one of R₃₁ to R₃₃ may each independently be a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₂-C₆₀ heteroaryl group, a substituted or unsubstituted monovalent non-aromatic condensed polycyclic group, or a substituted or unsubstituted monovalent non-aromatic condensed heteropolycyclic group,
<Condition A3>
   R₃₀ₐ may be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, the organometallic compound represented by Formula 1 may satisfy at least one of <Condition B1> to <Condition B3>, or each of <Condition B1> and <Condition B2>:
<Condition B1>
   R_{30b} may be a group represented by *-C(R₃₄)(R₃₅)(R₃₆), and
   R₃₄ to R₃₆ may each independently be a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
<Condition B2>
   R_{30b} may be a group represented by *-C(R₃₄)(R₃₅)(R₃₆), and
   at least one of R₃₄ to R₃₆ may each independently be a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₂-C₆₀ heteroaryl group, a substituted or unsubstituted monovalent non-aromatic condensed polycyclic group, or a substituted or unsubstituted monovalent non-aromatic condensed heteropolycyclic group,
<Condition B3>
   R_{30b} may be a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In one or more embodiments, R₃₇ in Formula 1 may be hydrogen or deuterium.

In one or more embodiments, R₃₀ₐ and R_{30b} in Formula 1 may be identical to each other.

In one or more embodiments, R₃₀ₐ and R_{30b} in Formula 1 may be different from each other.

In one or more embodiments, Formula 1 may include at least one deuterium.

In one or more embodiments, Formula 1 may include at least one fluoro group (-F).

In one or more embodiments, at least one of R₀ and R₁₁ to R₁₄ in Formula 1 may include a fluoro group (-F).

In one or more embodiments, R₀ and R₁₁ to R₁₄ in Formula 1 may not include a fluoro group (-F).

In one or more embodiments, R₃₇ in the organometallic compound represented by Formula 1 may be a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

In the formulae above, i) two or more of a plurality of R₀ are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, ii) two or more of R₁₁ to R₁₉ are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iii) two or more of R₁₁ to R₁₉, and R₀ are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, iv) two or more of R₂₁ to R₂₆ are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ, and v) two or more of R₃₀ₐ, R_{30b}, and R₃₇ are optionally linked to each other to form a C₅-C₃₀ carbocyclic group that is unsubstituted or substituted with at least one R₁₀ₐ or a C₁-C₃₀ heterocyclic group that is unsubstituted or substituted with at least one R₁₀ₐ. R₁₀ₐ are the same as described in connection with R₀.

In an embodiment, the organometallic compound represented by Formula 1 may emit red or green light, for example, red or green light having a maximum emission wavelength of 500 nm or more, for example, a maximum emission wavelength in the range of 500 nm to 650 nm.

In an embodiment, the organometallic compound represented by Formula 1 may emit light having a maximum emission wavelength in the range of 525nm to 650nm, 550nm to 650nm, 575nm to 650nm, 600 nm to 650 nm, 610 nm to 645 nm, or 620 nm to 645 nm.

In an embodiment, the organometallic compound represented by Formula 1 may emit light having a full width at half maximum (FWHM) in the range of 25 nm to 50 nm, 30 nm to 45 nm, or 30 nm to 43 nm.

The organometallic compound represented by Formula 1 may be one of Compounds 1 to 46:

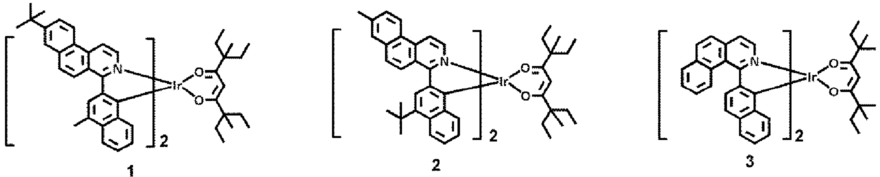

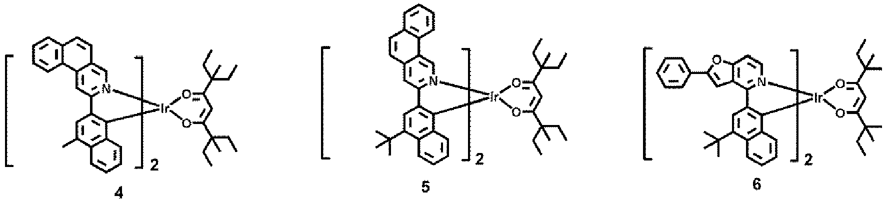

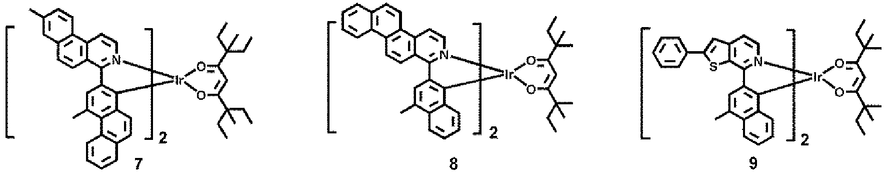

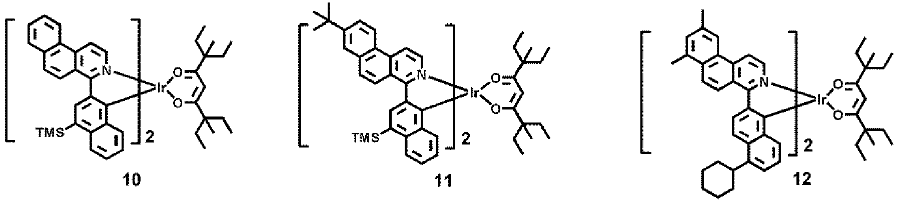

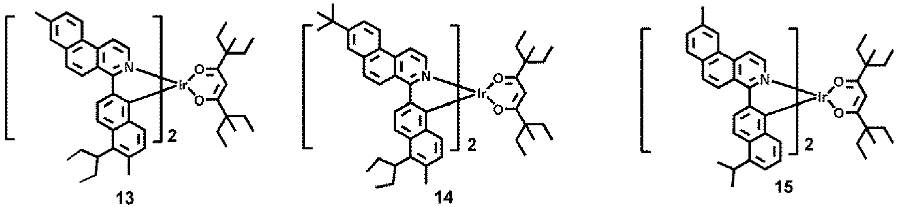

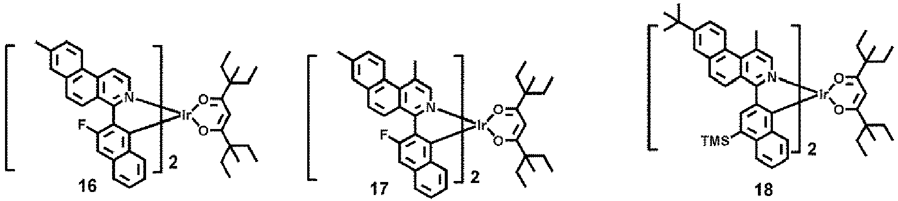

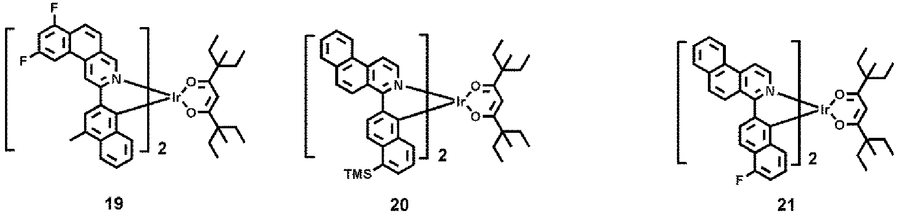

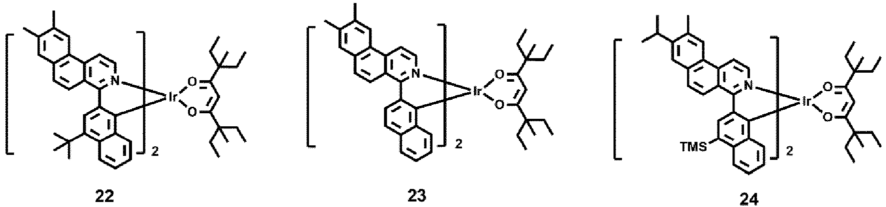

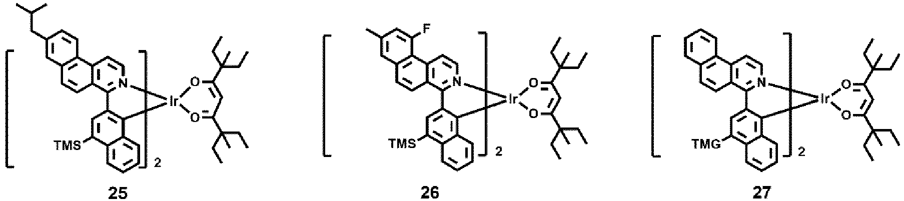

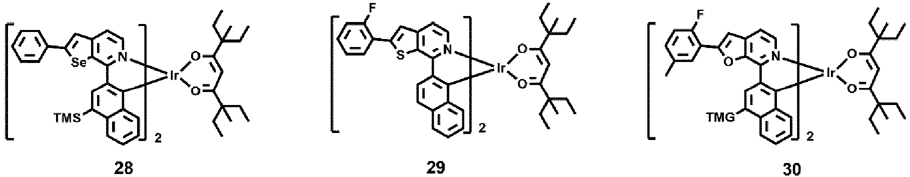

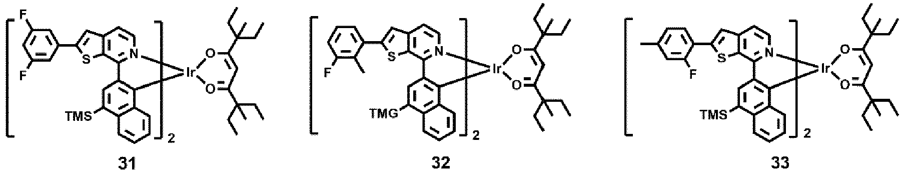

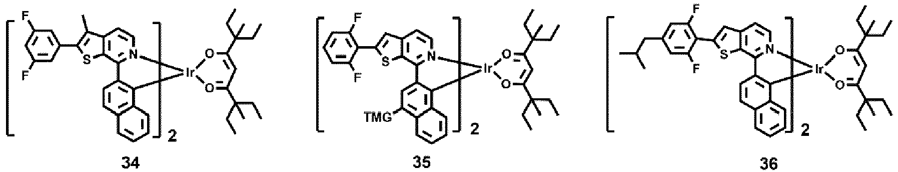

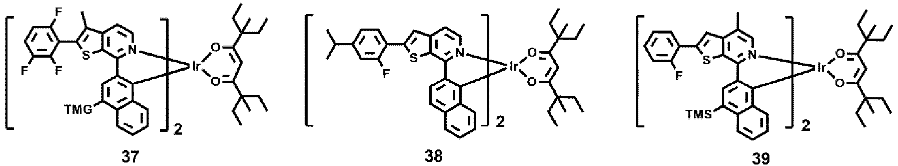

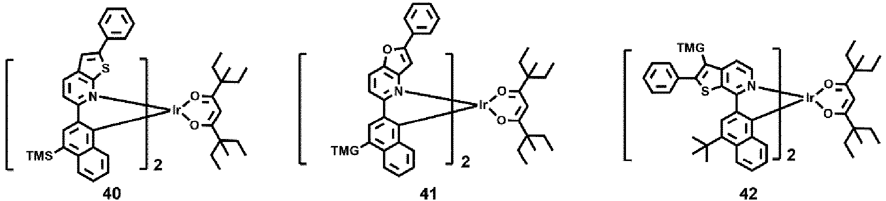

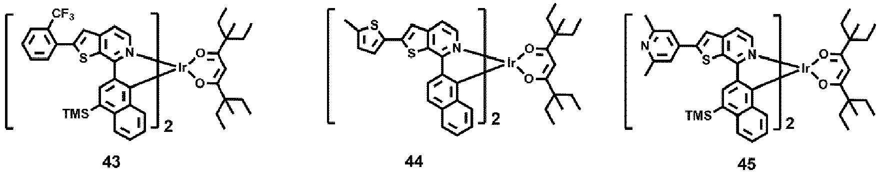

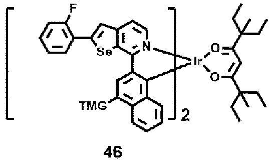

The organometallic compound has a backbone of Formula 1 as described herein. As a result, vibration transmission of the organometallic compound represented by Formula 1 is significantly reduced, and thus, an electronic device, for example, an organic light-emitting device using the organometallic compound represented by Formula 1 may emit light having relatively small FWHM and high luminescence efficiency.

R₃₀ₐ in Formula 1 may be a group represented by *-C(R₃₁)(R₃₂)(R₃₃), a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and each of R₃₁ to R₃₃ may not be hydrogen. As a result, since the organometallic compound represented by Formula 1 has a relatively large steric hindrance, triplet-triplet quenching may less occur. Thus, an electronic device, for example, an organic light-emitting device using the organometallic compound represented by Formula 1 may have excellent internal photoluminescence quantum yield.

The highest occupied molecular orbital (HOMO) energy level, lowest unoccupied molecular orbital (LUMO) energy level, and T₁ energy level of some compounds of the organometallic compound represented by Formula 1 were evaluated using the Gaussian 09 program with the molecular structure optimization obtained by B3LYP-based density functional theory (DFT), and results thereof are shown in Table 1.

**Table 1**

| Compound No. | HOMO(eV) | LUMO(eV) | T₁(eV) |
|---|---|---|---|
| 1 | -4.455 | -1.659 | 1.969 |
| 2 | -4.492 | -1.676 | 1.983 |
| 4 | -4.469 | -1.638 | 2.030 |
| 6 | -4.543 | -1.698 | 2.017 |
| 8 | -4.500 | -1.830 | 1.907 |
| 9 | -4.470 | -1.845 | 1.964 |
| 10 | -4.625 | -1.759 | 1.945 |
| 14 | -4.479 | -1.682 | 1.955 |
| 16 | -4.790 | -1.931 | 1.986 |
| 18 | -4.538 | -1.619 | 2.000 |
| 23 | -4.508 | -1.631 | 1.935 |
| 26 | -4.603 | -1.749 | 1.945 |
| 27 | -4.600 | -1.750 | 1.932 |
| 29 | -4.536 | -1.977 | 1.841 |
| 32 | -4.633 | -1.862 | 1.949 |
| 34 | -4.717 | -1.976 | 1.958 |
| 35 | -4.509 | -1.935 | 1.866 |
| 38 | -4.492 | -1.892 | 1.869 |
| 42 | -4.438 | -1.625 | 1.975 |

In an embodiment, an absolute value of HOMO energy level of the organometallic compound represented by Formula 1 may be in the range of 4.4 eV to 4.8 eV, for example, 4.438 eV or 4.790 eV.

In an embodiment, an absolute value of LUMO energy level of the organometallic compound represented by Formula 1 may be in the range of 1.6 eV to 2.0 eV, for example, 1.619 eV or 1.977 eV.

In an embodiment, an absolute value of T₁ energy level of the organometallic compound represented by Formula 1 may be in the range of 1.8 eV to 2.1 eV, for example, 1.841 eV or 2.030 eV.

The HOMO HOMO energy level, LUMO energy level and T₁ energy level may be evaluated by DFT, for example DFT using the Gaussian 09 program.

From Table 1, it is confirmed that the organometallic compound represented by Formula 1 has such electronic characteristics that are suitable for use as a dopant for an electric device, for example, an organic light-emitting device.

Synthesis methods of the organometallic compound represented by Formula 1 may be recognizable by one of ordinary skill in the art by referring to Synthesis Examples provided below.

Accordingly, the organometallic compound represented by Formula 1 is suitable for use as a material for an organic layer of organic light-emitting device, for example, a dopant in an emission layer of the organic layer. Thus, another aspect provides an organic light-emitting device including: a first electrode; a second electrode; and an organic layer located between the first electrode and the second electrode and including an emission layer, and the organic layer includes at least one organometallic compound represented by Formula 1.

Since the organic light-emitting device has an organic layer containing the organometallic compound represented by Formula 1 as described above, excellent characteristics may be obtained with respect to driving voltage, external quantum efficiency, and lifespan, and the FWHM of the emission peak of the EL spectrum is relatively narrow.

The organometallic compound of Formula 1 may be used between a pair of electrodes of an organic light-emitting device. For example, the organometallic compound represented by Formula 1 may be included in the emission layer. In this regard, the organometallic compound may act as a dopant, and the emission layer may further include a host (that is, an amount (for example, a weight) of the organometallic compound represented by Formula 1 in the emission layer is smaller than an amount (for example, a weight) of the host). The emission layer including the organometallic compound represented by Formula 1 (or, the organic light-emitting device including the emission layer) may emit red or green light, for example, red of green light having a maximum emission wavelength of 500 nm or more, for example, a maximum emission wavelength in the range of 500 nm to 650 nm.

In an embodiment, the emission layer including the organometallic compound represented by Formula 1 (or, the organic light-emitting device including the emission layer) may emit light having a maximum emission wavelength in the range of 525nm to 650nm, 550nm to 650nm, 575nm to 650nm, 600 nm to 650 nm, 610 nm to 645 nm, or 620 nm to 645 nm.

In an embodiment, the emission layer including the organometallic compound represented by Formula 1 (or, the organic light-emitting device including the emission layer) may emit light having a FWHM in the range of 25 nm to 50 nm, 30 nm to 45 nm, or 30 nm to 43 nm.

The maximum emission wavelength and FWHM may be evaluated from an EL spectrum of the organic light-emitting device.

In one embodiment, the emission layer including the organometallic compound represented by Formula 1 (or, the organic light-emitting device including the emission layer) emit red light.

The expression "(an organic layer) includes at least one of organometallic compounds" used herein may include a case in which "(an organic layer) includes identical organometallic compounds represented by Formula 1" and a case in which "(an organic layer) includes two or more different organometallic compounds represented by Formula 1".

For example, the organic layer may include, as the organometallic compound, only Compound 1. In this embodiment, Compound 1 may be included in the emission layer of the organic light-emitting device. In one or more embodiments, the organic layer may include, as the organometallic compound, Compound 1 and Compound 2. In this regard, Compound 1 and Compound 2 may exist in an identical layer (for example, Compound 1 and Compound 2 all may exist in an emission layer).

The first electrode may be an anode, which is a hole injection electrode, and the second electrode may be a cathode, which is an electron injection electrode; or the first electrode may be a cathode, which is an electron injection electrode, and the second electrode may be an anode, which is a hole injection electrode.

In one embodiment, in the organic light-emitting device, the first electrode is an anode, and the second electrode is a cathode, and the organic layer may further include a hole transport region between the first electrode and the emission layer and an electron transport region between the emission layer and the second electrode, and the hole transport region may include a hole injection layer, a hole transport layer, an electron blocking layer, a buffer layer, or any combination thereof, and the electron transport region may include a hole blocking layer, an electron transport layer, an electron injection layer, or any combination thereof.

The term "organic layer" used herein refers to a single layer and/or a plurality of layers between the first electrode and the second electrode of the organic light-emitting device. The "organic layer" may include, in addition to an organic compound, an organometallic complex including metal.

FIGURE is a schematic cross-sectional view of an organic light-emitting device 10 according to an embodiment. Hereinafter, the structure of an organic light-emitting device according to an embodiment of the present disclosure and a method of manufacturing an organic light-emitting device according to an embodiment of the present disclosure will be described in connection with FIGURE. The organic light-emitting device 10 includes a first electrode 11, an organic layer 15, and a second electrode 19, which are sequentially stacked.

A substrate may be additionally located under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and water resistance.

In one or more embodiments, the first electrode 11 may be formed by depositing or sputtering a material for forming the first electrode11 on the substrate. The first electrode 11 may be an anode. The material for forming the first electrode 11 may include materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), zinc oxide (ZnO), or any combination thereof. In one or more embodiments, the material for forming the first electrode 11 may be magnesium (Mg), aluminum (Al), silver (Ag), aluminum-lithium (Al-Li), calcium (Ca), magnesium-indium (Mg-In), magnesium-silver (Mg-Ag), or any combination thereof.

The first electrode 11 may have a single-layered structure or a multi-layered structure including two or more layers. For example, the first electrode 11 may have a three-layered structure of ITO/Ag/ITO.

The organic layer 15 is located on the first electrode 11.

The organic layer 15 may include a hole transport region, an emission layer, and an electron transport region.

The hole transport region may be between the first electrode 11 and the emission layer.

The hole transport region may include a hole injection layer, a hole transport layer, an electron blocking layer, a buffer layer, or any combination thereof.

The hole transport region may include only either a hole injection layer or a hole transport layer. In one or more embodiments, the hole transport region may have a hole injection layer/hole transport layer structure or a hole injection layer/hole transport layer/electron blocking layer structure, wherein, for each structure, each layer is sequentially stacked in this stated order from the first electrode 11.

When the hole transport region includes a hole injection layer (HIL), the hole injection layer may be formed on the first electrode 11 by using one or more suitable methods, for example, vacuum deposition, spin coating, casting, and/or Langmuir-Blodgett (LB) deposition.

When a hole injection layer is formed by vacuum deposition, the deposition conditions may vary according to a material that is used to form the hole injection layer, and the structure and thermal characteristics of the hole injection layer. For example, the deposition conditions may include a deposition temperature of about 100 °C to about 500 °C, a vacuum pressure of about 1.33 x 10⁻⁶ Pa (10⁻⁶ torr) to about 0.133 Pa (10⁻³ torr), and a deposition rate of about 0.01 Å/sec to about 100 Å/sec.

When the hole injection layer is formed using spin coating, coating conditions may vary according to the material used to form the hole injection layer, and the structure and thermal properties of the hole injection layer. For example, a coating speed may be from about 2,000 rpm to about 5,000 rpm, and a temperature at which a heat treatment is performed to remove a solvent after coating may be from about 80°C to about 200 °C.

Conditions for forming a hole transport layer and an electron blocking layer may be understood by referring to conditions for forming the hole injection layer.

The hole transport region may include m-MTDATA, TDATA, 2-TNATA, NPB, β-NPB, TPD, Spiro-TPD, Spiro-NPB, methylated-NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonicacid (PANI/CSA), polyaniline/poly(4-styrenesulfonate) (PANI/PSS), a compound represented by Formula 201 below, a compound represented by Formula 202 below, or any combination thereof:

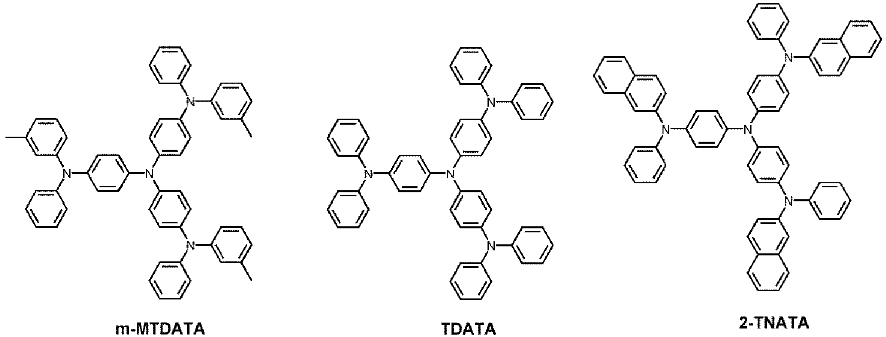

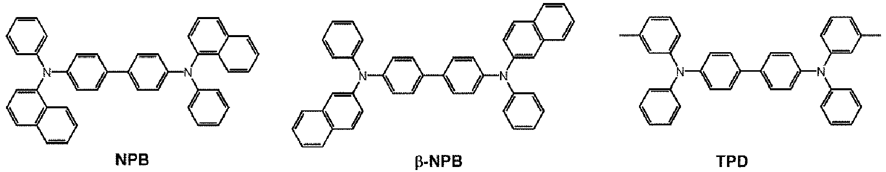

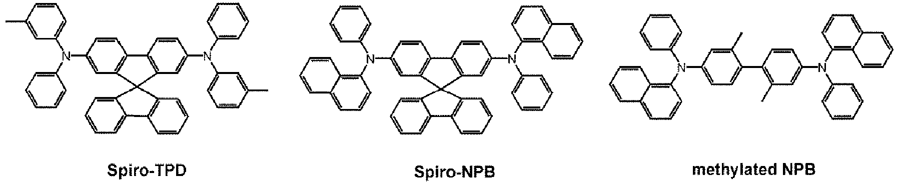

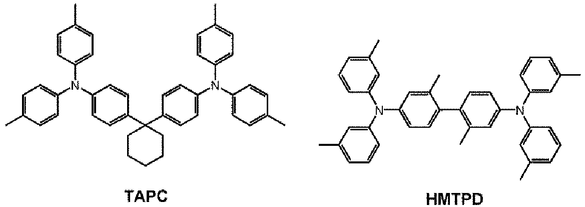

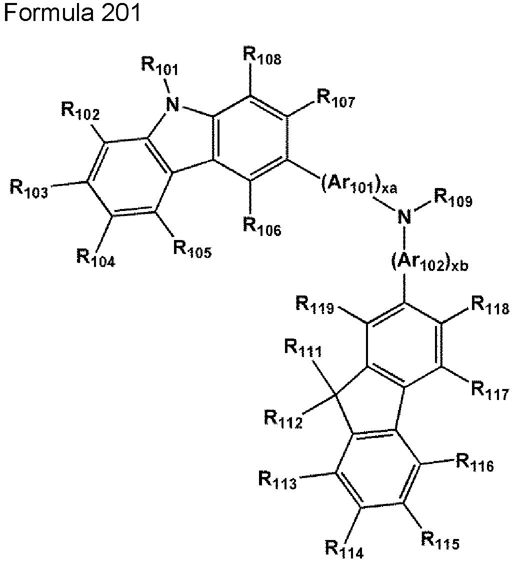

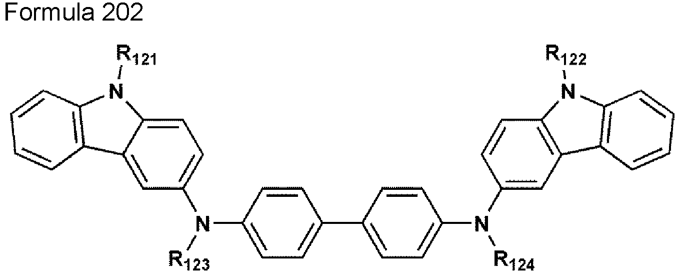

Ar₁₀₁ and Ar₁₀₂ in Formula 201 may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₃-C₁₀ cycloalkenyl group, a C₁-C₁₀ heterocycloalkyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, or any combination thereof.

xa and xb in Formula 201 may each independently be an integer from 0 to 5, or 0, 1, or 2. For example, xa may be 1 and xb may be 0.

R₁₀₁ to R₁₀₈, R₁₁₁ to R₁₁₉ and R₁₂₁ to R₁₂₄ in Formulae 201 and 202 may each independently be selected from:
hydrogen, deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, etc.), or a C₁-C₁₀ alkoxy group (for example, a methoxy group, an ethoxy group, a propoxy group, a butoxy group, a pentoxy group, etc.);
a C₁-C₁₀ alkyl group or a C₁-C₁₀ alkoxy group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or any combination thereof; or
a phenyl group, a naphthyl group, an anthracenyl group, a fluorenyl group, or a pyrenyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, or any combination thereof.
R₁₀₉ in Formula 201 may be a phenyl group, a naphthyl group, an anthracenyl group, or a pyridinyl group, each unsubstituted or substituted with deuterium, -F, -Cl, -Br, -I, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a phenyl group, a naphthyl group, an anthracenyl group, a pyridinyl group, or any combination thereof.

In one embodiment, the compound represented by Formula 201 may be represented by Formula 201A:

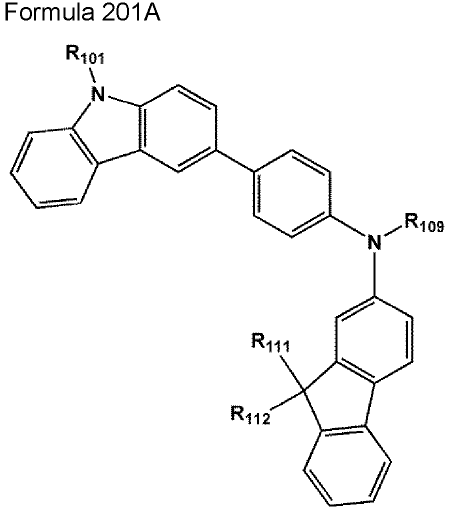

R₁₀₁, R₁₁₁, R₁₁₂, and R₁₀₉ in Formula 201A may be understood by referring to the description provided herein.

For example, the hole transport region may include one of Compounds HT1 to HT21 or any combination thereof:

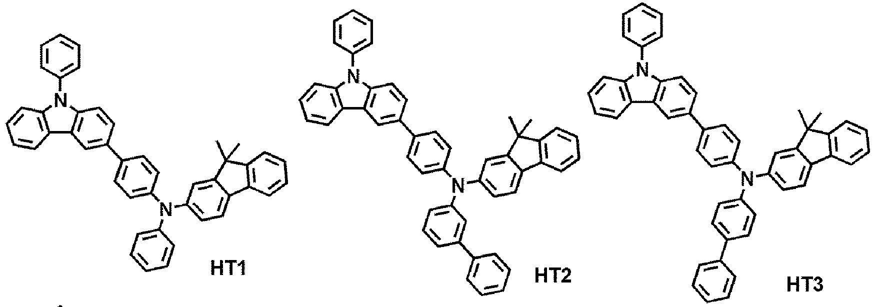

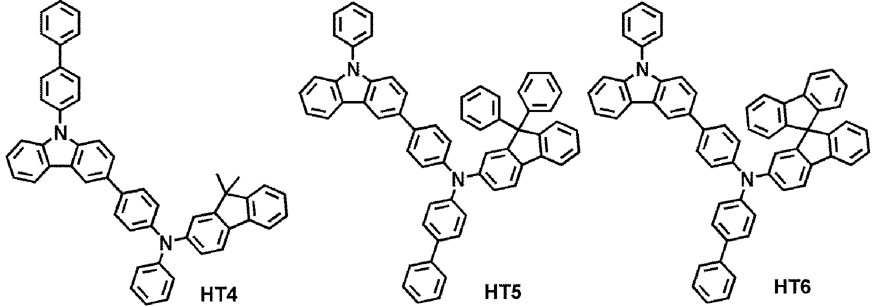

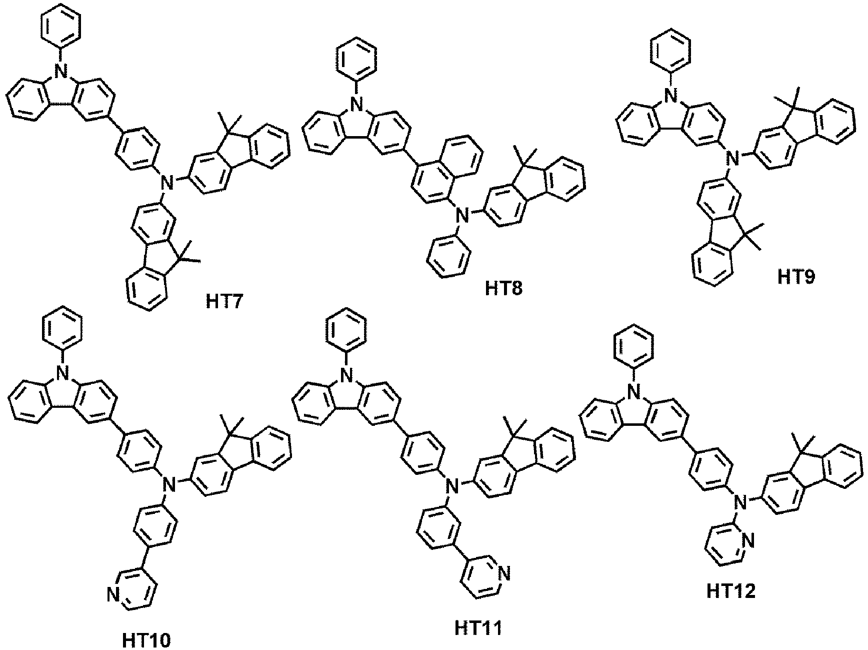

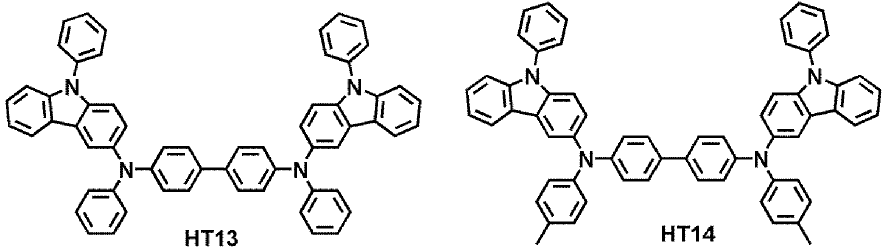

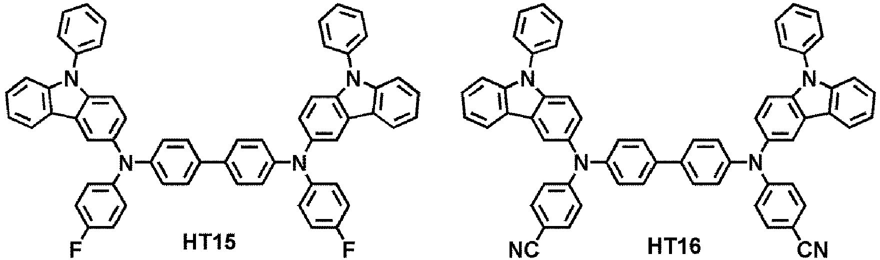

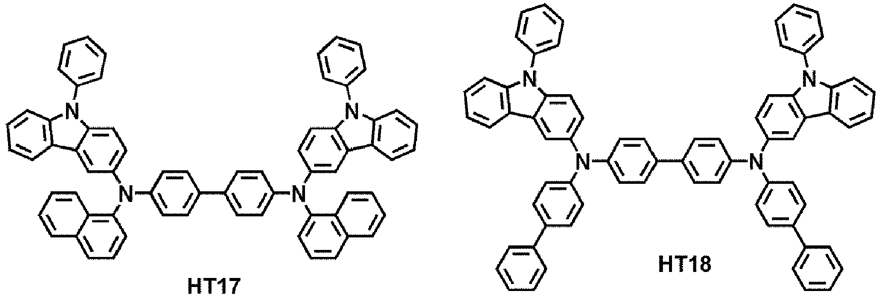

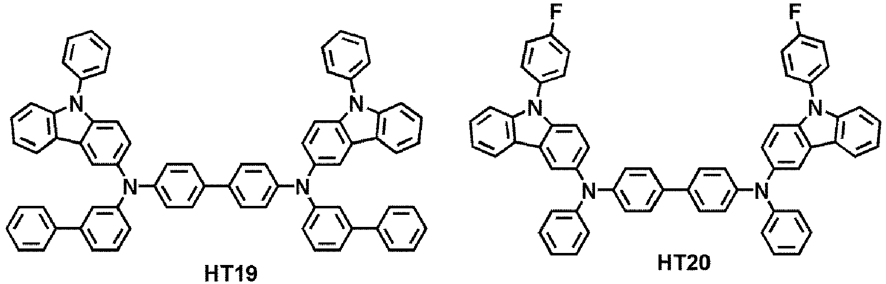

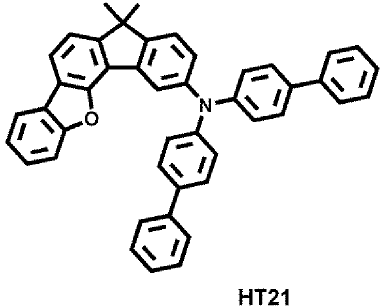

A thickness of the hole transport region may be in a range of about 100 Å to about 10,000 Å, for example, about 100 Å to about 1,000 Å. When the hole transport region includes at least one of a hole injection layer and a hole transport layer, a thickness of the hole injection layer may be in a range of about 100 Å to about 10,000 Å, for example, about 100 Å to about 1,000 Å, and a thickness of the hole transport layer may be in a range of about 50 Å to about 2,000 Å, for example, about 100 Å to about 1,500 Å. When the thicknesses of the hole transport region, the hole injection layer and the hole transport layer are within these ranges, satisfactory hole transporting characteristics may be obtained without a substantial increase in driving voltage.

The hole transport region may further include, in addition to these materials, a charge-generation material for the improvement of conductive properties. The charge-generation material may be homogeneously or non-homogeneously dispersed in the hole transport region.

The charge-generation material may be, for example, a p-dopant. The p-dopant may include a quinone derivative, a metal oxide, a cyano group-containing compound, or any combination thereof. For example, the p-dopant may include: a quinone derivative such as tetracyanoquinonedimethane (TCNQ), 2,3,5,6-tetrafluorotetracyano-1,4-benzoquinonedimethane (F4-TCNQ), or F6-TCNNQ; metal oxide, such as tungsten oxide and molybdenum oxide; a cyano group-containing compound, such as Compound HT-D1; or any combination thereof.

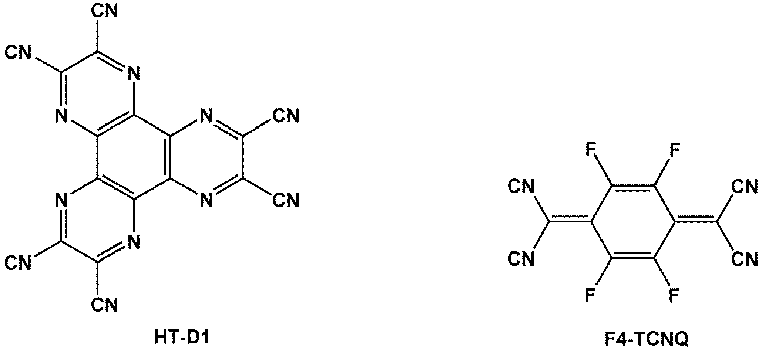

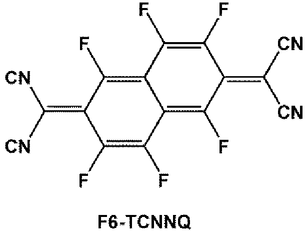

The hole transport region may include a buffer layer.

Also, the buffer layer may compensate for an optical resonance distance according to a wavelength of light emitted from the emission layer, and thus, efficiency of a formed organic light-emitting device may be improved.

Meanwhile, when the hole transport region includes an electron blocking layer, a material for forming the electron blocking layer may include a material that is used in the hole transport region as described above, a host material described below, or any combination thereof. For example, when the hole transport region includes an electron blocking layer, mCP, Compound H21 described below, or any combination may be used as the material for forming the electron blocking layer.

Then, an emission layer (EML) may be formed on the hole transport region by vacuum deposition, spin coating, casting, LB deposition, or the like. When the emission layer is formed by vacuum deposition or spin coating, the deposition or coating conditions may be similar to those applied in forming the hole injection layer although the deposition or coating conditions may vary according to a material that is used to form the emission layer.

The emission layer may include a host and a dopant, and the dopant may include the organometallic compound represented by Formula 1 as described herein.

The host may include TPBi, TBADN, ADN (also referred to as "DNA"), CBP, CDBP, TCP, mCP, Compound H50, Compound H51, Compound H52, or any combination thereof:

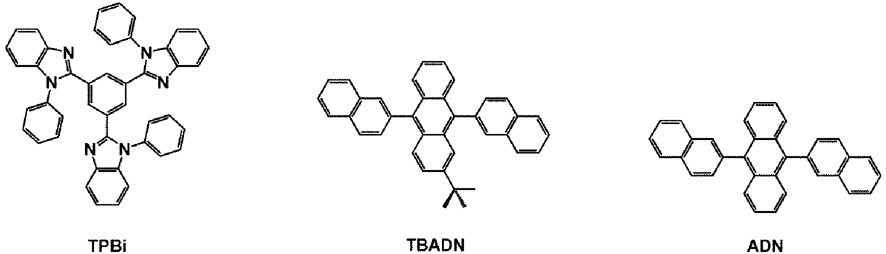

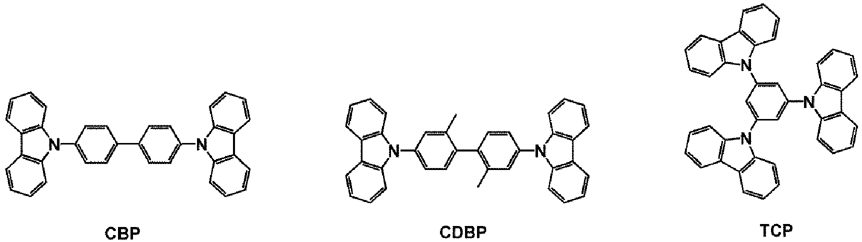

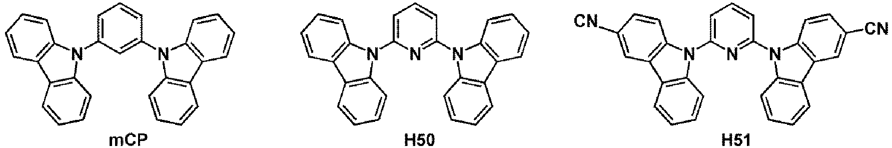

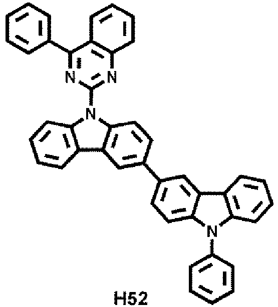

When the organic light-emitting device is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit white light.

When the emission layer includes a host and a dopant, an amount of the dopant may be in a range of about 0.01 parts by weight to about 15 parts by weight based on 100 parts by weight of the host.

A thickness of the emission layer may be in a range of about 100 Å to about 1,000 Å, for example, about 200 Å to about 600 Å. When the thickness of the emission layer is within this range, excellent light-emission characteristics may be obtained without a substantial increase in driving voltage.

Then, an electron transport region may be located on the emission layer.

The electron transport region may include a hole blocking layer, an electron transport layer, an electron injection layer, or any combination thereof.

For example, the electron transport region may have a hole blocking layer/electron transport layer/electron injection layer structure or an electron transport layer/electron injection layer structure. The electron transport layer may have a single-layered structure or a multi-layered structure including two or more different materials.

Conditions for forming the hole blocking layer, the electron transport layer, and the electron injection layer which constitute the electron transport region may be understood by referring to the conditions for forming the hole injection layer.

When the electron transport region includes a hole blocking layer, the hole blocking layer may include, for example, at least one of BCP, Bphen, and BAlq.

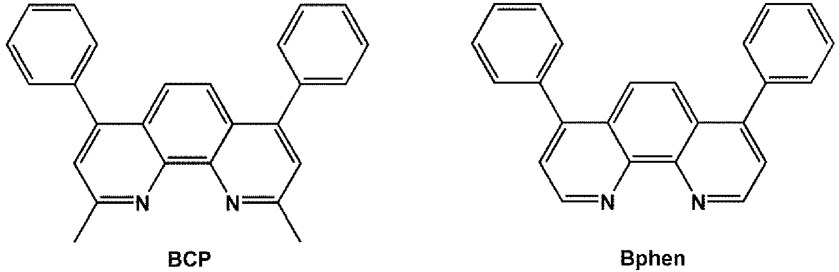

In one or more embodiments, the hole blocking layer may include the host, a material for forming an electron transport layer, a material for forming an electron injection layer, which will be described later, or any combination thereof.

A thickness of the hole blocking layer may be in a range of about 20 Å to about 1,000 Å, for example, about 30 Å to about 600 Å. When the thickness of the hole blocking layer is within these ranges, the hole blocking layer may have excellent hole blocking characteristics without a substantial increase in driving voltage.

The electron transport layer may include BCP, Bphen, TPBi, Alq₃, Balq, TAZ, NTAZ, or any combination thereof:

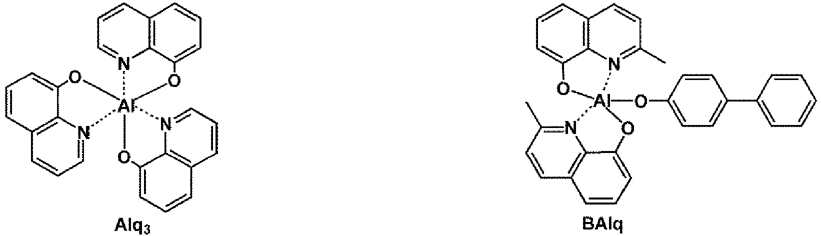

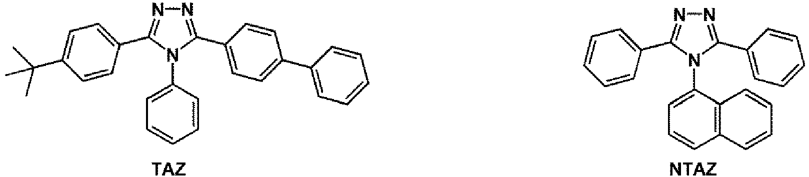

In one or more embodiments, the electron transport layer may include one of Compounds ET1 to ET25 or any combination thereof:

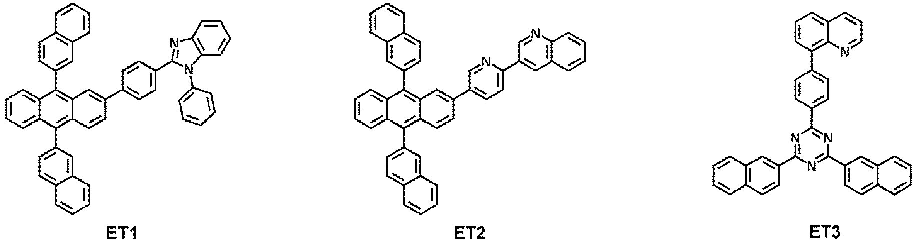

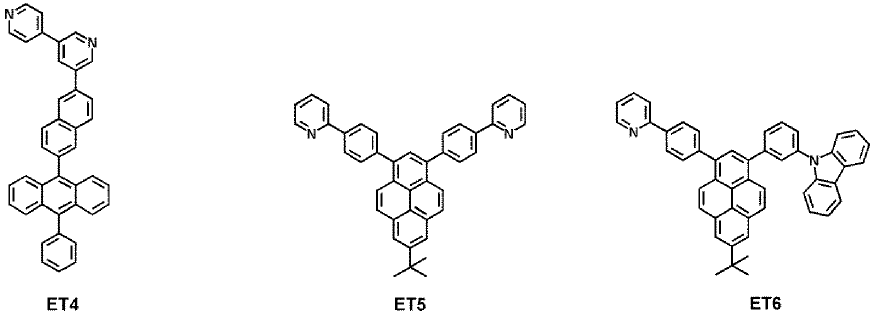

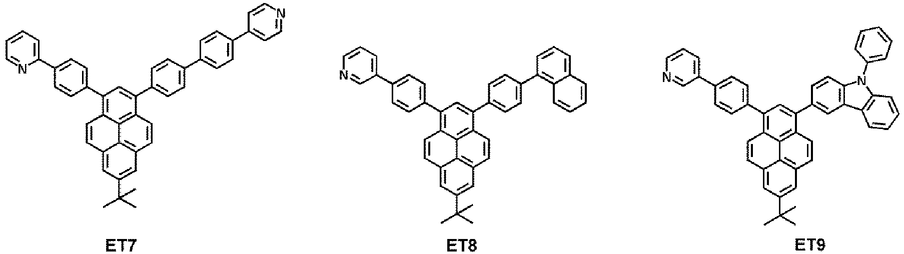

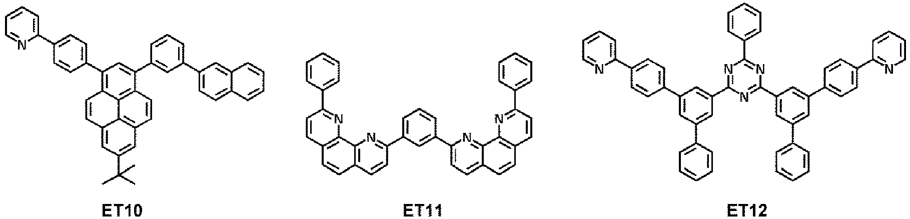

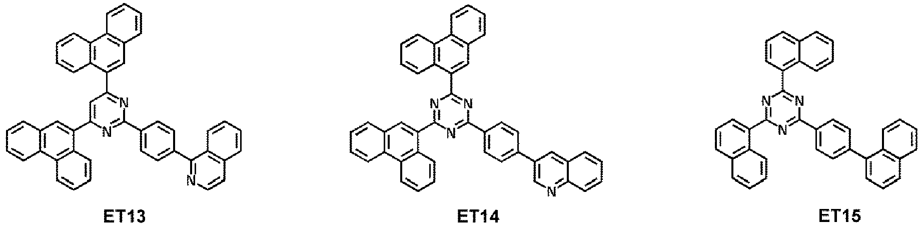

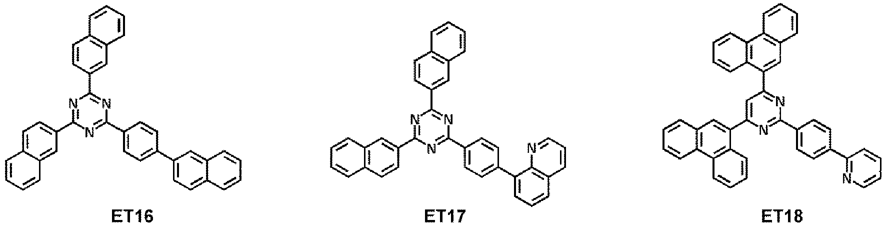

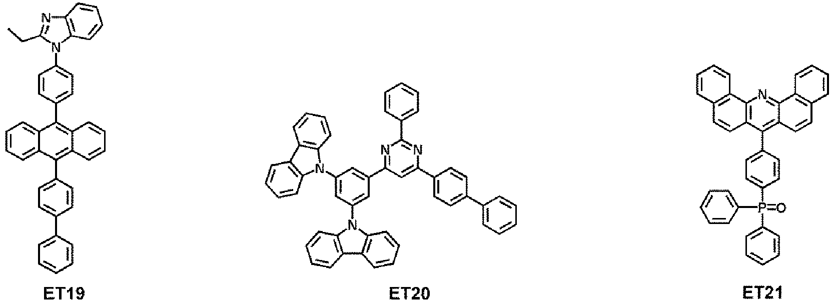

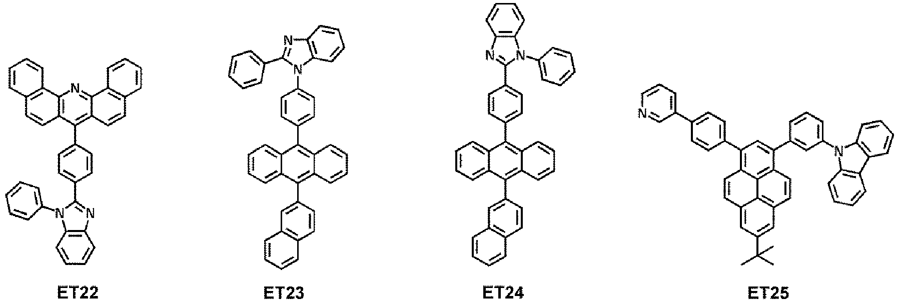

A thickness of the electron transport layer may be in a range of about 100 Å to about 1,000 Å, for example, about 150 Å to about 500 Å. When the thickness of the electron transport layer is within the range described above, the electron transport layer may have satisfactory electron transport characteristics without a substantial increase in driving voltage.

Also, the electron transport layer may further include, in addition to the materials described above, a metal-containing material.

The metal-containing material may include a Li complex. The Li complex may include, for example, Compound ET-D1 or ET-D2:

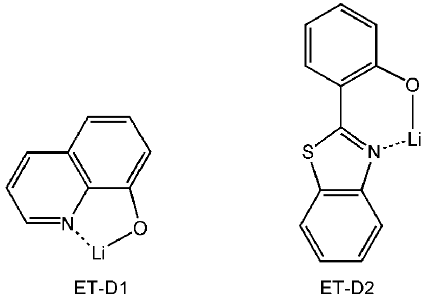

The electron transport region may include an electron injection layer (EIL) that promotes the flow of electrons from the second electrode 19 thereinto.

The electron injection layer may include LiF, NaCl, CsF, Li₂O, BaO, or any combination thereof.

A thickness of the electron injection layer may be in a range of about 1 Å to about 100 Å, and, for example, about 3 Å to about 90 Å. When the thickness of the electron injection layer is within the range described above, the electron injection layer may have satisfactory electron injection characteristics without a substantial increase in driving voltage.

The second electrode 19 may be located on the organic layer 15. The second electrode 19 may be a cathode. A material for forming the second electrode 19 may be metal, an alloy, an electrically conductive compound, or a combination thereof, which have a relatively low work function. For example, lithium (Li), magnesium (Mg), aluminum (Al), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device has been described with reference to FIGURE, but embodiments of the present disclosure are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, and the like.

Another aspect provides a diagnostic composition including at least one organometallic compound represented by Formula 1.

The organometallic compound represented by Formula 1 provides high luminescent efficiency. Accordingly, a diagnostic composition including the organometallic compound may have high diagnostic efficiency.

The diagnostic composition may be used in various applications including a diagnosis kit, a diagnosis reagent, a biosensor, and a biomarker.

The term "C₁-C₆₀ alkyl group" as used herein refers to a linear or branched saturated aliphatic hydrocarbons monovalent group having 1 to 60 carbon atoms, and the term "C₁-C₆₀ alkylene group_{"} as used here refers to a divalent group having the same structure as the C₁-C₆₀ alkyl group.

Examples of the C₁-C₆₀ alkyl group, the C₁-C₂₀ alkyl group, and/or the C₁-C₁₀ alkyl group are a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or any combination thereof. For example, Formula 9-33 is a branched C₆ alkyl group, for example, a tert-butyl group that is substituted with two methyl groups.

The term "C₁-C₆₀ alkoxy group" as used herein refers to a monovalent group having the formula of -OA₁₀₁ (where A₁₀₁ is the C₁-C₆₀ alkyl group).

Examples of the C₁-C₆₀ alkoxy group, a C₁-C₂₀ alkoxy group or C₁-C₁₀ alkoxy group are a methoxy group, an ethoxy group, a propoxy group, a butoxy group, and a pentoxy group.

The term "C₂-C₆₀ alkenyl group" as used herein refers to a hydrocarbon group formed by substituting at least one carbon-carbon double bond in the middle or at the terminus of the C₂-C₆₀ alkyl group, and examples thereof include an ethenyl group, a propenyl group, and a butenyl group. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and examples thereof include an ethynyl group, and a propynyl group. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon cyclic group having 3 to 10 carbon atoms, and the C₃-C₁₀ cycloalkylene group is a divalent group having the same structure as the C₃-C₁₀ cycloalkyl group.

Examples of the C₃-C₁₀ cycloalkyl group are a cyclopropyl group, a cyclobutyl group, a cyclopentyl, cyclohexyl group, a cycloheptyl group, a cyclooctyl group, an adamantanyl group, a norbornanyl group (a bicyclo[2.2.1]heptyl group), a bicyclo[1.1.1]pentyl group, a bicyclo[2.1.1]hexyl group, and a bicyclo[2.2.2]octyl group.

The term "C₁-C₁₀ heterocycloalkyl group" as used herein refers to a saturated cyclic group that includes at least one hetero atom selected from N, O, P, Si, S, Se, Ge, and B as a ring-forming atom and 1 to 10 carbon atoms, and the C₁-C₁₀ heterocycloalkylene group refers to a divalent group having the same structure as the C₁-C₁₀ heterocycloalkyl group.

Examples of the C₁-C₁₀ heterocycloalkyl group are a silolanyl group, a silinanyl group, tetrahydrofuranyl group, a tetrahydro-2H-pyranyl group, a tetrahydrothiophenyl group, and the like.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one hetero atom selected from N, O, P, Si, S, Se, Ge, and B as a ring-forming atom, 1 to 10 carbon atoms, and at least one carbon-carbon double bond in its ring. Examples of the C₁-C₁₀ heterocycloalkenyl group are a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms, and the term "C₆-C₆₀ arylene group" as used herein refers to a divalent group having a carbocyclic aromatic system having 6 to 60 carbon atoms. Examples of the C₆-C₆₀ aryl group include a phenyl group, a naphthyl group, an anthracenyl group, a phenanthrenyl group, a pyrenyl group, and a chrysenyl group. When the C₆-C₆₀ aryl group and the C₆-C₆₀ arylene group each include two or more rings, the rings may be fused to each other.

The C₇-C₆₀ alkylaryl group used herein refers to a C₆-C₆₀ aryl group substituted with at least one C₁-C₆₀ alkyl group.

The term "C₁-C₆₀ heteroaryl group" as used herein refers to a monovalent group having at least one hetero atom selected from N, O, P, Si, S, Se, Ge, and B as a ring-forming atom and a cyclic aromatic system having 1 to 60 carbon atoms, and the term "C₁-C₆₀ heteroarylene group" as used herein refers to a divalent group having at least one hetero atom selected from N, O, P, Si, S, Se, Ge, and B as a ring-forming atom and a carbocyclic aromatic system having 1 to 60 carbon atoms. Examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. When the C₆-C₆₀ heteroaryl group and the C₆-C₆₀ heteroarylene group each include two or more rings, the rings may be fused to each other.

The C₂-C₆₀ alkylheteroaryl group used herein refers to a C₁-C₆₀ heteroaryl group substituted with at least one C₁-C₆₀ alkyl group.

The term "C₆-C₆₀ aryloxy group" as used herein indicates -OA₁₀₂ (wherein A₁₀₂ indicates the C₆-C₆₀ aryl group), the C₆-C₆₀ arylthio group indicates -SA₁₀₃ (wherein A₁₀₃ indicates the C₆-C₆₀ aryl group), and the C₁-C₆₀ alkylthio group indicates -SA₁₀₄ (wherein A₁₀₄ indicates the C₁-C₆₀ alkyl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Examples of the monovalent non-aromatic condensed polycyclic group include a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed to each other, a heteroatom selected from **N, O, P,** Si, S, Se, Ge, and **B,** other than carbon atoms, as a ring-forming atom, and no aromaticity in its entire molecular structure. Examples of the monovalent non-aromatic condensed heteropolycyclic group include a carbazolyl group. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group. Examples of the "C₅-C₃₀ carbocyclic group (unsubstituted or substituted with at least one R₁₀ₐ)" are an adamantane group, a norbornane group (a bicyclo[2.2.1]heptane group), a norbornene group, a bicyclo[1.1.1]pentane group, a bicyclo[2.1.1]hexane group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, a fluorene group (each unsubstituted or substituted with at least one R₁₀ₐ).

The term "C₁-C₃₀ heterocyclic group" as used herein refers to a saturated or unsaturated cyclic group having, as a ring-forming atom, at least one heteroatom selected from N, O, P, Si, Se, Ge, B, and S other than 1 to 30 carbon atoms. The C₁-C₃₀ heterocyclic group may be a monocyclic group or a polycyclic group. The "C₁-C₃₀ heterocyclic group (unsubstituted or substituted with at least one R₁₀ₐ)" may be, for example, a thiophene group, a furan group, a pyrrole group, a silole group, borole group, a phosphole group, a selenophene group, a germole group, a benzothiophene group, a benzofuran group, an indole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluorene-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluorene-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isooxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (, each unsubstituted or substituted with at least one R₁₀ₐ).

The terms "fluorinated C₁-C₆₀ alkyl group (or a fluorinated C₁-C₂₀ alkyl group or the like)", "fluorinated C₃-C₁₀ cycloalkyl group", "fluorinated C₁-C₁₀ heterocycloalkyl group," and "fluorinated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one fluoro group (-F). For example, the "fluorinated C₁ alkyl group (that is, the fluorinated methyl group)" may include -CF₃, -CF₂H, and -CFH₂. The "fluorinated C₁-C₆₀ alkyl group (or, a fluorinated C₁-C₂₀ alkyl group, or the like)", "the fluorinated C₃-C₁₀ cycloalkyl group", "the fluorinated C₁-C₁₀ heterocycloalkyl group", or "the fluorinated a phenyl group" may be i) a fully fluorinated C₁-C₆₀ alkyl group (or, a fully fluorinated C₁-C₂₀ alkyl group, or the like), a fully fluorinated C₃-C₁₀ cycloalkyl group, a fully fluorinated C₁-C₁₀ heterocycloalkyl group, or a fully fluorinated phenyl group, wherein, in each group, all hydrogen included therein is substituted with a fluoro group, or ii) a partially fluorinated C₁-C₆₀ alkyl group (or, a partially fluorinated C₁-C₂₀ alkyl group, or the like), a partially fluorinated C₃-C₁₀ cycloalkyl group, a partially fluorinated C₁-C₁₀ heterocycloalkyl group, or a partially fluorinated phenyl group, wherein, in each group, all hydrogen included therein is not substituted with a fluoro group.

The terms "deuterated C₁-C₆₀ alkyl group (or a deuterated C₁-C₂₀ alkyl group or the like)", "deuterated C₃-C₁₀ cycloalkyl group", "deuterated C₁-C₁₀ heterocycloalkyl group," and "deuterated phenyl group" respectively indicate a C₁-C₆₀ alkyl group (or a C₁-C₂₀ alkyl group or the like), a C₃-C₁₀ cycloalkyl group, a C₁-C₁₀ heterocycloalkyl group, and a phenyl group, each substituted with at least one deuterium. For example, the "deuterated C₁ alkyl group (that is, the deuterated methyl group)" may include - CD₃, -CD₂H, and -CDH₂, and examples of the "deuterated C₃-C₁₀ cycloalkyl group" are, for example, Formula 10-501 and the like. The "deuterated C₁-C₆₀ alkyl group (or, the deuterated C₁-C₂₀ alkyl group or the like)", "the deuterated C₃-C₁₀ cycloalkyl group", "the deuterated C₁-C₁₀ heterocycloalkyl group", or "the deuterated phenyl group" may be i) a fully deuterated C₁-C₆₀ alkyl group (or, a fully deuterated C₁-C₂₀ alkyl group or the like), a fully deuterated C₃-C₁₀ cycloalkyl group, a fully deuterated C₁-C₁₀ heterocycloalkyl group, or a fully deuterated phenyl group, in which, in each group, all hydrogen included therein are substituted with deuterium, or ii) a partially deuterated C₁-C₆₀ alkyl group (or, a partially deuterated C₁-C₂₀ alkyl group or the like), a partially deuterated C₃-C₁₀ cycloalkyl group, a partially deuterated C₁-C₁₀ heterocycloalkyl group, or a partially deuterated phenyl group, in which, in each group, all hydrogen included therein are not substituted with deuterium.

The term "(C₁-C₂₀ alkyl) 'X' group" as used herein refers to a 'X' group that is substituted with at least one C₁-C₂₀ alkyl group. For example, the term "(C₁-C₂₀ alkyl)C₃-C₁₀ cycloalkyl group" as used herein refers to a C₃-C₁₀ cycloalkyl group substituted with at least one C₁-C₂₀ alkyl group, and the term "(C₁-C₂₀ alkyl)phenyl group" as used herein refers to a phenyl group substituted with at least one C₁-C₂₀ alkyl group. An example of a (C₁ alkyl) phenyl group is a toluyl group.

The terms "an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluorene-9-one group, and an azadibenzothiophene group 5,5-dioxide group" respectively refer to heterocyclic groups having the same backbones as "an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluorene-9-one group, a dibenzothiophene group 5,5-dioxide group," in which, in each group, at least one carbon selected from ring-forming carbons is substituted with nitrogen.

Substituent(s) of the substituted C₅-C₃₀ carbocyclic group, the substituted C₂-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkylaryl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted monovalent non-aromatic condensed polycyclic group, and the substituted monovalent non-aromatic condensed heteropolycyclic group may each independently be:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₁₁)(Q₁₂), - Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), -P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(=O)(Q₃₈)(Q₃₉), or -P(Q₃₈)(Q₃₉); or
any combination thereof.
Q₁ to Q₉, Q₁₁ to Q₁₉, Q₂₁ to Q₂₉, and Q₃₁ to Q₃₉ used herein are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

Hereinafter, a compound and an organic light-emitting device according to embodiments are described in detail with reference to Synthesis Example and Examples. However, the organic light-emitting device is not limited thereto. The wording "B was used instead of A" used in describing Synthesis Examples means that an amount of A used was identical to an amount of B used, in terms of a molar equivalent.

### [Examples]

### Synthesis Example 1 (Compound 1)

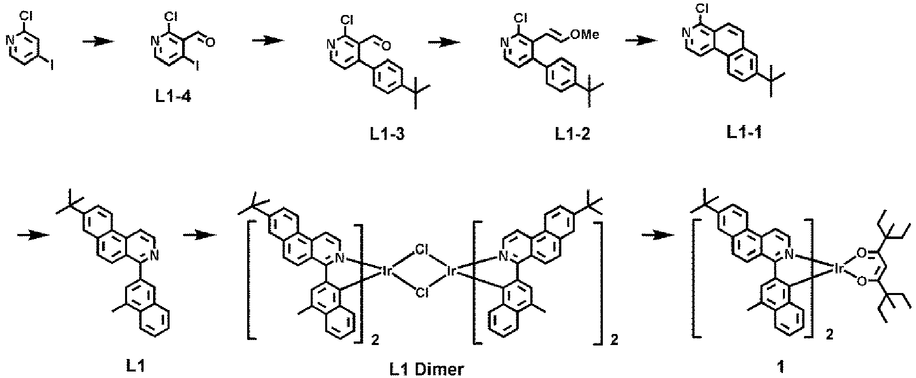

### Synthesis of Intermediate L1-4

5 g (20.9 mmol) of 2-chloro-4-iodopyridine was dissolved in 50 ml of anhydrous **THF** (tetrahydrofuran), and 12.5 ml (25 mmol) of 2.0M lithium diisopropylamide (in THF) was slowly added dropwise thereto at a temperature of -78 °C. After about 3 hours, 2.5 ml (32 mmol) of ethylformate was slowly added dropwise thereto, followed by stirring at room temperature for 18 hours. When the reaction was completed, water and ethylacetate were added to the reaction mixture and an extraction process was performed thereon, and the obtained organic layer was dried using magnesium sulfate and distilled under reduced pressure. The resultant was purified by liquid chromatorgraphy to obtain 2.2 g of Intermediate L1-4 (yield of 40%).

### Synthesis of Intermediate L1-3

2.0 g (7.5 mmol) of Intermediate L1-4 was dissolved in 60 ml of acetonitrile and 15 ml of water, and then, 0.6 g (0.5 mmol) of PdCl₂(PPh₃)₂ (Bis(triphenylphosphine)palladium(II) dichloride), 1.4 g (8.0 mmol) of (4-(tert-butyl)phenyl)boronic acid, 2.6 g (18.8 mmol) of K₂CO₃ were added thereto and refluxed while heating at a temperature of 80 °C for 18 hours. When the reaction was completed, the reaction mixture was concentrated under reduced pressure, dichloromethane and water were added thereto, followed by extraction, and the obtained organic layer was dried using magnesium sulfate and distilled under reduced pressure. The resultant was purified by liquid chromatorgraphy to obtain 1.4 g of Intermediate L1-3 (yield of 84%).

### Synthesis of Intermediate L1-2

5.4 g (15.8 mmol) of (Methoxymethyl)triphenylphosphonium chloride was dissolved in 50 ml of anhydrous diethyl ether, and then, 16 ml of 1.0 M potassium tert-butoxide solution was added dropwise thereto. After stirring at room temperature for about 1 hour, 1.7 g (6.3 mmol) of Intermediate L1-3 dissolved in 30 ml of anhydrous THF was slowly added dropwise thereto and stirred at room temperature for 18 hours. When the reaction was completed, water and ethylacetate were added to the reaction mixture and an extraction process was performed thereon, and the obtained organic layer was dried using magnesium sulfate and distilled under reduced pressure. The resultant was purified by liquid chromatorgraphy to obtain 1.6 g of Intermediate L1-2 (yield of 95%).

### Synthesis of Intermediate L1-1

1.4 g (5.1 mmol) of Intermediate L1-2 was dissolved in 40 ml of dichloromethane, and 3.0 ml of methanesulfonic acid was slowly added dropwise thereto, followed by stirring at room temperature for about 18 hours. After the reaction was completed, an extraction process was performed thereon after adding a saturated aqueous sodium hydrogen carbonate solution thereto, and the obtained organic layer was dried using magnesium sulfate and distilled under reduced pressure. The resultant was purified by liquid chromatorgraphy to obtain 1.0 g of Intermediate L1-1 (yield of 90%).

### Synthesis of Intermediate L1

1.0 g (4.1 mmol) of Intermediate L1-1 was dissolved in 40 ml of THF and 10 ml of water, and then, 1.6 g (6.2 mmol) of 3,5-4,4,5,5-tetramethyl-2-(4-methylnaphthalen-2-yl)-1,3,2-dioxaborolane, 0.09 g (0.4 mmol) of Pd(OAc)₂ (Palladium(II) acetate), 0.35 g (0.82 mmol) of Sphos (2-dicyclohexylphosphino-2',6'-dimethoxybiphenyl), 1.4 g (10.3 mmol) of K₂CO₃ were added thereto, and the resultant mixture was refluxed while heating at 70 °C for about 24 hours. After the reaction was completed, an extraction process was performed thereon after adding ethylacetate and water thereto, and the obtained organic layer was dried using magnesium sulfate and distilled under reduced pressure. The resultant was purified by liquid chromatorgraphy to obtain 1.1 g of Intermediate L1 (yield of 85%).

### Synthesis of Intermediate L1 Dimer

1.05 g (3.4 mmol) of Intermediate L1 and 0.6 g (1.6 mmol) of iridium chloride were added to 40 mL of ethoxyethanol and 15 mL of distilled water, followed by refluxing while heating at 70 °C for 24 hours. After the reaction was completed, the temperature was lowered to room temperature, and the solid produced therefrom was filtered and washed sufficiently in the order of water/methanol/hexane. The obtained solid was dried in a vacuum oven to obtain 1.1 g of Intermediate L1 Dimer.

### Synthesis of Compound 1

40 mL of ethoxyethanol was mixed with 1.0 g (0.63 mmol) of Intermediate L1 Dimer, 0.9 g (4.5 mmol) of 3,7-diethyl-3,7-dimethylnonane-4,6-dione, and 0.48 g (4.5 mmol) of Na₂CO₃, and the resultant mixture was stirred for 24 hours at a temperature of 90 °C to proceed a reaction. After the reaction was completed, the temperature was lowered to room temperature, and the solid produced therefrom was filtered and purified by liquid chromatography to obtain 0.5 g (yield of 40%) of Compound 1.
LC-MS m/z = 1181(M+H)⁺

### Synthesis Example 2 (Compound 6)

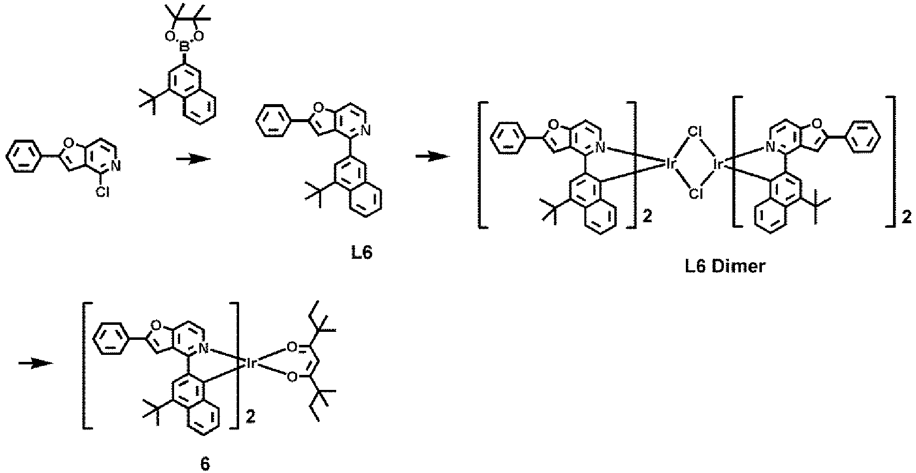

### Synthesis of Intermediate L6

0.9 g (yield of 84%) of Intermediate L6 was obtained in the same manner as used to obtain Intermediate L1 of Synthesis Example 1, except that 4-chloro-2-phenylfuro[3,2-c]pyridine was used instead of Intermediate L1-1 and 2-(4-(tert-butyl)naphthalen-2-yl)-4,4,5,5-tetramethyl-1,3,2-dioxaborolane was used instead of tetramethyl-2-(4-methylnaphthalen-2-yl)-1,3,2-dioxaborolane.
LC-MS m/z = 378(M+H)⁺

### Synthesis of Intermediate L6 Dimer

0.7g of Intermediate L6 Dimer was obtained in the same manner as used to obtain Intermediate L1 Dimer of Synthesis Example 1, except that Intermediate L6 was used instead of Intermediate L1.

### Synthesis of Compound 6

0.3 g (yield of 42%) of Compound 6 was obtained in the same manner as used to obtain Compound 1 of Synthesis Example 1, except that Intermediate L6 Dimer was used instead of Intermediate L1 Dimer and 3,3,7,7-tetramethylnonane-4,6-dione was used instead of 3,7-diethyl-3,7-dimethylnonane-4,6-dione.
LC-MS m/z = 1185(M+H)⁺

### Synthesis Example 3 (Compound 11)

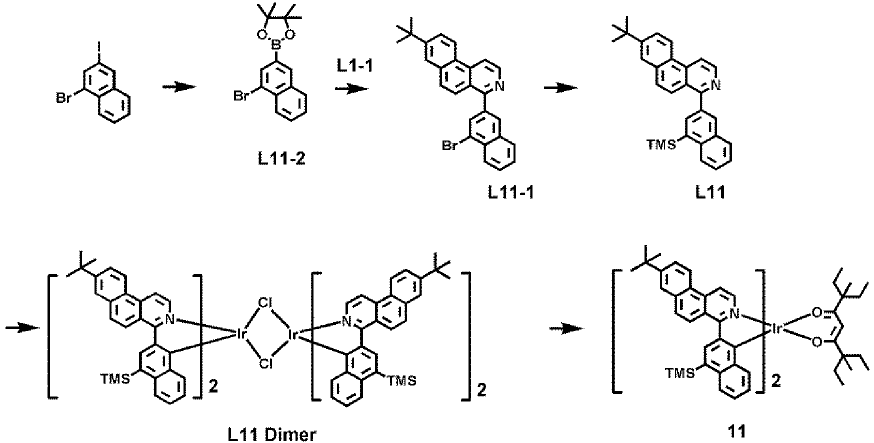

### Synthesis of Intermediate L11-2

2.5 g (7.4 mmol) of 1-bromo-3-iodonaphthalene was mixed with 60 ml of anhydrous tetrahydrofuran (THF), and then, 4.8 ml (7.4 mmol) of 1.6 M BuLi *(n-*butyllithium) solution in hexane was slowly added thereto at a temperature of -78 °C. After about 1 hour, 1.8 ml (8.9 mmol) of 2-iIsopropoxy-4,4,5,5-tetramethyl-1,3,2-dioxaborolane was slowly added dropwise thereto and stirred at room temperature for 14 hours. After completion of the reaction, the organic layer, obtained by extraction with 50 ml of water and ethylacetate, was dried using magnesium sulfate and distilled under reduced pressure. The resultant was purified by liquid chromatorgraphy to obtain 2.2 g of Intermediate L11-2 (yield of 90%).

### Synthesis of Intermediate L11-1

2.3 g (yield of 80%) of Intermediate L11-1 was obtained in the same manner as used to obtain Intermediate L1 of Synthesis Example 1, except that Intermediate L11-2 was used instead of 4,4,5,5-tetramethyl-2-(4-methylnaphthalen-2-yl)-1,3,2-dioxaborolane.
LC-MS m/z = 440(M+H)⁺

### Synthesis of Intermediate L11

2.2 g (5.0 mmol) of Intermediate L11-1 was mixed with 40 ml of anhydrous tetrahydrofuran (THF), and then, at a temperature of -78°C, 3.4 ml (5.5 mmol) of 1.6M BuLi solution in hexane was slowly added thereto. After about 1 hour, 0.8 ml (6.0 mmol) of chlorotrimethylsilane was slowly added dropwise thereto and stirred at room temperature for 12 hours. After completion of the reaction, the organic layer, obtained by extraction with 40 ml of water and ethylacetate, was dried using magnesium sulfate and distilled under reduced pressure. The resultant was purified by liquid chromatorgraphy to obtain 2.0 g (yield of 95%) of Intermediate L11.
LC-MS m/z = 434(M+H)⁺

### Synthesis of Intermediate L11 Dimer

Intermediate L11 Dimer was obtained in the same manner as used to obtain Intermediate L1 Dimer of Synthesis Example 1, except that Intermediate L11 was used instead of Intermediate L1 and refluxing was performed while heating at 100 °C for 24 hours.

### Synthesis of Compound 11

0.3 g (yield of 15%) of Compound 11 was obtained in the same manner as used to obtain Compound 1 of Synthesis Example 1, except that Intermediate L11 Dimer was used instead of Intermediate L1 Dimer.
LC-MS m/z = 1297(M+H)⁺

### Synthesis Example 4 (Compound 13)

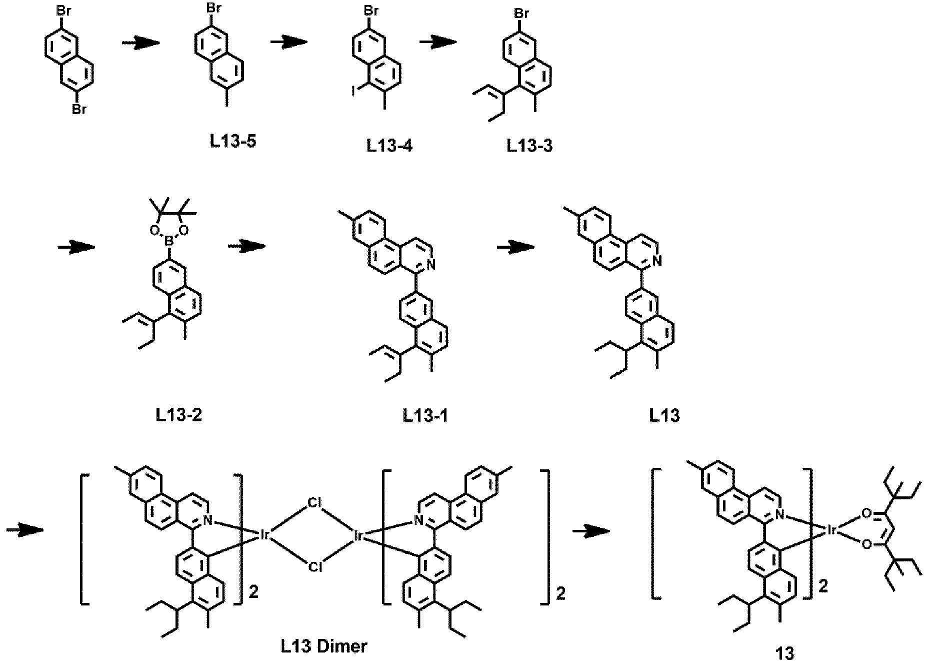

### Synthesis of Intermediate L13-5

10.0 g (34.9 mmol) of 2,6-dibromonaphthalene was mixed with 120 ml of anhydrous tetrahydrofuran (THF), and then, at a temperature of -78 °C, 24.0 ml (38.0 mmol) of 1.6 M BuLi solution in hexane was slowly added thereto. After about 1 hour, 2.6 ml (42.0 mmol) of iodomethane was slowly added dropwise thereto and stirred at room temperature for 18 hours. After completion of the reaction, the organic layer, obtained by extraction with 60 ml of water and ethylacetate, was dried using magnesium sulfate and distilled under reduced pressure. The resultant was purified by liquid chromatorgraphy to obtain 6.9 g (yield of 90%) of Intermediate L13-5.
LC-MS m/z = 221(M+H)⁺

### Synthesis of Intermediate L13-4

6.9 g (31.4 mmol) of Intermediate L13-5 was dissolved in 120 ml of acetonitrile, and then, 0.8 ml (9.4 mmol) of trifluoroacetic acid and 8.5 ml (37.7 mmol) of N-lodosuccinimide were added dropwise thereto, and then, the resultant mixture was heated at a temperature of 80°C for 18 hours. After completion of the reaction, the organic layer obtained by extraction with aqueous ethylacetate and sodium thiosulfate was dried by using magnesium sulfate. The reaction mixture was filtered, concentrated under reduced pressure, and purified by liquid chromatorgraphy to obtain 9.8 g (yield of 90%) of Intermediate L13-4.
LC-MS m/z = 347(M+H)⁺

### Synthesis of Intermediate L13-3

6.1 g (yield of 75%) of Intermediate L13-3 was obtained in the same manner as used to obtain Intermediate L1 of Synthesis Example 1, except that 4,4,5,5-tetramethyl-2-(pent-2-en-3-yl)-1,3,2-dioxaborolane was used instead of tetramethyl-2-(4-methylnaphthalen-2-yl)-1,3,2-dioxaborolane, and Intermediate L13-4 was used instead of Intermediate L1-1.

### Synthesis of Intermediate L13-2

6.4 g (yield of 90%) of Intermediate L13-2 was obtained in the same manner as used to obtain Intermediate L11-2 of Synthesis Example 3, except that Intermediate L13-3 was used instead of 1-bromo-3-iodonaphthalene.

### Synthesis of Intermediate L13-1

6.3 g (yield of 82%) of Intermediate L13-1 was obtained in the same manner as used to obtain Intermediate L1 of Synthesis Example 1, except that Intermediate L13-2 was used instead of 4,4,5,5-tetramethyl-2-(4-methylnaphthalen-2-yl)-1,3,2-dioxaborolane and 4-chloro-8-methylbenzo[f]isoquinoline was used instead of L1-1.

### Synthesis of Intermediate L13

6.0 g (14.9 mmol) of Intermediate L13-1 was mixed with 60 ml of ethanol, and 0.6 g (10 wt%) of Pd/C (palladium on carbon) was added thereto, and then, hydrogen was added thereto, followed by stirring for 18 hours at room temperature. After completion of the reaction, the reaction mixture was passed through a celite pad, concentrated under reduced pressure, and then purified by liquid chromatography to obtain 5.4 g (yield of 90%) of Intermediate L13.
LC-MS m/z = 404(M+H)⁺

### Synthesis of Intermediate L13 Dimer

2.0 g of Intermediate L13 Dimer was obtained in the same manner as used to obtain Intermediate L1 Dimer of Synthesis Example 1, except that Intermediate L13 was used instead of Intermediate L1.

### Synthesis of Compound 13

1.3 g (yield of 46%) of Compound 13 was obtained in the same manner as used to obtain Compound 1 of Synthesis Example 1, except that Intermediate L13 Dimer was used instead of Intermediate L1 Dimer.
LC-MS m/z = 1238(M+H)⁺

### Synthesis Example 5 (Compound 16)

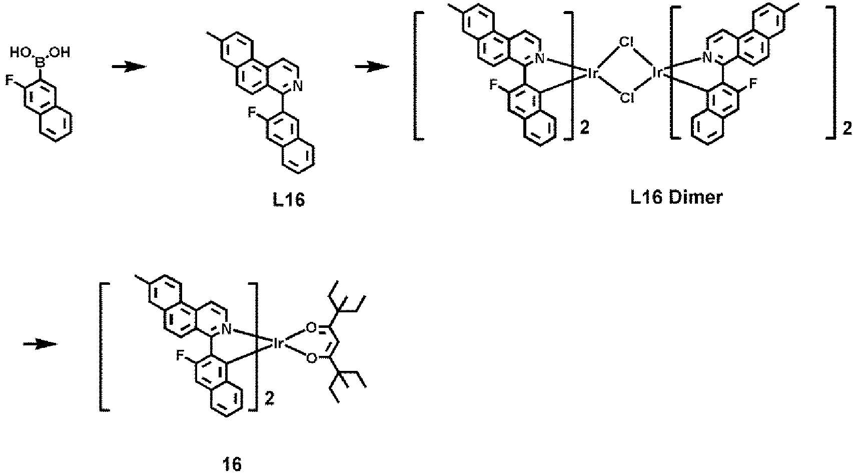

### Synthesis of Intermediate L16

1.1 g (yield of 74%) of Intermediate L16-1 was obtained in the same manner as used to obtain Intermediate L1 of Synthesis Example 1, except that (3-fluoronaphthalen-2-yl)boronic acid was used instead of 4,4,5,5-tetramethyl-2-(4-methylnaphthalen-2-yl)-1,3,2-dioxaborolane and 4-chloro-8-methylbenzo[f]isoquinoline was used instead of L1-1.
LC-MS m/z = 338(M+H)⁺

### Synthesis of Intermediate L16 Dimer

0.9 g of Intermediate L16 Dimer was obtained in the same manner as used to obtain Intermediate L1 Dimer of Synthesis Example 1, except that Intermediate L16 was used instead of Intermediate L1.

### Synthesis of Compound 16

0.7 g (yield of 40%) of Compound 16 was obtained in the same manner as used to obtain Compound 1 of Synthesis Example 1, except that Intermediate L16 Dimer was used instead of Intermediate L1 Dimer.
LC-MS m/z = 1105(M+H)⁺

### Synthesis Example 6 (Compound 23)

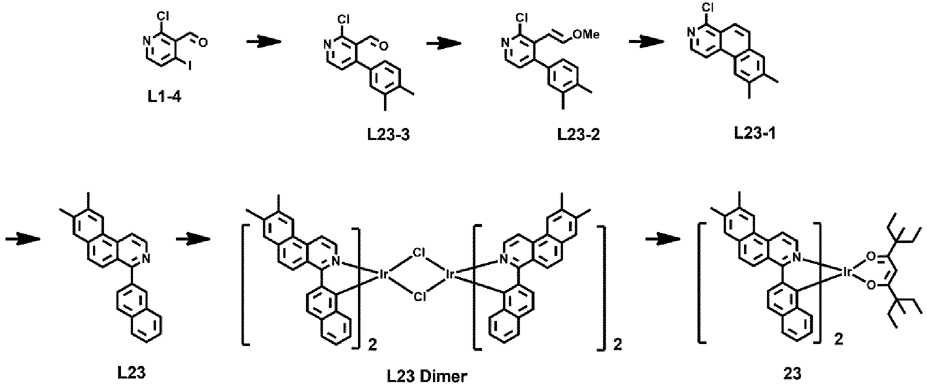

### Synthesis of Intermediate L23-3

3.5 g (yield of 80%) of Intermediate L23-3 was obtained in the same manner as used to obtain Intermediate L1-3 of Synthesis Example 1, except that (3,4-dimethylphenyl)boronic acid was used instead of (4-(tert-butyl)phenyl)boronic acid.

### Synthesis of Intermediate L23-2

3.5 g (yield of 90%) of Intermediate L23-2 was obtained in the same manner as used to obtain Intermediate L1-2 of Synthesis Example 1, except that Intermediate L23-3 was used instead of Intermediate L1-3.

### Synthesis of Intermediate L23-1

1.9 g (yield of 63%) of Intermediate L23-1 was obtained in the same manner as used to obtain Intermediate L1-1 of Synthesis Example 1, except that Intermediate L23-2 was used instead of Intermediate L1-2.

### Synthesis of Intermediate L23

0.8 g (yield of 80%) of Intermediate L23 was obtained in the same manner as used to obtain Intermediate L1 of Synthesis Example 1, except that Intermediate L23-1 was used instead of Intermediate L1-1 and 4,4,5,5-tetramethyl-2-(naphthalen-2-yl)-1,3,2-dioxaborolane was used instead of 4,4,5,5-tetramethyl-2-(4-methylnaphthalen-2-yl)-1,3,2-dioxaborolane.

### Synthesis of Intermediate L23 Dimer

40 mL of ethoxyethanol was mixed with Intermediate L23 (3.4 mmol) and iridium chloride (1.6 mmol), followed by refluxing while heating at 125 °C for 48 hours. Once the reaction was completed, the temperature was cooled to room temperature, and a solid material formed therefrom was filtered and washed thoroughly with water and methanol in this stated order. The obtained solid was dried in a vacuum oven to obtain 0.6 g of Intermediate L23 Dimer.

### Synthesis of Compound 23

40 mL of ethoxyethanol was mixed with Intermediate L23 Dimer (1 equiv.), 3,7-diethyl-3,7-dimethylnonane-4,6-dione (2.5 equiv.), and K₂CO₃ (2.5 equiv.), and the resultant was stirred for 24 hours at room temperature to cause a reaction. Once the reaction was completed, methanol was added thereto to filter the resulting solid, and the obtained solid was purified through liquid chromatography to obtain 70 mg (yield of 10%) of Compound 23.
LC-MS m/z = 1098(M+H)⁺

### Synthesis Example 7 (Compound 27)

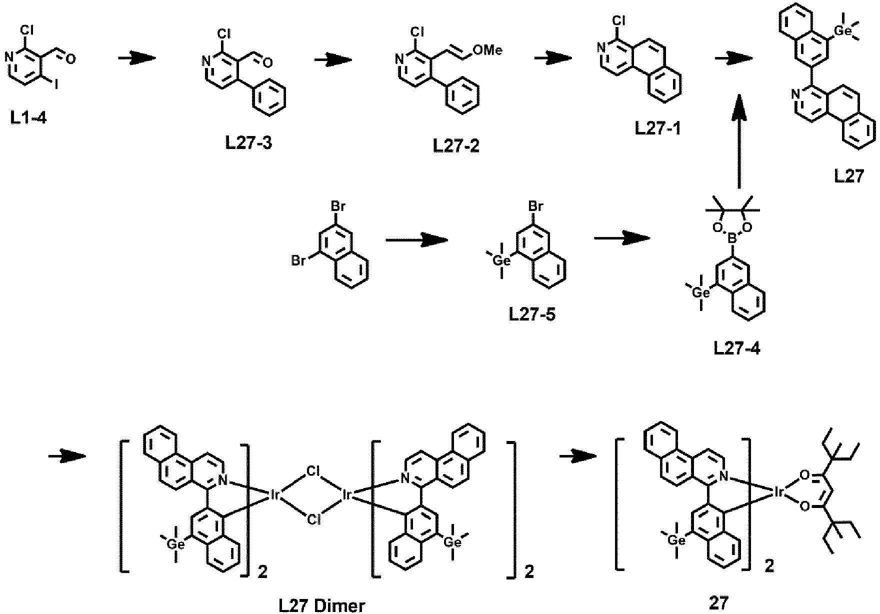

### Synthesis of Intermediate L27-5

10.0 g (42.4 mmol) of 1,3-dibromonaphthalene was dissolved in 100 ml of diethyl ether, and then, at a temperature of -78 °C, 28.0 ml (44.5 mmol) of 1.6M BuLi solution in hexane was slowly added thereto. After about 1 hour of stirring, 6.6 ml (53.4 mmol) of chlorotrimethylgermane was slowly added dropwise thereto and stirred for 18 hours at room temperature. After completion of the reaction, an organic layer obtained by extraction using water and ethylacetate, was dried using magnesium sulfate and purified through liquid chromatography to obtain 12.5 g (yield of 90%) of Intermediate L27-5.

### Synthesis of Intermediate L27-4

12.0 g (37.1 mmol) of Intermediate L27-5 and 150 ml of toluene were mixed, and 14.0 g (55.6 mmol) of diboron, 3.0 g (2.6 mmol) of Pd(PPh₃)₄, and 12.8 g (92.7 mmol) of K₂CO₃ were added thereto, followed by refluxing while heating at a temperature of 110 °C for 16 hours. After completion of the reaction, the reaction mixture was concentrated under reduced pressure, extracted using ethylacetate, and purified through liquid chromatography to obtain 10.0 g (6.0 mmol, yield of 75%) of Intermediate L27-4.

### Synthesis of Intermediate L27-3

3.2 g (yield of 85%) of Intermediate L27-3 was obtained in the same manner as used to obtain Intermediate L1-3 of Synthesis Example 1, except that phenylboronic acid was used instead of (4-(tert-butyl)phenyl)boronic acid.

### Synthesis of Intermediate L27-2

3.3 g (yield of 92%) of Intermediate L27-2 was obtained in the same manner as used to obtain Intermediate L1-2 of Synthesis Example 1, except that Intermediate L27-3 was used instead of Intermediate L1-3.

### Synthesis of Intermediate L27-1

1.9 g (yield of 65%) of Intermediate L27-1 was obtained in the same manner as used to obtain Intermediate L1-1 of Synthesis Example 1, except that Intermediate L27-2 was used instead of Intermediate L1-2.

### Synthesis of Intermediate L27

2.8 g (yield of 75%) of Intermediate L27 was obtained in the same manner as used to obtain Intermediate L1 of Synthesis Example 1, except that Intermediate L27-1 was used instead of Intermediate L1-1 and Intermediate L27-4 was used instead of 4,4,5,5-tetramethyl-2-(4-methylnaphthalen-2-yl)-1,3,2-dioxaborolane.
LC-MS m/z = 423(M+H)+

### Synthesis of Intermediate L27 Dimer

0.9 g of Intermediate L27 Dimer was obtained in the same manner as used to obtain Intermediate L1 Dimer of Synthesis Example 1, except that Intermediate L27 was used instead of Intermediate L1.

### Synthesis of Compound 27

0.2 g (yield of 12%) of Compound 27 was obtained in the same manner as used to obtain Compound 1 of Synthesis Example 1, except that Intermediate L27 Dimer was used instead of Intermediate L1 Dimer.
LC-MS m/z = 1275(M+H)⁺

### Synthesis Example 8 (Compound 10)

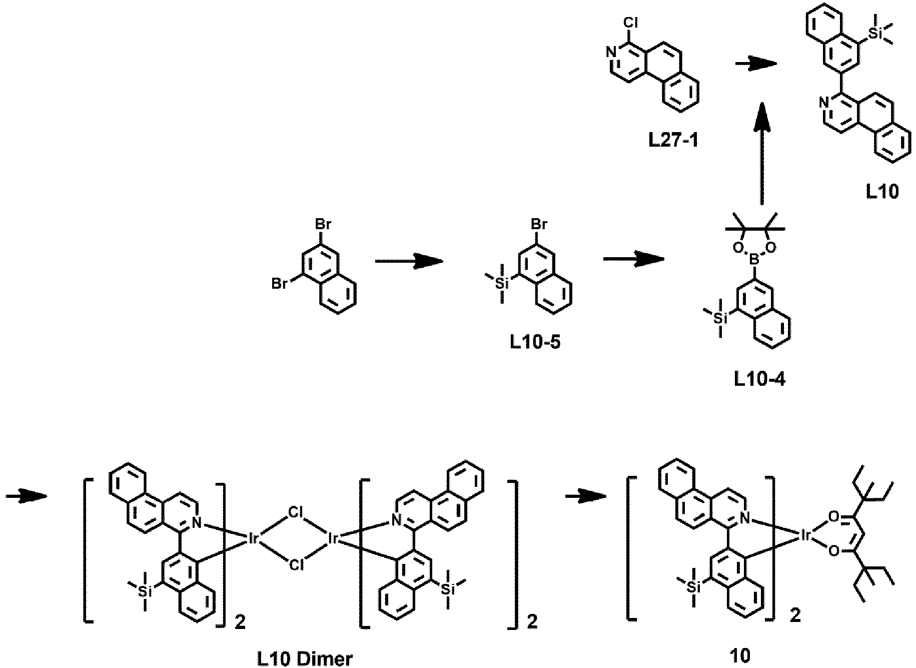

### Synthesis of Intermediate L10-5

4.8 g (yield of 85%) of Intermediate L10-5 was obtained in the same manner as used to obtain Intermediate L27-5 of Synthesis Example 7, except that chlorotrimethylsilane was used instead of chlorotrimethylgermane.

### Synthesis of Intermediate L10-4

4.2 g (yield of 76%) of Intermediate L10-4 was obtained in the same manner as used to obtain Intermediate L27-4 of Synthesis Example 7, except that Intermediate L10-5 was used instead of Intermediate L27-5.

### Synthesis of Intermediate L10

Intermediate L10 was obtained in the same manner as used to obtain Intermediate L27 of Synthesis Example 7, except that Intermediate L10-4 was used instead of Intermediate L27-4.

### Synthesis of Intermediate L10 Dimer

0.8 g of Intermediate L10 Dimer was obtained in the same manner as used to obtain Intermediate L27 Dimer of Synthesis Example 7, except that Intermediate L10 was used instead of Intermediate L27.

### Synthesis of Compound 10

0.2 g (yield of 20%) of Compound 10 was obtained in the same manner as used to obtain Compound 27 of Synthesis Example 7, except that Intermediate L10 Dimner was used instead of Intermediate L27 Dimer.
LC-MS m/z = 1185(M+H)⁺

### Synthesis Example 9 (Compound 24)

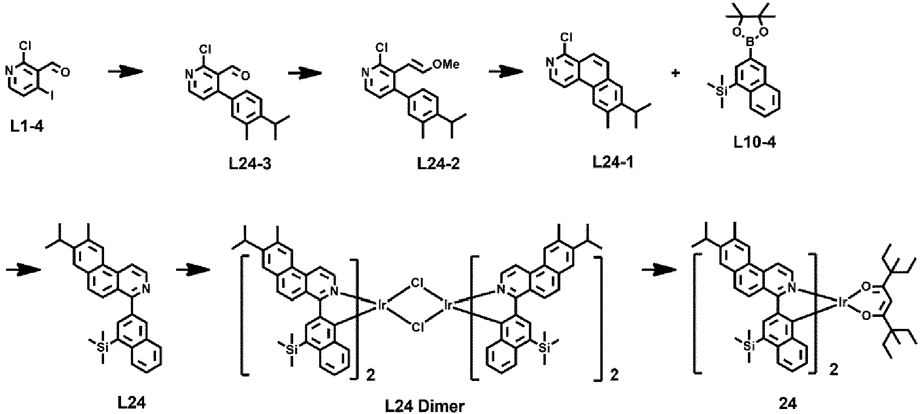

### Synthesis of Intermediate L24-3

2.7 g (yield of 78%) of Intermediate L24-3 was obtained in the same manner as used to obtain Intermediate L1-3 of Synthesis Example 1, except that (4-isopropyl-3-methylphenyl)boronic acid was used instead of (4-(tert-butyl)phenyl)boronic acid. Synthesis of Intermediate L24-2

2.7 g (yield of 92%) of Intermediate L24-2 was obtained in the same manner as used to obtain Intermediate L1-2 of Synthesis Example 1, except that Intermediate L24-3 was used instead of Intermediate L1-3.

### Synthesis of Intermediate L24-1

1.3 g (yield of 55%) of Intermediate L24-1 was obtained in the same manner as used to obtain Intermediate L1-1 of Synthesis Example 1, except that Intermediate L24-2 was used instead of Intermediate L1-2.

### Synthesis of Intermediate L24

1.6 g (yield of 75%) of Intermediate L24 was obtained in the same manner as used to obtain Intermediate L1 of Synthesis Example 1, except that Intermediate L24-1 was used instead of Intermediate L1-1 and Intermediate L10-4 was used instead of 4,4,5,5-tetramethyl-2-(4-methylnaphthalen-2-yl)-1,3,2-dioxaborolane.

### Synthesis of Intermediate L24 Dimer

1.0 g of Intermediate L24 Dimer was obtained in the same manner as used to obtain Intermediate L1 Dimer of Synthesis Example 1, except that Intermediate L24 was used instead of Intermediate L1.

### Synthesis of Compound 24

0.4 g (yield of 35%) of Comopund 24 was obtained in the same manner as used to obtain Compound 1 of Synthesis Example 1, except that Intermediate L24 Dimer was used instead of Intermediate L1 Dimer.
LC-MS m/z = 1297(M+H)⁺

### Synthesis Example 10 (Compound 26)

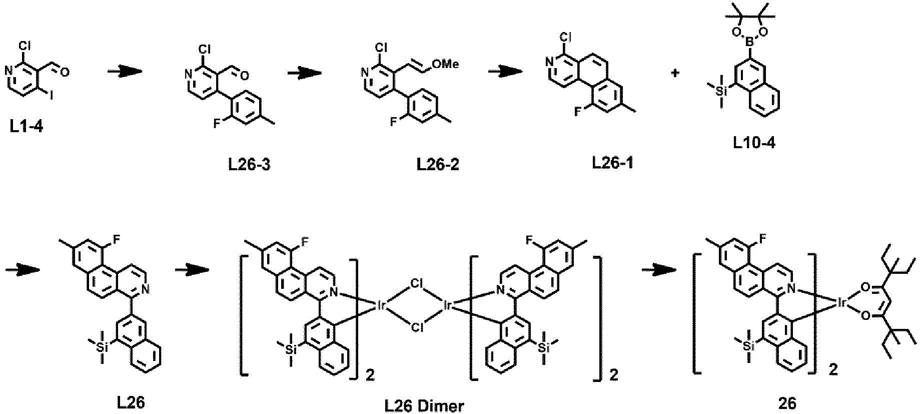

### Synthesis of Intermediate L26-3

2.5 g (yield of 75%) of Intermediate L26-3 was obtained in the same manner as used to obtain Intermediate L1-3 of Synthesis Example 1, except that (2-fluoro-4-methylphenyl)boronic acid was used instead of (4-(tert-butyl)phenyl)boronic acid. Synthesis of Intermediate L26-2

2.4 g (yield of 88%) of Intermediate L26-2 was obtained in the same manner as used to obtain Intermediate L1-2 of Synthesis Example 1, except that Intermediate L26-3 was used instead of Intermediate L1-3.

### Synthesis of Intermediate L26-1

1.0 g (yield of 50%) of Intermediate L26-1 was obtained in the same manner as used to obtain Intermediate L1-1 of Synthesis Example 1, except that Intermediate L26-2 was used instead of Intermediate L1-2.

### Synthesis of Intermediate L26

1.2 g (yield of 70%) of Intermediate L26 was obtained in the same manner as used to obtain Intermediate L1 of Synthesis Example 1, except that Intermediate L26-1 was used instead of Intermediate L1-1 and Intermediate L10-4 was used instead of 4,4,5,5-tetramethyl-2-(4-methylnaphthalen-2-yl)-1,3,2-dioxaborolane.

### Synthesis of Intermediate L26 Dimer

0.8 g of Intermediate L26 Dimer was obtained in the same manner as used to obtain Intermediate L1 Dimer of Synthesis Example 1, except that Intermediate L26 was used instead of Intermediate L1.

### Synthesis of Compound 26

0.3 g (yield of 40%) of Comopund 26 was obtained in the same manner as used to obtain Compound 1 of Synthesis Example 1, except that Intermediate L26 Dimer was used instead of Intermediate L1 Dimer.
LC-MS m/z = 1249(M+H)⁺

### Synthesis Example 11 (Compound 32)

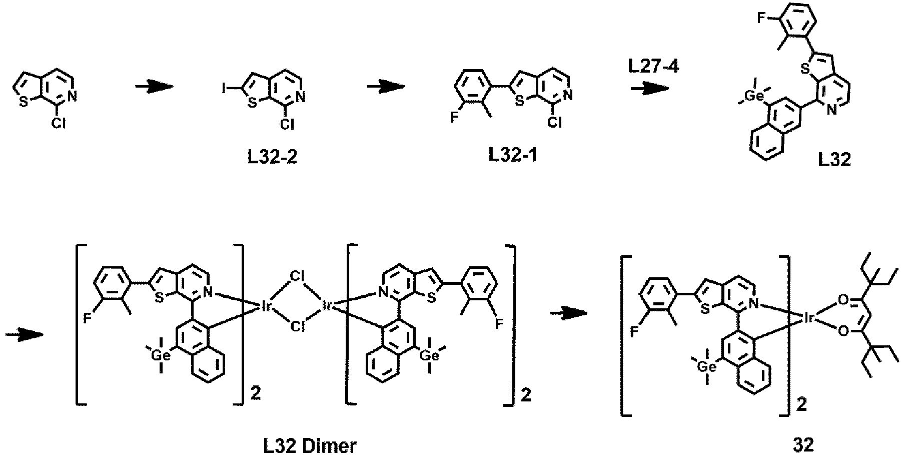

### Synthesis of Intermediate L32-2

6.0 g (35.4 mmol) of 7-chlorothieno[2,3-c]pyridine was dissolved in 60 ml of anhydrous THF, and then, at a temperature of -78 °C, 43.0 ml (42.5 mmol) of 1.0M LDA solution in THF was slowly added thereto. After about 1 hour of stirring, 11.0 g (43.0 mmol) of iodine dissolved in anhydrous THF was slowly added dropwise thereto and stirred at room temperature for 18 hours. After completion of the reaction, extraction was performed using water and ethylacetate, followed by a purification process through liquid chromatography to obtain 10.0 g (yield of 95%) of Intermediate L32-2.
LC-MS m/z = 296(M+H)⁺

### Synthesis of Intermediate L32-1

10.0 g (33.8 mmol) of Intermediate L32-2 was dissolved in 60 ml of 95% EtOH aqueous solution, and then, 5.4 g (35.5 mmol) of 3-fluoro-2-methylphenylboronic acid, 0.5 g (2.5 mmol) of Pd(OAc)₂, 1.9 g (4.7 mmol) of SPhos, and 11.7 g (84.5 mmol) of K₂CO₃ were added thereto, and refluxed while heating at a temperature of 80 °C for 18 hours. After completion of the reaction, the mixture obtained by concentrating the reactants was extracted using ethylacetate and water, and purified through liquid chromatography to obtain 7.8 g (yield of 83%) of Intermediate L32-1.
LC-MS m/z = 278(M+H)⁺

### Synthesis of Intermediate L32

7.0 g (25.2 mmol) of Intermediate L32-1 was dissolved in 60 ml of THF and 15 ml of water, and then, 11.2 g (30.2 mmol) of Intermediate L27-4, 2.0 g (1.8 mmol) of Pd(PPh₃)₄, and 8.7 g (63.0 mmol) of K₂CO₃ were added thereto and heated at a temperature of 70 °C for one day. Once the reaction was completed, ethylacetate and water were added thereto, followed by extraction, and an organic layer was dried using magnesium sulfate and purified through liquid chromatography, to obtain 12.0 g (yield of 70%) of Intermediate L32.
LC-MS m/z = 487(M+H)⁺

### Synthesis of Intermediate L32 Dimer

1.1 g of Intermediate L32 Dimer was obtained in the same manner as used to obtain Intermediate L1 Dimer of Synthesis Example 1, except that Intermediate L32 was used instead of Intermediate L1.

### Synthesis of Compound 32

0.1 g (yield of 10%) of Comopund 32 was obtained in the same manner as used to obtain Compound 1 of Synthesis Example 1, except that Intermediate L32 Dimer was used instead of Intermediate L1 Dimer.
LC-MS m/z = 1405(M+H)⁺

### Synthesis Example 12 (Compound 35)

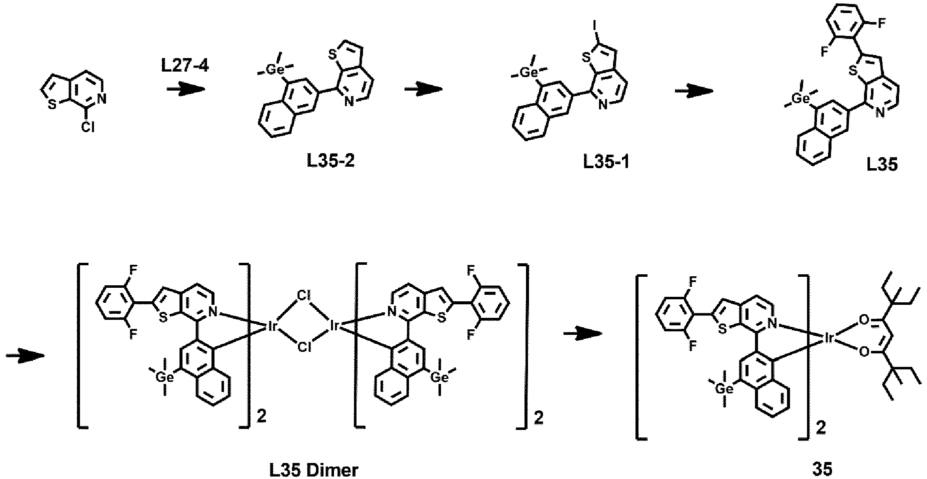

### Synthesis of Intermediate L35-2

5.2 g (yield of 68%) of Intermediate L35-2 was obtained in the same manner as used to obtain Intermediate L1 of Synthesis Example 1, except that 7-chlorothieno[2,3-c]pyridine was used instead of Intermediate L1-1 and Intermediate L27-4 was used instead of 4,4,5,5-tetramethyl-2-(4-methylnaphthalen-2-yl)-1,3,2-dioxaborolane.

### Synthesis of Intermediate L35-1

Intermediate L35-1 was obtained in the same manner as used to obtain Intermediate 32-3 of Synthesis Example 11, except that Intermediate L35-2 was used instead of 7-chlorothieno[2,3-c]pyridine and was used in the following reaction without an additional purification.

### Synthesis of Intermediate L35

6.3 g (12.6 mmol) of Intermediate L35-1 was dissolved in 80 ml of DMF, and then, 2.4 g (15.1 mmol) of 2,6-difluorophenyl boronic acid, 1.0 g (0.9 mmol) of Pd(PPh₃)₄, 3.5 g (15.1 mmol) of Ag₂O, and 6.7 g (31.5 mmol) of K₃PO₄ were added thereto and heated at a temperature of 90 °C for one day. Once the reaction was completed, dichloromethane and water were added thereto, followed by extraction, and an organic layer was dried using magnesium sulfate and purified through liquid chromatography to obtain 2.5 g (yield of 40%) of Intermediate L35.
LC-MS m/z = 492(M+H)⁺

### Synthesis of Intermediate L35 Dimer

1.5 g of Intermediate L35 Dimer was obtained in the same manner as used to obtain Intermediate L1 Dimer of Synthesis Example 1, except that Intermediate L35 was used instead of Intermediate L1.

### Synthesis of Compound 35

0.2 g (yield of 12%) of Comopund 35 was obtained in the same manner as used to obtain Compound 1 of Synthesis Example 1, except that Intermediate L35 Dimer was used instead of Intermediate L1 Dimer.
LC-MS m/z = 1275(M+H)⁺

### Synthesis Example 13 (Compound 37)

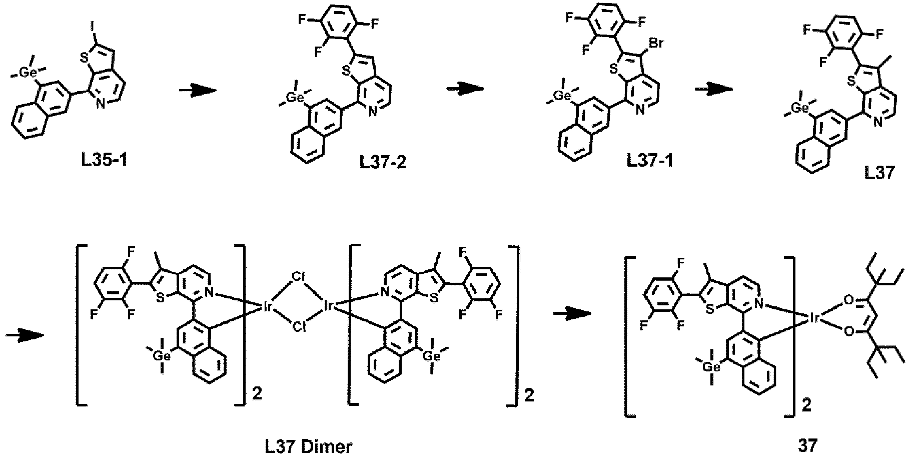

### Synthesis of Intermediate L37-2

3.3 g (yield of 45%) of Intermediate L37-2 was obtained in the same manner as used to obtain Intermediate L35 of Synthesis Example 12, except that 2,3,6-trifluorophenylboronic acid was used instead of 2,6-difluorophenyl boronic acid.
LC-MS m/z = 510(M+H)⁺

### Synthesis of Intermediate L37-1

3.0 g (5.90 mmol) of Intermediate L37-2 was dissolved in 50 ml of dichloromethane, and then, 1.2 g (7.08 mmol) of N-bromosuccinimide was added thereto and stirred at room temperature for 18 hours. Once the reaction was completed, the resultant solution was subjected to an extraction process using saturated Na₂CO₃ aqueous solution, followed by drying using magnesium sulfate and distillation under reduced pressure. The result was purified through liquid chromatography to obtain 2.8 g (yield of 80%) of Intermediate L37-1.
LC-MS m/z = 588(M+H)⁺

### Synthesis of Intermediate L37

1.3 g (2.2 mmol) of Intermediate L37-1 was dissolved in 60 ml of THF, and then, 0.03 g (0.03 mmol) of Pd₂(dba)₃ (Tris(dibenzylideneacetone)dipalladium(0)), 0.03 g (0.07 mmol) of Xphos (2-Dicyclohexylphosphino-2',4',6'-triisopropylbiphenyl), and 0.8 g (3.3 mmol)of bis(trimethylaluminum)-1,4-diazabicyclo[2.2.2]octane adduct were added thereto and refluxed while heating for 18 hours. After completion of the reaction, ice water was added thereto and stirred for about 1 hour. An organic layer obtained after extraction using ethylacetate was purified through liquid chromatography to obtain 1.0 g (yield of 86%) of Intermediate L37.
LC-MS m/z = 524(M+H)⁺

### Synthesis of Intermediate L37 Dimer

0.8 g of Intermediate L37 Dimer was obtained in the same manner as used to obtain Intermediate L1 Dimer of Synthesis Example 1, except that Intermediate L37 was used instead of Intermediate L1 and refluxing was performed while heating at 100 °C for 24 hours.

### Synthesis of Compound 37

40 mL of ethoxyethanol was mixed with Intermediate L27 Dimer (0.63 mmol), 0.9 g of 3,7-diethyl-3,7-dimethylnonane-4,6-dione (4.5 mmol), and K₂CO₃ (4.5 mmol), and the resultant was stirred for 48 hours at room temperature to cause a reaction. Once the reaction was completed, methanol was added thereto to filter the resulting solid and recrystallized using dichloromethane and methanol, and the obtained solid was purified through liquid chromatography to obtain 0.1 g (yield of 15%) of Compound 37.
LC-MS m/z = 1477(M+H)⁺

### Synthesis Example 14 (Compound 40)

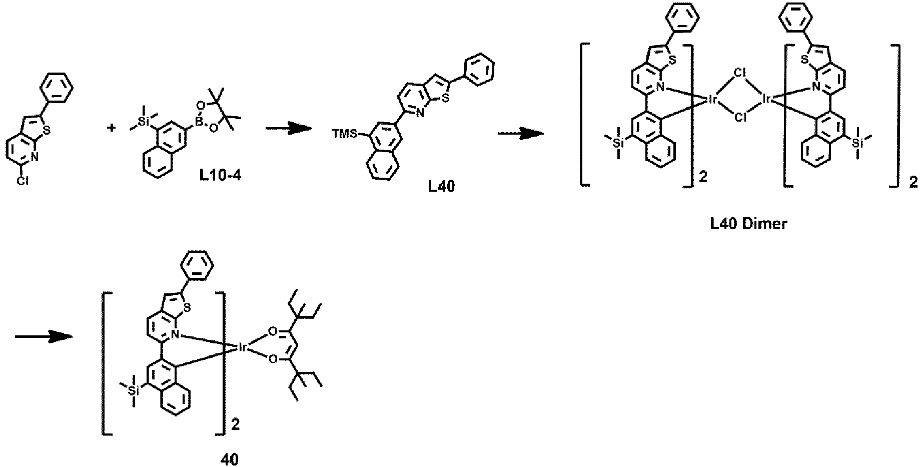

### Synthesis of Intermediate L40

1.2 g (yield of 85%) of Intermediate L40 was obtained in the same manner as used to obtain Intermediate L27 of Synthesis Example 7, except that 6-chloro-2-phenylthieno[2,3-b]pyridine was used instead of Intermediate L27-1 and Intermediate L10-4 was used instead of Intermediate L27-4.
LC-MS m/z = 410(M+H)⁺

### Synthesis of Intermediate L40 Dimer

0.9 g of Intermediate L40 Dimer was obtained in the same manner as used to obtain Intermediate L27 Dimer of Synthesis Example 7, except that Intermediate L40 was used instead of Intermediate L27.

### Synthesis of Compound 40

0.1 g (yield of 10%) of Comopund 40 was obtained in the same manner as used to obtain Compound 27 of Synthesis Example 7, except that Intermediate L40 Dimer was used instead of Intermediate L27 Dimer.
LC-MS m/z = 1275(M+H)⁺

### Synthesis Example 15 (Compound 42)

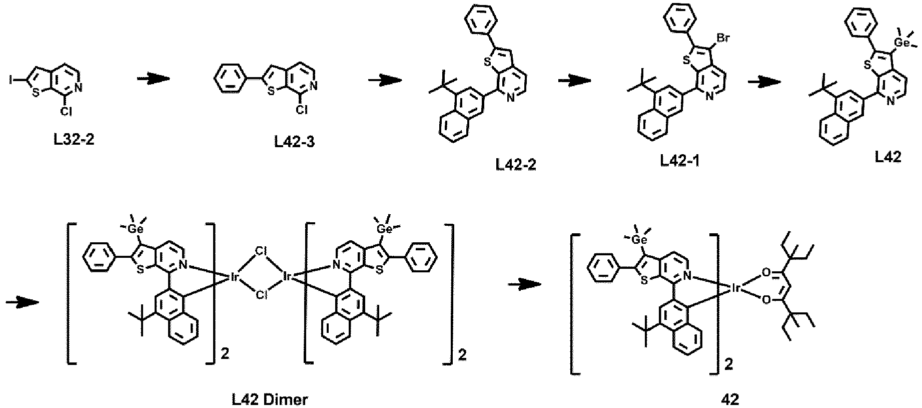

### Synthesis of Intermediate L42-3

2.7 g (yield of 60%) of Intermediate L42-3 was obtained in the same manner as used to obtain Intermediate L32-1 of Synthesis Example 11, except that phenylboronic acid was used instead of 3-fluoro-2-methylphenylboronic acid.

### Synthesis of Intermediate L42-2

1.7 g (yield of 80%) of Intermediate L42-2 was obtained in the same manner as used to obtain Intermediate L6 of Synthesis Example 2, except that Intermediate L42-3 was used instead of 4-chloro-2-phenylfuro[3,2-c]pyridine.
LC-MS m/z = 394(M+H)⁺

### Synthesis of Intermediate L42-1

1.6 g (yield of 78%) of Intermediate L42-1 was obtained in the same manner as used to obtain Intermediate L37-1 of Synthesis Example 13, except that Intermediate L42-2 was used instead of Intermediate L37-2.
LC-MS m/z = 472(M+H)⁺

### Synthesis of Intermediate L42

1.0 g (2.1 mmol) of Intermediate L42-1 was dissolved in 40 ml of anhydrous tetrahydrofuran (THF), and then, at a temperature of -78 °C, 1.5 ml (2.3 mmol) of 1.6 M BuLi solution in hexane was slowly added thereto. After about 1 hour, 0.5 g (3.1 mmol) of chlorotrimethylgermane was slowly added dropwise thereto and stirred at room temperature for 12 hours. After completion of the reaction, the organic layer, obtained by extraction using ethyl acetate and saturated Na₂CO₃ aqueous solution, was dried using magnesium sulfate and distilled under reduced pressure. The resultant was purified by liquid chromatography to obtain 0.8 g (yield 76%) of Intermediate L42.
LC-MS m/z = 512(M+H)⁺

### Synthesis of Intermediate L42 Dimer

0.6 g of Intermediate L42 Dimer was obtained in the same manner as used to obtain Intermediate L37 Dimer of Synthesis Example 13, except that Intermediate L42 was used instead of Intermediate L37.

### Synthesis of Compound 42

0.3 g (yield of 42%) of Compound 42 was obtained in the same manner as used to obtain Compound 37 of Synthesis Example 13, except that Intermediate L42 Dimer was used instead of Intermediate L37 Dimer.
LC-MS m/z = 1453(M+H)⁺

### Synthesis Example 16 (Compound 29)

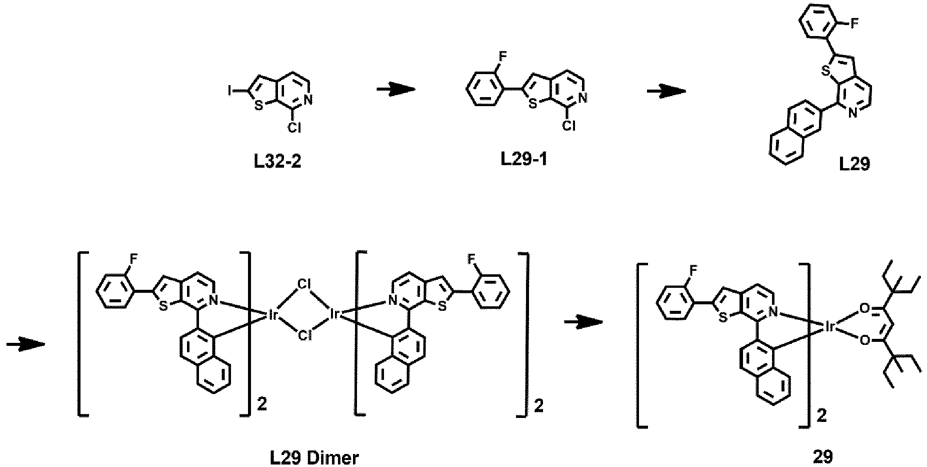

### Synthesis of Intermediate L29-1

Intermediate L29-1 was obtained in the same manner as used to obtain Intermediate 32-1 of Synthesis Example 11, except that (2-fluorophenyl)boronic acid was used instead of 3-fluoro-2-methylphenylboronic acid and was used in the following reaction without an additional purification.

### Synthesis of Intermediate L29

1.1 g (yield of 80%) of Intermediate L29 was obtained in the same manner as used to obtain Intermediate L32 of Synthesis Example 11, except that Intermediate L29-1 was used instead of Intermediate L31-1 and 4,4,5,5-tetramethyl-2-(naphthalen-2-yl)-1,3,2-dioxaborolane was used instead of Intermediate L27-4.

### Synthesis of Intermediate L29 Dimer

0.8 g of Intermediate L29 Dimer was obtained in the same manner as used to obtain Intermediate L32 Dimer of Synthesis Example 11, except that Intermediate L29 was used instead of Intermediate L32.

### Synthesis of Compound 29

50 mg (yield of 9%) of Compound 29 was obtained in the same manner as used to obtain Compound 32 of Synthesis Example 11, except that Intermediate L29 Dimer was used instead of Intermediate L32 Dimer.
LC-MS m/z = 1141(M+H)⁺

### Synthesis Example 17 (Compound 30)

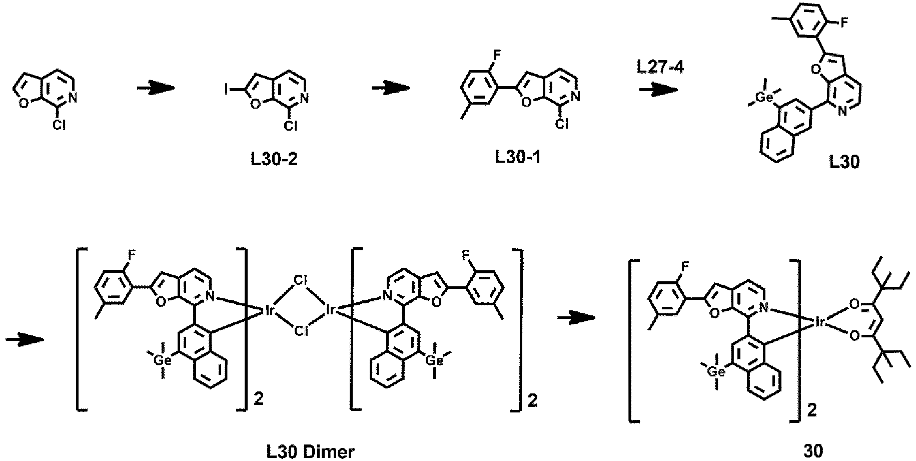

### Synthesis of Intermediate L30-2

3.1 g (yield of 87%) of Intermediate L30-2 was obtained in the same manner as used to obtain Intermediate L32-2 of Synthesis Example 11, except that 7-chlorofuro[2,3-c]pyridine was used instead of 7-chlorothieno[2,3-c]pyridine.

### Synthesis of Intermediate L30-1

Intermediate L30-1 was obtained in the same manner as used to obtain Intermediate 32-1 of Synthesis Example 11, except that Intermediate L30-2 was used instead of Intermediate L32-2 and (2-fluoro-5-methylphenyl)boronic acid was used instead of 3-fluoro-2-methylphenylboronic acid and was used in the following reaction without an additional purification.

### Synthesis of Intermediate L30

3.1 g (yield of 75%) of Intermediate L30 was obtained in the same manner as used to obtain Intermediate L32 of Synthesis Example 11, except that Intermediate L30-1 was used instead of Intermediate L32-1.

### Synthesis of Intermediate L30 Dimer

1.1 g of Intermediate L30 Dimer was obtained in the same manner as used to obtain Intermediate L32 Dimer of Synthesis Example 11, except that Intermediate L30 was used instead of Intermediate L32.

### Synthesis of Compound 30

0.2 g (yield of 25%) of Compound 30 was obtained in the same manner as used to obtain Compound 32 of Synthesis Example 11, except that Intermediate L30 Dimer was used instead of Intermediate L32 Dimer.
LC-MS m/z = 1370(M+H)⁺

### Synthesis Example 18 (Compound 33)

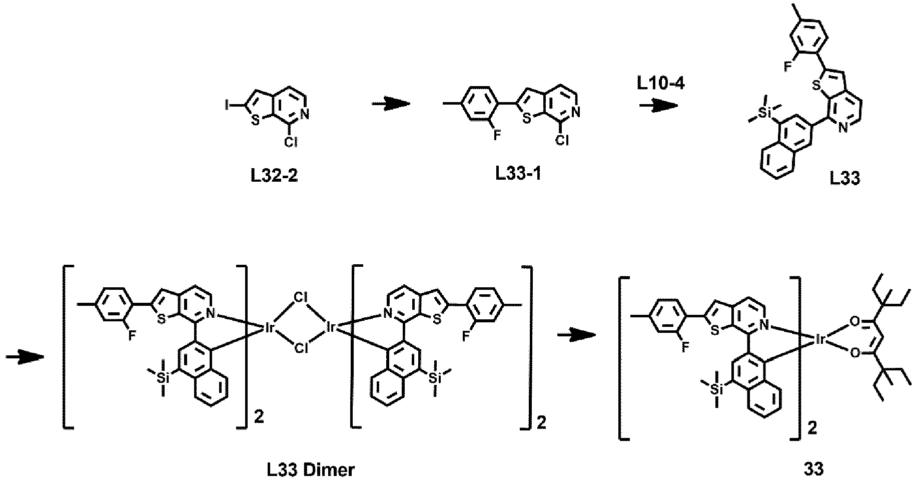

### Synthesis of Intermediate L33-1

Intermediate L33-1 was obtained in the same manner as used to obtain Intermediate 32-1 of Synthesis Example 11, except that (2-fluoro-4-methylphenyl)boronic acid was used instead of 3-fluoro-2-methylphenylboronic acid and was used in the following reaction without an additional purification.

### Synthesis of Intermediate L33

1.8 g (yield of 76%) of Intermediate L33 was obtained in the same manner as used to obtain Intermediate L32 of Synthesis Example 11, except that Intermediate L33-1 was used instead of Intermediate L32-1 and Intermediate L10-4 was used instead of Intermediate L27-4.

### Synthesis of Intermediate L33 Dimer

0.8 g of Intermediate L33 Dimer was obtained in the same manner as used to obtain Intermediate L32 Dimer of Synthesis Example 11, except that Intermediate L33 was used instead of Intermediate L32.

### Synthesis of Compound 33

0.1 g (yield of 16%) of Compound 33 was obtained in the same manner as used to obtain Compound 32 of Synthesis Example 11, except that Intermediate L33 Dimer was used instead of Intermediate L32 Dimer.
LC-MS m/z = 1313(M+H)⁺

### Synthesis Example 19 (Compound 34)

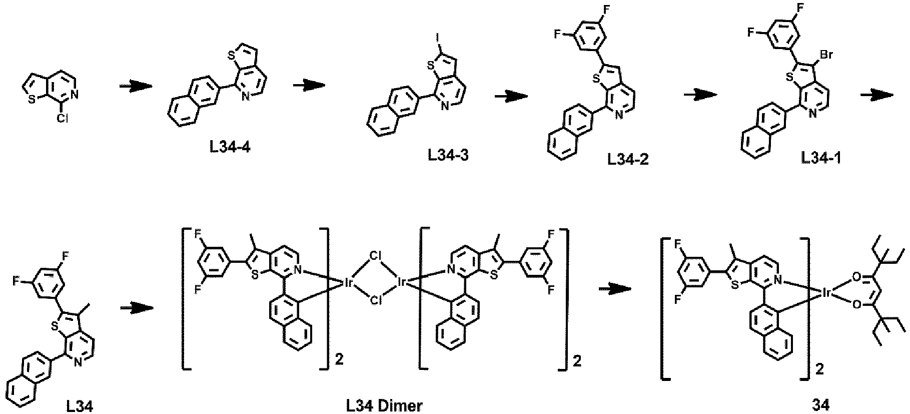

### Synthesis of Intermediate L34-4

2.4 g (yield of 70%) of Intermediate L34-4 was obtained in the same manner as used to obtain Intermediate L35-2 of Synthesis Example 12, except that naphthalen-2-ylboronic acid was used instead of Intermediate L27-4.

### Synthesis of Intermediate L34-3

3.2 g (yield of 90%) of Intermediate L34-3 was obtained in the same manner as used to obtain Intermediate L35-1 of Synthesis Example 12, except that Intermediate L34-4 was used instead of Intermediate L35-2.

### Synthesis of Intermediate L34-2

2.3 g (yield of 76%) of Intermediate L34-2 was obtained in the same manner as used to obtain Intermediate L35 of Synthesis Example 12, except that Intermediate L34-3 was used instead of Intermediate L35-1 and 3,5-Difluorophenyl boronic acid was used instead of 2,6-Difluorophenyl boronic acid.

### Synthesis of Intermediate L34-1

2.0 g (yield of 70%) of Intermediate L34-1 was obtained in the same manner as used to obtain Intermediate L37-1 of Synthesis Example 13, except that Intermediate L34-2 was used instead of Intermediate L37-2.

### Synthesis of Intermediate L34

1.4 g (yield of 82%) of Intermediate L34 was obtained in the same manner as used to obtain Intermediate L37 of Synthesis Example 13, except that Intermediate L34-1 was used instead of Intermediate L37-1.

### Synthesis of Intermediate L34 Dimer

1.3 g of Intermediate L34 Dimer was obtained in the same manner as used to obtain Intermediate L37 Dimer of Synthesis Example 13, except that Intermediate L34 was used instead of Intermediate L37.

### Synthesis of Compound 34

120 mg (yield of 9%) of Compound 34 was obtained in the same manner as used to obtain Compound 37 of Synthesis Example 13, except that Intermediate L34 Dimer was used instead of Intermediate L37 Dimer.
LC-MS m/z = 1205(M+H)⁺

### Synthesis Example 20 (Compound 38)

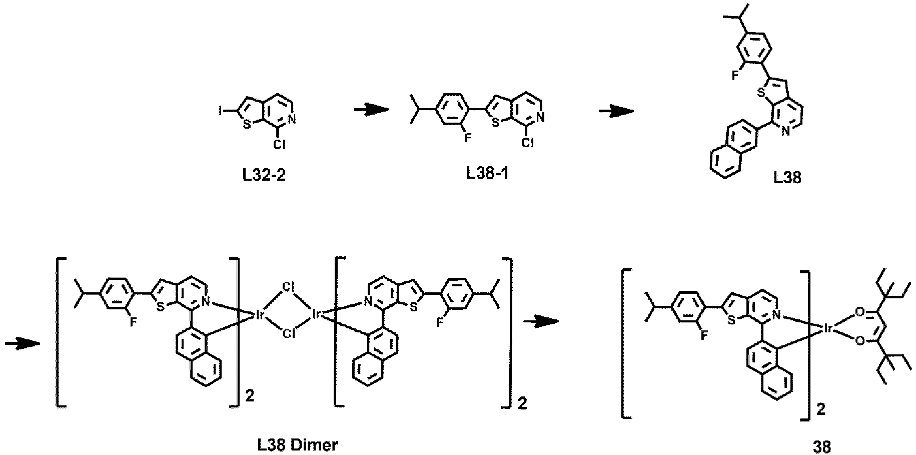

### Synthesis of Intermediate L38-1

Intermediate L38-1 was obtained in the same manner as used to obtain Intermediate 32-1 of Synthesis Example 11, except that (2-fluoro-4-isopropylphenyl)boronic acid was used instead of 3-fluoro-2-methylphenylboronic acid and was used in the following reaction without an additional purification.

### Synthesis of Intermediate L38

2.8 g (yield of 78%) of Intermediate L38 was obtained in the same manner as used to obtain Intermediate L32 of Synthesis Example 11, except that Intermediate L38-1 was used instead of Intermediate L32-1 and 4,4,5,5-tetramethyl-2-(naphthalen-2-yl)-1,3,2-dioxaborolane was used instead of Intermediate L27-4.

### Synthesis of Intermediate L33 Dimer

1.6 g of Intermediate L38 Dimer was obtained in the same manner as used to obtain Intermediate L32 Dimer of Synthesis Example 11, except that Intermediate L38 was used instead of Intermediate L32.

### Synthesis of Compound 38

0.1 g (yield of 7%) of Compound 38 was obtained in the same manner as used to obtain Compound 32 of Synthesis Example 11, except that Intermediate L38 Dimer was used instead of Intermediate L32 Dimer.
LC-MS m/z = 1226(M+H)⁺

### Synthesis Example 21 (Compound 46)

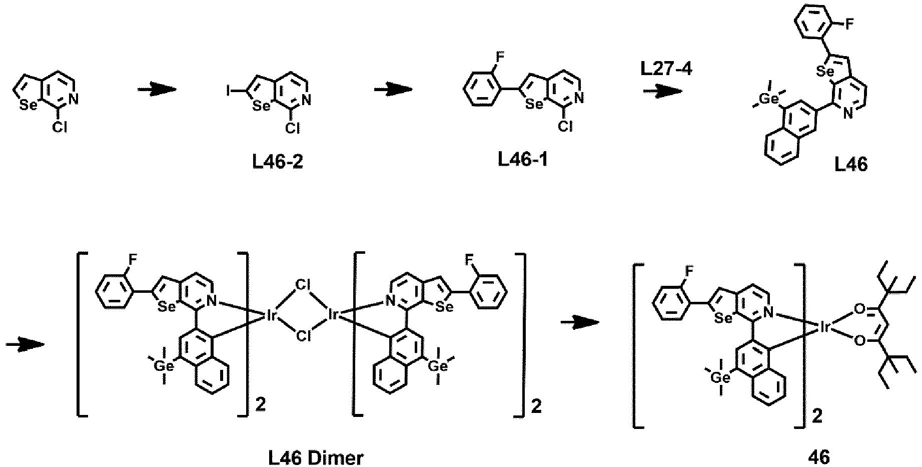

### Synthesis of Intermediate L46-2

4.6 g (yield of 62%) of Intermediate L46-2 was obtained in the same manner as used to obtain Intermediate L32-2 of Synthesis Example 11, except that 7-chloroselenopheno[2,3-c]pyridine was used instead of 7-chlorothieno[2,3-c]pyridine.

### Synthesis of Intermediate L46-1

Intermediate L46-1 was obtained in the same manner as used to obtain Intermediate 32-1 of Synthesis Example 11, except that Intermediate L46-2 was used instead of Intermediate L32-2 and 2-fluorophenyl boronic acid was used instead of 3-fluoro-2-methylphenylboronic acid and was used in the following reaction without an additional purification.

### Synthesis of Intermediate L46

3.1 g (yield of 63%) of Intermediate L46 was obtained in the same manner as used to obtain Intermediate L32 of Synthesis Example 11, except that Intermediate L46-1 was used instead of Intermediate L32-1.

### Synthesis of Intermediate L46 Dimer

1.0 g of Intermediate L46 Dimer was obtained in the same manner as used to obtain Intermediate L32 Dimer of Synthesis Example 11, except that Intermediate L46 was used instead of Intermediate L32.

### Synthesis of Compound 46

0.2 g (yield of 36%) of Compound 46 was obtained in the same manner as used to obtain Compound 32 of Synthesis Example 11, except that Intermediate L46 Dimer was used instead of Intermediate L32 Dimer.
LC-MS m/z = 1469(M+H)⁺

### Evaluation Example 1: Evaluation of photoluminescence quantum yields (PLQY)

Compound H52 and Compound 1 were co-deposited at a vacuum of 1.33 x 10⁻⁵ Pa (10⁻⁷ torr) at a weight ratio of 98:2 to produce a film with a thickness of 40 nm.

The PLQY of Compound 1 in film was evaluated by using a Hamamatsu Photonics absolute PL quantum yield measurement system equipped with a xenon light source, a monochromator, a photonic multichannel analyzer, and an integrating sphere, and using PLQY measurement software (Hamamatsu Photonics, Ltd., Shizuoka, Japan). Results thereof are shown in Table 2.

The PLQY measurements were performed on Compounds 6, 10, 11, 13, 16, 23, 24, 26, 27, 29, 30, 32, 33, 34, 35, 38, 42, 46, A1, A2, B1, and B2, respectively, and results thereof are shown in Table 2.

**Table 2**

| Compound No. | PLQY in film (%) |
|---|---|
| 1 | 99 |
| 6 | 98 |
| 10 | 98 |
| 11 | 99 |
| 13 | 99 |
| 16 | 98 |
| 23 | 98 |
| 24 | 99 |
| 26 | 98 |
| 27 | 97 |
| 29 | 98 |
| 30 | 99 |
| 32 | 98 |
| 33 | 98 |
| 34 | 96 |
| 35 | 97 |
| 38 | 98 |
| 42 | 97 |
| 46 | 98 |
| A1 | 87 |
| A2 | 93 |
| B1 | 92 |
| B2 | 81 |

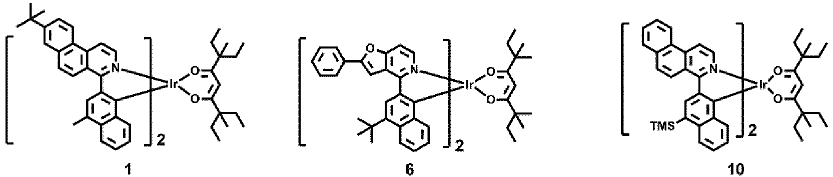

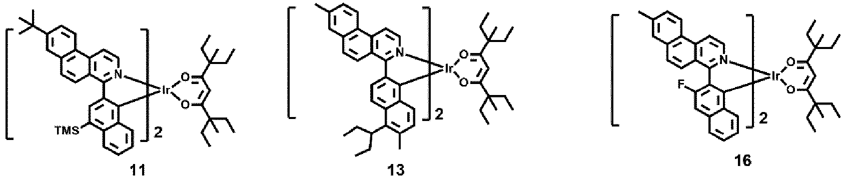

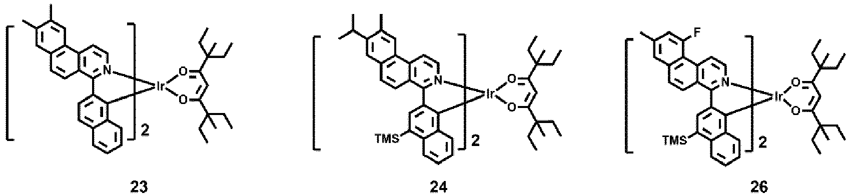

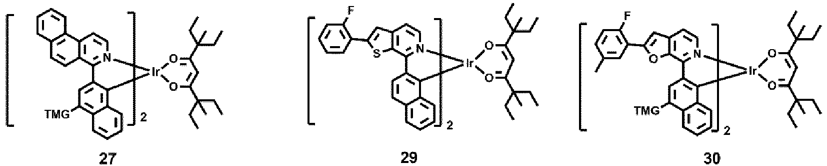

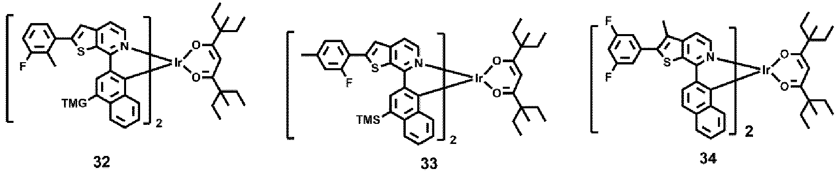

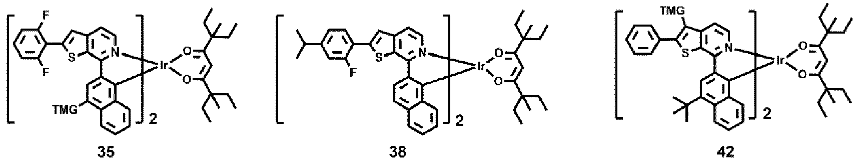

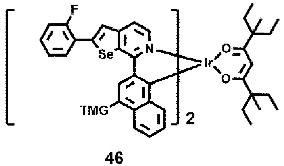

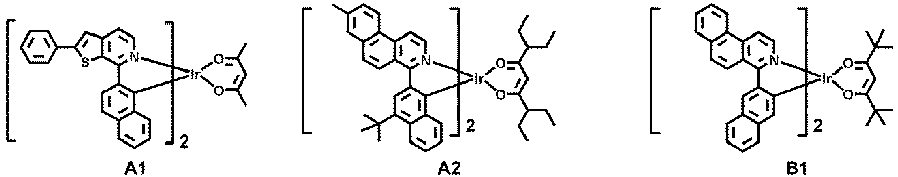

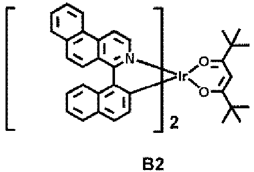

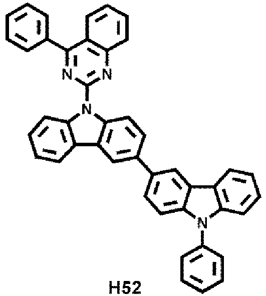

From Table 2, it can be seen that Compounds 1, 6, 10, 11, 13, 16, 23, 24, 26, 27, 29, 30, 32, 33, 34, 35, 38, 42 and 46 have superior PLQY characteristics compared to Compounds A1, A2, B1, and B2.

### Evaluation Example 2: Evaluation of horizontal orientation ratio (optical orientation ratio)

In a vacuum deposition apparatus having a vacuum degree of 1.33 x 10⁻⁵ Pa (1×10⁻⁷ torr), Compound H52 and Compound 1 were co-deposited at a weight ratio of 98 : 2 on a fused silica layer (thickness: 1 mm) to form a film having a thickness of 40 nm, and then sealed with glass and glue under a nitrogen atmosphere.

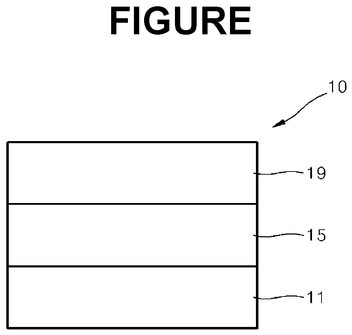

Meanwhile, an angle-dependent PL measurement apparatus having the same structure as that shown in FIG. 3 of Korean Patent Application Publication No. 2013-0150834 was prepared. Detailed specifications are as follows:
- Excitation-light wavelength: 325 nm
- Source of excitation-light: He-Cd laser of Melles Griot Inc.
- Excitation-light irradiation member: optical fiber having a diameter of 1 mm of Thorlabs Inc.
- Semi-cylindrical prism: a fused silica having a diameter of 100 mm and a length of 30 mm
- Emitted-light detection member: photomultiplier tube of Acton Inc.
- Polarizer mounted on emitted-light detection member: linear polarizer of Thorlabs Inc.
- Recoder: SpectraSense of Acton Inc.
- Incidence angle of excitation light: θP = 45°, θH = 0°
- Distance from a sample to the emitted-light detection member (or a radius of a movement path of the emitted-light detection member): 900 mm

Subsequently, the film was fixed on a semi-cylindrical lens and irradiated with 325 nm laser to emit light. The emitted light passed through a polarization film, and then, in order to measure a p-polarized photoluminescence intensity with respect to light in a Max wavelength of a spectrum in a range of 90 degree to 0 degree, the semi-cylindrical lens, on which the sample was fixed, was rotated by 1 degree with respect to an axis of the semi-cylindrical lens by using a charge-coupled device (CCD).

The p-polarized photoluminescence intensity (a first p-polarized photoluminescence intensity) in a case where each compound is vertically aligned and the p-polarized photoluminescence intensity (a second p-polarized photoluminescence intensity) in a case where each compound is horizontally aligned were respectively calculated within a range of 0 degree to 90 degrees. The p-polarized photoluminescence intensity obtained by multiplying the first p-polarized photoluminescence intensity and the second p-polarized photoluminescence intensity respectively by a weight value was obtained to obtain a weight value corresponding to the measured p-polarization photoluminescence intensity. Then, the horizontal orientation ratio of each compound shown in Table 3 was measured and results thereof are shown in Table 3. Here, the angle-dependent photoluminescence spectrum was analyzed using a classical dipole model which regards light emitted from excitons as dissipated power from an oscillating dipole, and the horizontal orientation ratio for Compound 1 was evaluated.

This measurement was performed on each of Compounds 6, 11, 13, 16, 23, 26, 27, 29, 32, 35, 40, 42, A1, A2, B1 and B2, respectively, and results are shown in Table 3.

**[Table 3]**

| Co-deposition materials | Horizontal orientation ratio (optical orientation ratio) (%) |
|---|---|
| H52 : Compound 1(2wt%) | 94 |
| H52 : Compound 6(2wt%) | 95 |
| H52 : Compound 11(2wt%) | 94 |
| H52 : Compound 13(2wt%) | 94 |
| H52 : Compound 16(2wt%) | 93 |
| H52 : Compound 23(2wt%) | 92 |
| H52 : Compound 26(2wt%) | 91 |
| H52 : Compound 27(2wt%) | 91 |
| H52 : Compound 29(2wt%) | 92 |
| H52 : Compound 32(2wt%) | 93 |
| H52 : Compound 35(2wt%) | 93 |
| H52 : Compound 40(2wt%) | 88 |
| H52 : Compound 42(2wt%) | 90 |
| H52 : Compound A1(2wt%) | 88 |
| H52 : Compound A2(2wt%) | 88 |
| H52 : Compound B1(2wt%) | 88 |
| H52 : Compound B2(2wt%) | 85 |

From Table 3, it can be seen that Compounds 1, 6, 11, 13, 16, 23, 26, 27, 29, 32, 35, 40 and 42 have superior horizontal orientation ratio characteristics compared to Compounds A1, A2, B1, and B2.

### Example 1

As an anode, an ITO-patterned glass substrate was cut to a size of 50 mm x 50 mm x 0.5 mm, sonicated with isopropyl alcohol, and pure water each for 5 minutes, and then cleaned by exposure to ultraviolet rays and ozone for 30 minutes. Then, the ITO-patterned glass substrate was provided to a vacuum deposition apparatus.

HT3 and F6-TCNNQ were vacuum-co deposited on the ITO anode at the weight ratio of 98 : 2 to form a hole injection layer having a thickness of 100 Å, and HT3 was vacuum-deposited on the hole injection layer to form a hole transport layer having a thickness of 1350 Å, and then, HT21 was vacuum-deposited on the hole transport layer to form an electron blocking layer having a thickness of 300 Å.

Then, H52 (host) and Compound 1 (dopant) were co-deposited at the weight ratio of 98 : 2 on the electron blocking layer to form an emission layer having a thickness of 400 Å.

Thereafter, ET3 and ET-D1 were co-deposited at a volume ratio of 50 : 50 on the emission layer to form an electron transport layer having a thickness of 350 Å, ET-D1 was vacuum-deposited on the electron transport layer to form an electron injection layer having a thickness of 10 Å, and Al was vacuum-deposited on the electron injection layer to form a cathode having a thickness of 1,000 Å, thereby completing the manufacture of an organic light-emitting device having a structure of ITO (1,500 Å)/HT3+F6TCNNQ (2 wt%) (100 Å)/HT3 (1350 Å)/HT21 (300 Å)/H52 + Compound 1 (2 wt%) (400 Å)/ET3+ET-D1 (50 %) (350 Å)/ET-D1 (10 Å)/Al (1,000 Å).

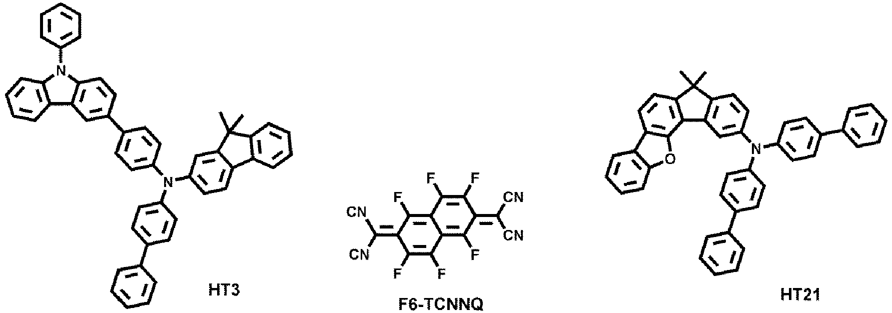

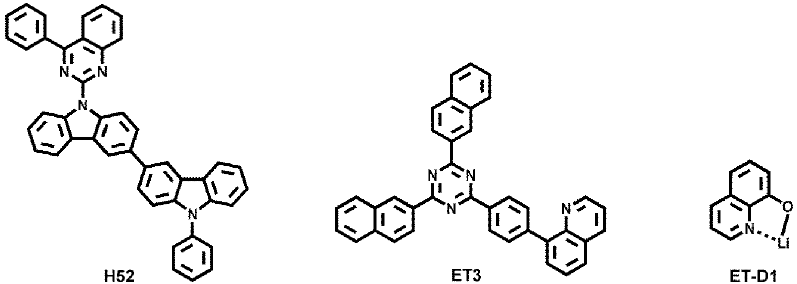

### Examples 2 to 14 and Comparative Examples A1, A2, B1, and B2

Organic light-emitting devices were manufactured in the same manner as in Example 1, except that Compounds shown in Table 4 were each used instead of Compound 1 as a dopant in forming an emission layer.

### Evaluation Example 3: Evaluation of device characteristics

The driving voltage (V), current density(mA/cm²), maximum value of external quantum efficiency (Max EQE)(%), FWHM of an emission peak of electroluminescent (EL) spectrum (FWHM, nm), and maximum emission wavelength, and lifespan (LT₉₇) of the organic light-emitting devices manufactured according to Examples 1 to 14 and Comparative Examples A1, A2, B1, and B2 were evaluated. Results thereof are shown in Table 4. As an evaluation device, a current-voltmeter (Keithley 2400) and a luminance meter (Minolta Cs-1000A) were used, and the lifespan (LT₉₇) (at 3500 nit (1 nit = 1 cd/m2)) was evaluated as the time taken for luminance to reduce to 97% of 100% of the initial luminance.

**Table 4**

| | Compound No. as a dopant in emission layer | Driving Voltage (V) | Current density (mA/cm²) | Max EQE (%) (relative value, %) | FWHM (nm) | Maximum emission wavelength (nm) | LT₉₇ (at 3500 nit) (Relative value, %) |
|---|---|---|---|---|---|---|---|
| Example 1 | 1 | 4.0 | 10 | 27 | 37 | 641 | 140 |
| Example 2 | 6 | 4.0 | 10 | 28 | 36 | 632 | 125 |
| Example 3 | 11 | 3.8 | 10 | 29 | 38 | 628 | 150 |
| Example 4 | 13 | 3.9 | 10 | 29 | 39 | 628 | 180 |
| Example 5 | 16 | 4.0 | 10 | 30 | 38 | 623 | 170 |
| Example 6 | 23 | 3.8 | 10 | 31 | 38 | 627 | 250 |
| Example 7 | 26 | 3.8 | 10 | 31 | 37 | 625 | 220 |
| Example 8 | 27 | 3.9 | 10 | 29 | 36 | 628 | 250 |
| Example 9 | 29 | 3.4 | 10 | 32 | 35 | 623 | >200 |
| Example 10 | 32 | 3.5 | 10 | 33 | 34 | 626 | >200 |
| Example 11 | 35 | 3.5 | 10 | 32 | 35 | 623 | >250 |
| Example 12 | 37 | 3.6 | 10 | 31 | 36 | 621 | 150 |
| Example 13 | 40 | 3.7 | 10 | 29 | 41 | 625 | 120 |
| Example 14 | 42 | 3.7 | 10 | 28 | 43 | 622 | 110 |
| Comparative Example A1 | A1 | 4.0 | 10 | 25 | 40 | 635 | 100 |
| Comparative Example A2 | A2 | 4.0 | 10 | 25 | 43 | 635 | 100 |
| Comparative Example B1 | B1 | 4.1 | 10 | 27 | 51 | 623 | 90 |
| Comparative Example B2 | B2 | 4.3 | 10 | 25 | 65 | 645 | 75 |

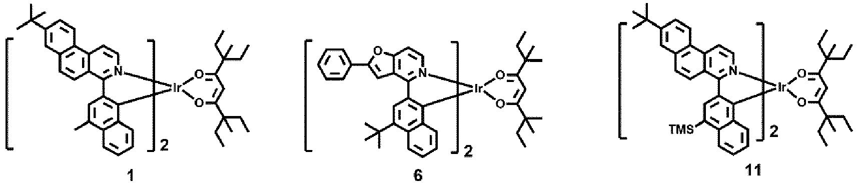

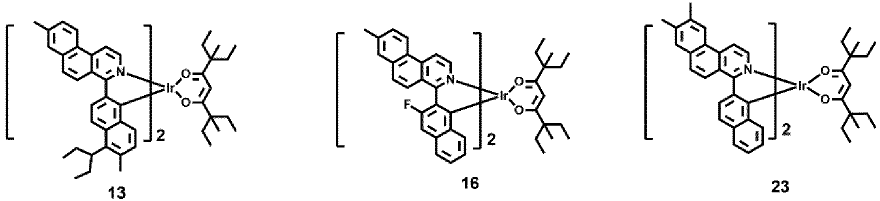

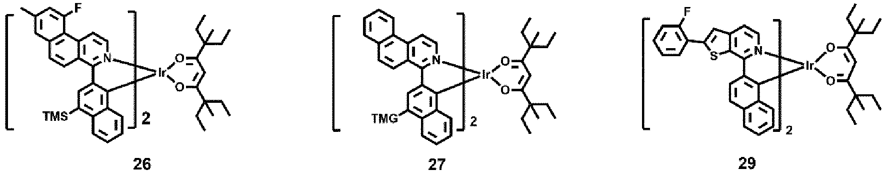

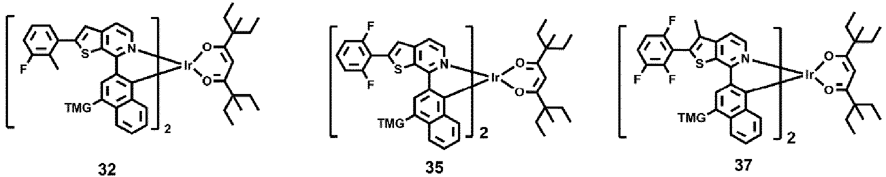

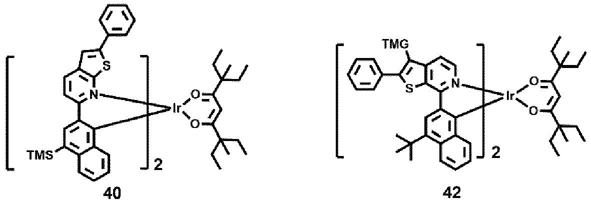

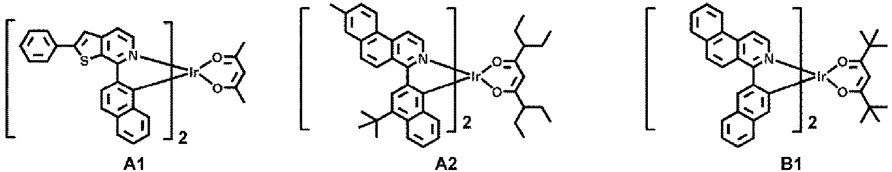

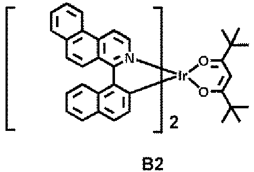

From Table 4, it was confirmed that the organic light-emitting devices of Examples 1 to 14 have improved driving voltage, improved external quantum efficiency and improved lifespan characteristics compared to the organic light-emitting devices of Comparative Examples A1, A2, B1 and B2. The organic light-emitting devices of Examples 1 to 5 may emit light having a relatively small FWHM.

The organometallic compounds as described above have excellent electrical characteristics. Accordingly, an electronic device, for example, an organic light-emitting device, using the organometallic compounds may have improved driving voltage, improved external quantum efficiency, and improved lifespan characteristics, and may emit light having a relatively small FWHM.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. An organometallic compound represented by Formula 1: 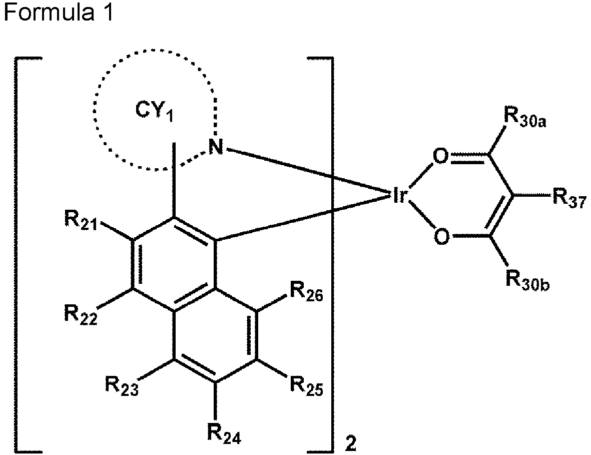
wherein, regarding Formula 1, ring CY₁ is a group represented by one of Formulae CY1-1 to CY1-9, 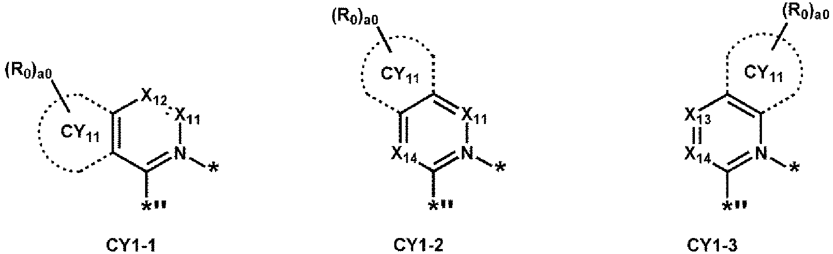 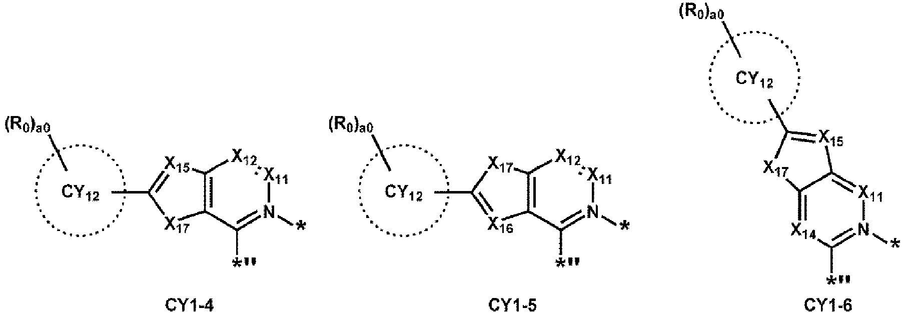 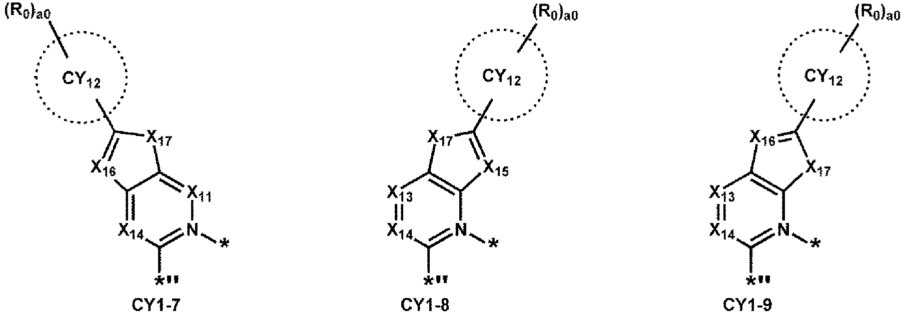
* in Formula CY1-1 to CY1-9 indicates a binding site to Ir in Formula 1, and *" indicates a binding site to a neighboring carbon atom,
ring CY₁₁ in Formula CY1-1 to CY1-3 is a polycyclic group in which two or more cyclic groups are condensed with each other,
the cyclic groups and ring CY₁₂ in Formulae CY1-4 to CY1-9 are each a Cs-C₃₀ carbocyclic group or a C₁-C₃₀ heterocyclic group,
in Formulae CY1-1 to CY1-9, X₁₁ is C(R₁₁) or N, X₁₂ is C(R₁₂) or N, X₁₃ is C(R₁₃) or N, X₁₄ is C(R₁₄) or N, X₁₅ is C(R₁₅) or N, X₁₆ is C(R₁₆) or N, and X₁₇ is O, S, N(R₁₇), C(R₁₈)(R₁₉) or Si(R₁₈)(R₁₉),
R₃₀ₐ is a group represented by *-C(R₃₁)(R₃₂)(R₃₃), a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
R_{30b} is a group represented by *-C(R₃₄)(R₃₅)(R₃₆),
R₀, R₁₁ to R₁₉, R₂₁ to R₂₆, and R₃₁ to R₃₆ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, -N(Q₁)(Q₂), -Si(Q₃)(Q₄)(Q₅), -Ge(Q₃)(Q₄)(Q₅), -B(Q₆)(Q₇), -P(=O)(Q₈)(Q₉), or - P(Q₈)(Q₉), and each of R₃₁ to R₃₆ is not hydrogen,
R₃₇ is hydrogen, deuterium, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
a0 is an integer from 0 to 20,
two or more of a plurality of R₀ are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of R₁₁ to R₁₉ are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of R₁₁ to R₁₉ and R₀ are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of R₂₁ to R₂₆ are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
two or more of R₃₀ₐ, R_{30b}, and R₃₇ are optionally linked to form a C₅-C₃₀ carbocyclic group that is unsubstituted or substituted with at least one R₁₀ₐ or a C₁-C₃₀ heterocyclic group that is unsubstituted or substituted with at least one R₁₀ₐ,
R₁₀ₐ is the same as described in connection with R₀, and
the substituents of the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀heterocycloalkenyl group, the substituted C₆-C₆₀ aryl group, the substituted C₆-C₆₀ aryloxy group, the substituted C₆-C₆₀ arylthio group, the substituted C₁-C₆₀ heteroaryl group, the substituted monovalent non-aromatic condensed polycyclic group, and the substituted monovalent non-aromatic condensed heteropolycyclic group are each independently:
deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, or a C₁-C₆₀ alkoxy group;
a C₁-C₆₀ alkyl group, a C₂-C₆₀ alkenyl group, a C₂-C₆₀ alkynyl group, or a C₁-C₆₀ alkoxy group, each substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), -P(=O)(Q₁₈)(Q₁₉), - P(Q₁₈)(Q₁₉), or any combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, or a monovalent non-aromatic condensed heteropolycyclic group, each unsubstituted or substituted with deuterium, -F, -Cl, -Br, -I, -CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₃-C₁₀ cycloalkyl group, a C₁-C₁₀ heterocycloalkyl group, a C₃-C₁₀ cycloalkenyl group, a C₁-C₁₀heterocycloalkenyl group, a C₆-C₆₀ aryl group, a C₆-C₆₀ aryloxy group, a C₆-C₆₀ arylthio group, a C₁-C₆₀ heteroaryl group, a monovalent non-aromatic condensed polycyclic group, a monovalent non-aromatic condensed heteropolycyclic group, -N(Q₂₁)(Q₂₂), -Si(Q₂₃)(Q₂₄)(Q₂₅), -Ge(Q₂₃)(Q₂₄)(Q₂₅),-B(Q₂₆)(Q₂₇), -P(=O)(Q₂₈)(Q₂₉), -P(Q₂₈)(Q₂₉), or any combination thereof;
-N(Q₃₁)(Q₃₂), -Si(Q33)(Q34)(Q35), -Ge(Q₃₃)(Q₃₄)(Q₃₅), -B(Q₃₆)(Q₃₇),-P(=O)(Q₃₈)(Q₃₉), or -P(Q₃₈)(Q₃₉); or
any combination thereof,
wherein Q₁ to Q₉, Q₁₁ to Q₁₉, Q₂₁ to Q₂₉, and Q₃₁ to Q₃₉ are each independently: hydrogen; deuterium; -F; -Cl; -Br; -I; a hydroxyl group; a cyano group; a nitro group; an amidino group; a hydrazine group; a hydrazone group; a carboxylic acid group or a salt thereof; a sulfonic acid group or a salt thereof; a phosphoric acid group or a salt thereof; a C₁-C₆₀ alkyl group which is unsubstituted or substituted with deuterium, a C₁-C₆₀ alkyl group, a C₆-C₆₀ aryl group, or any combination thereof; a C₂-C₆₀ alkenyl group; a C₂-C₆₀ alkynyl group; a C₁-C₆₀ alkoxy group; a C₃-C₁₀ cycloalkyl group; a C₁-C₁₀ heterocycloalkyl group; a C₃-C₁₀ cycloalkenyl group; a C₁-C₁₀ heterocycloalkenyl group; a C₆-C₆₀ aryl group which is unsubstituted or substituted with deuterium, a C₁-C₆₀ alkyl group, a C₆-C₆₀ aryl group, or any combination thereof; a C₆-C₆₀ aryloxy group; a C₆-C₆₀ arylthio group; a C₁-C₆₀ heteroaryl group; a monovalent non-aromatic condensed polycyclic group; or a monovalent non-aromatic condensed heteropolycyclic group.

2. The organometallic compound of claim 1, wherein ring CY₁₁ in Formulae CY1-1 to CY1-3 is a) a condensed cyclic group in which two or more first rings are condensed with each other, b) a condensed cyclic group in which two or more second rings are condensed with each other, or c) a condensed cyclic group in which at least one first ring is condensed with at least one second ring,
ring CY₁₂ in Formulae CY1-4 to CY1-9 is i) a first ring, ii) a second ring, iii) a condensed cyclic group in which two or more first rings are condensed with each other, iv) a condensed cyclic group in which two or more second rings are condensed with each other, or v) a condensed cyclic group in which at least one first ring is condensed with at least one second ring,
the first ring is a cyclopentane group, a cyclopentene group, a furan group, a thiophene group, a pyrrole group, a silole group, a germole group, a borole group, a selenophene group, a phosphole group, an oxazole group, an oxadiazole group, an oxatriazole group, a thiazole group, a thiadiazole group, a thiatriazole group, a pyrazole group, an imidazole group, a triazole group, a tetrazole group, an azasilole group, an azagermole group, an azaborole group, an azaselenophene group, or an azaphosphole group, and
the second ring is an adamantane group, a norbornane group, a norbornene group, a bicyclo[1.1.1]pentane group, a bicyclo[2.1.1]hexane group, a bicyclo[2.2.2]octane group, a cyclohexane group, a cyclohexene group, a benzene group, a pyridine group, a pyrimidine group, a pyrazine group, a pyridazine group, or a triazine group.

3. The organometallic compound of claims 1 or 2, wherein R₀, R₁₁ to R₁₉, R₂₁ to R₂₆, R₃₁ to R₃₃, and R_{30b} are each independently:
hydrogen, deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or
-Si(Q₃)(Q₄)(Q₅), or -Ge(Q₃)(Q₄)(Q₆);
wherein each of R₃₁ to R₃₃ is not hydrogen.

4. The organometallic compound of any of claims 1-3, wherein at least one of R₂₁ to R₂₆ is not hydrogen.

5. The organometallic compound of any of claims 1-4, wherein at least one of R₂₁ to R₂₆ is :
deuterium, -F, or a cyano group;
a C₁-C₂₀ alkyl group unsubstituted or substituted with deuterium, -F, a cyano group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof;
a C₃-C₁₀ cycloalkyl group, a C₁-C₁₀ heterocycloalkyl group, a phenyl group, a biphenyl group, a naphthyl group, a pyridinyl group, a fluorenyl group, a carbazolyl group, a dibenzofuranyl group, or a bibenzothiophenyl group, unsubstituted or substituted with deuterium, -F, a cyano group, a C₁-C₂₀ alkyl group, a deuterated C₁-C₂₀ alkyl group, a C₁-C₂₀ fluorinated alkyl group, a C₁-C₂₀ alkoxy group, a deuterated C₁-C₂₀ alkoxy group, a C₁-C₂₀ fluorinated alkoxy group, a C₃-C₁₀ cycloalkyl group, a deuterated C₃-C₁₀ cycloalkyl group, a fluorinated C₃-C₁₀ cycloalkyl group, a (C₁-C₂₀ alkyl)C₃-C₁₀ cycloalkyl group, a C₁-C₁₀ heterocycloalkyl group, a deuterated C₁-C₁₀ heterocycloalkyl group, a fluorinated C₁-C₁₀ heterocycloalkyl group, a (C₁-C₂₀ alkyl)C₁-C₁₀ heterocycloalkyl group, a phenyl group, a deuterated phenyl group, a fluorinated phenyl group, a (C₁-C₂₀ alkyl)phenyl group, a biphenyl group, a deuterated biphenyl group, a fluorinated biphenyl group, a (C₁-C₂₀ alkyl)biphenyl group, a dibenzofuranyl group, a deuterated dibenzofuranyl group, a fluorinated dibenzofuranyl group, a (C₁-C₂₀ alkyl)dibenzofuranyl group, a dibenzothiophenyl group, a deuterated dibenzothiophenyl group, a fluorinated dibenzothiophenyl group, a (C₁-C₂₀ alkyl)dibenzothiophenyl group, or any combination thereof; or -Si(Q₃)(Q₄)(Q₅), or -Ge(Q₃)(Q₄)(Q₅).

6. The organometallic compound of any of claims 1-5, wherein ring CY₁ is a group represented by one of Formulae CY1-1 to CY1-3, and
at least one of R₀(s) in the number of a0 in Formulae CY1-1 to CY1-3 is each independently deuterium, -F, a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group; or
wherein ring CY₁ is a group represented by one of Formulae CY1-1 to CY1-3, and at least one of R₂₃ to R₂₆ is not hydrogen.

7. The organometallic compound of any of claims 1-6, wherein a group represented by one of Formulae CY1-1 to CY1-3 is a group represented by one of Formulae CY1(1) to CY1(15): 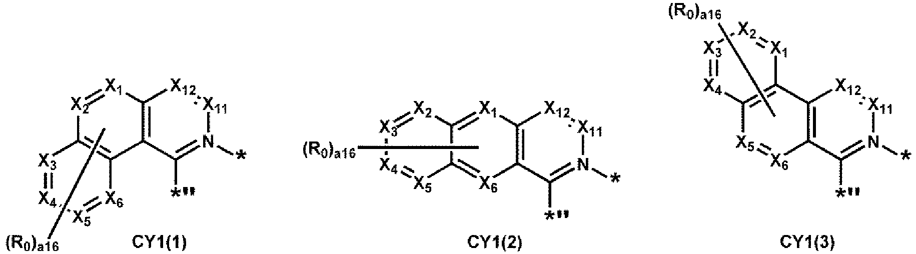 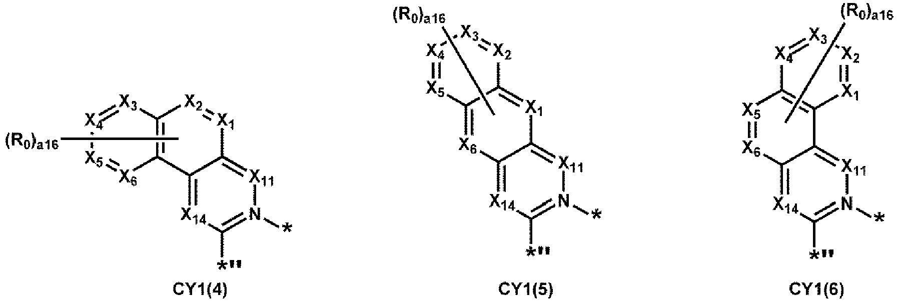 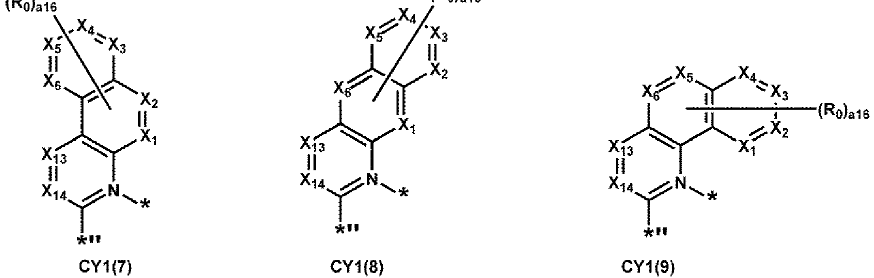 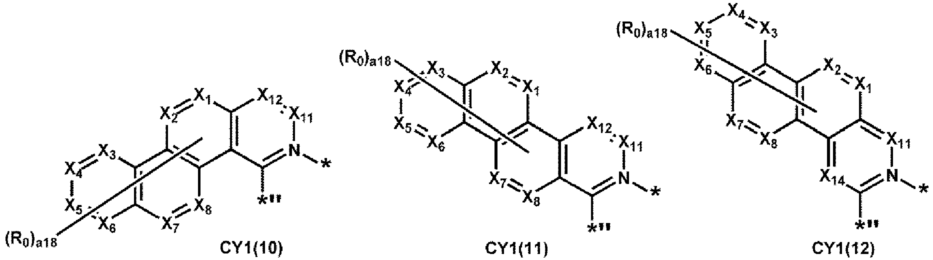 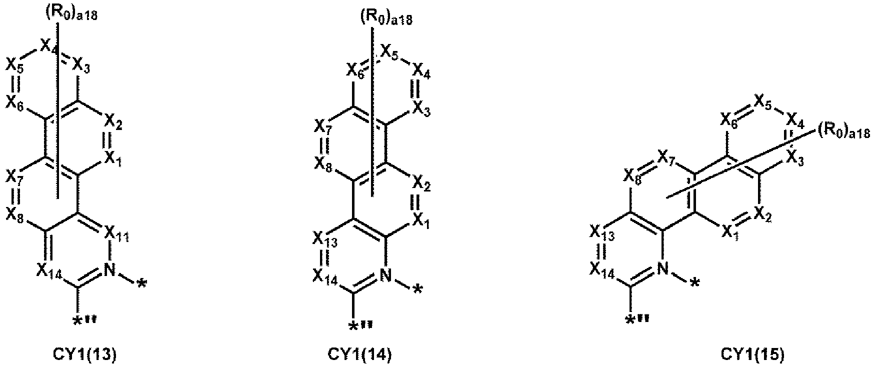 wherein, in Formulae CY1(1) to CY1(15),
X₁₁ to X₁₄ and R₀ are the same as described in claim 1,
X₁ to X₈ are each independently C or N, at least one of X₁ to X₆ of Formulae CY1(1) to CY1(9) is C, and at least one of X₁ to X₈ of Formulae CY1(10) to CY1(15) is C,
a16 is an integer from 0 to 6,
a18 is an integer from 0 to 8,
* is a binding site to Ir in Formula 1, and
*" is a binding site to a neighboring carbon atom in Formula 1; and/or
wherein a group represented by 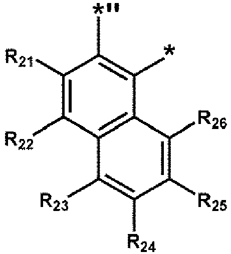 in Formula 1 is a group represented by one of Formulae CY2-1 to CY2-59: 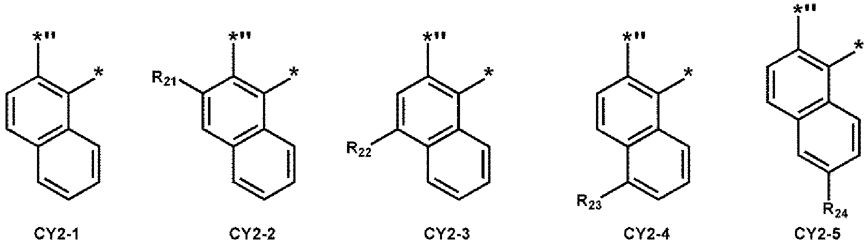 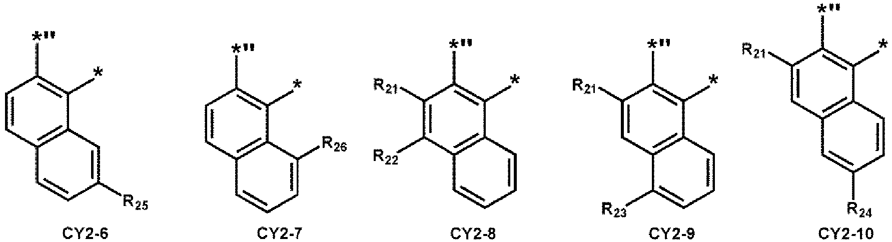 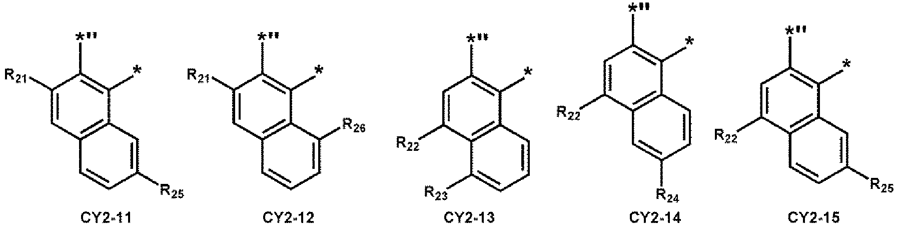 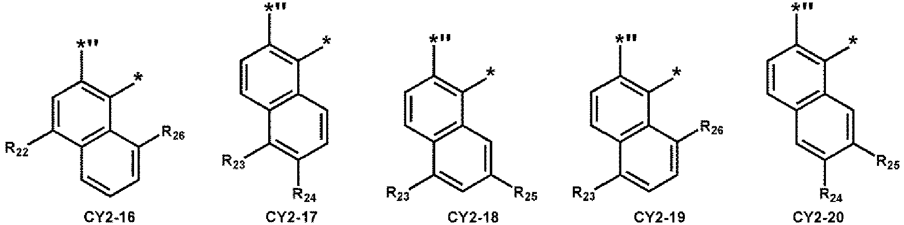 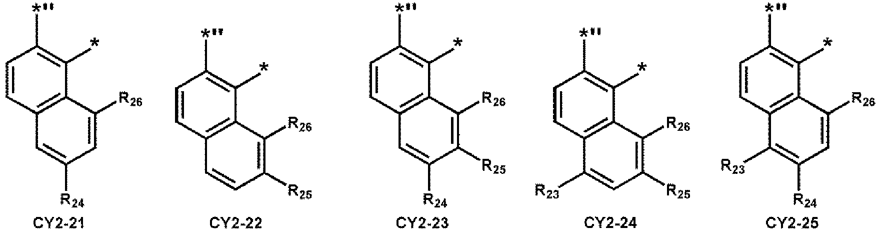 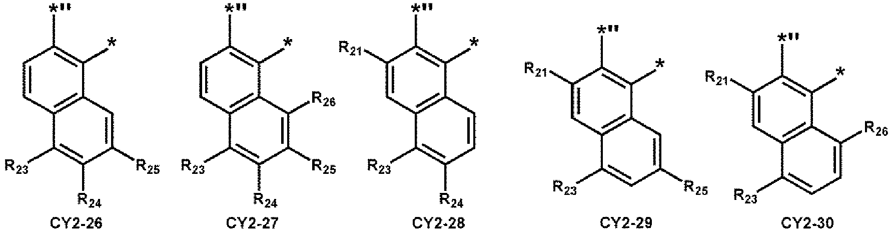 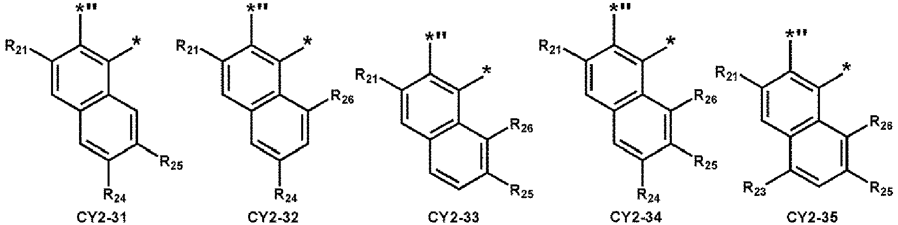 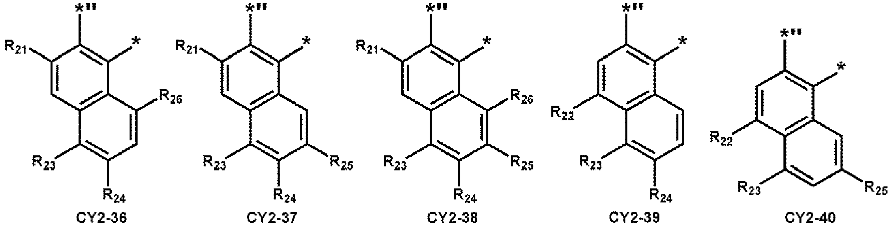 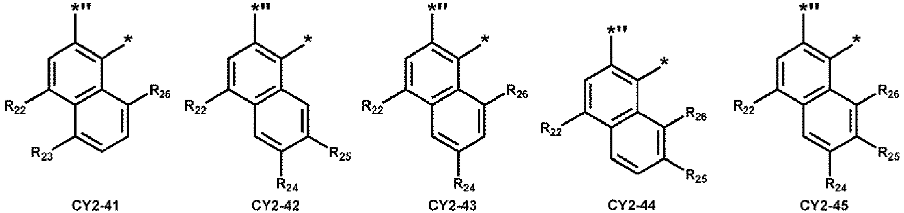 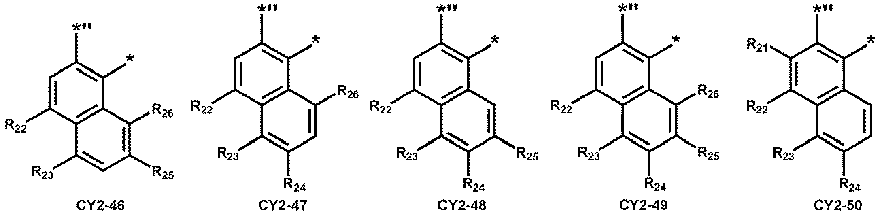 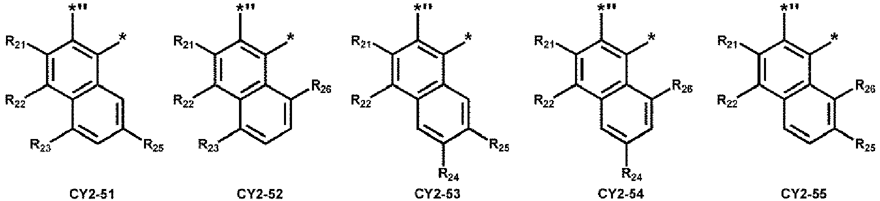 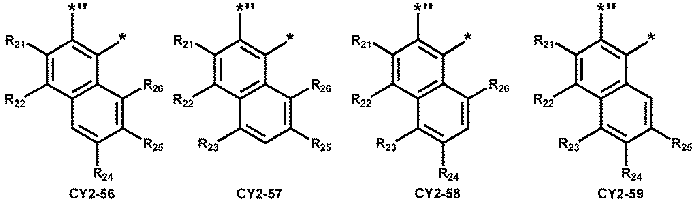
wherein, in Formulae CY2-1 to CY2-59,
R₂₁ to R₂₆ are the same as described in claim 1, and each of R₂₁ to R₂₆ is not hydrogen,
* is a binding site to Ir in Formula 1, and
*" is a binding site to a neighboring atom in Formula 1.

8. The organometallic compound of any of claims 1-7, wherein a group represented by 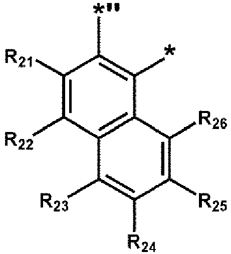 in Formula 1 is a group represented by one of Formulae 4-1 to 4-3: 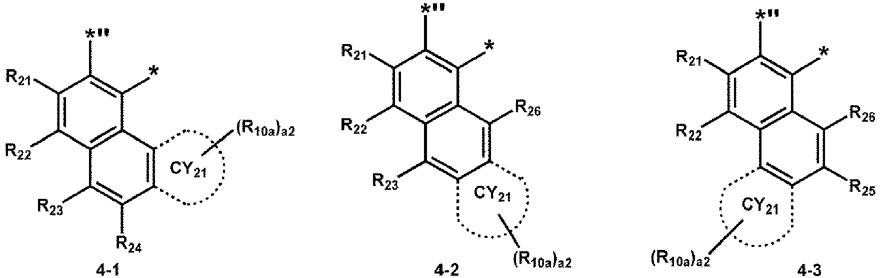 wherein, in Formulae 4-1 to 4-3,
R₂₁ to R₂₆ and R₁₀ₐ are the same as described in claim 1,
ring CY₂₁ is a C₅-C₃₀ carbocyclic group or a C₁-C₃₀ heterocyclic group,
a2 is an integer from 0 to 20,
* is a binding site to Ir in Formula 1, and
*" is a binding site to a neighboring atom in Formula 1.

9. The organometallic compound of any of claims 1-8, wherein R₃₀ₐ is a group represented by *-C(R₃₁)(R₃₂)(R₃₃), and at least one of R₃₁ to R₃₃ is not a methyl group.

10. The organometallic compound of any of claims 1-9, wherein at least one of <Condition A1> to <Condition A3> is satisfied, or
<Condition A1 > and <Condition A2> are each satisfied:
<Condition A1 >
R₃₀ₐ is a group represented by *-C(R₃₁)(R₃₂)(R₃₃), and
R₃₁ to R₃₃ are each independently a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
<Condition A2>
R₃₀ₐ is a group represented by *-C(R₃₁)(R₃₂)(R₃₃), and
each of at least one of R₃₁ to R₃₃ is independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and
<Condition A3>
R₃₀ₐ is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

11. The organometallic compound of any of claims 1-10, wherein at least one of <Condition B1> to <Condition B3> is satisfied, or
<Condition B1> and <Condition B2> are each satisfied:
<Condition B1>
R_{30b} is a group represented by *-C(R₃₄)(R₃₅)(R₃₆), and
R₃₄ to R₃₆ are each independently a substituted or unsubstituted C₁-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group,
<Condition B2>
R_{30b} is a group represented by *-C(R₃₄)(R₃₅)(R₃₆), and
each of at least one of R₃₄ to R₃₆ is independently a substituted or unsubstituted C₂-C₆₀ alkyl group, a substituted or unsubstituted C₃-C₁₀ cycloalkyl group, a substituted or unsubstituted C₁-C₁₀ heterocycloalkyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group, and
<Condition B3>
R_{30b} is a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₁-C₆₀ heteroaryl group, a substituted or unsubstituted monovalent non-aromatic condensed polycyclic group, or a substituted or unsubstituted monovalent non-aromatic condensed heteropolycyclic group.

12. The organometallic compound of claim 1, wherein the organometallic compound is one of Compounds 1 to 46 below:

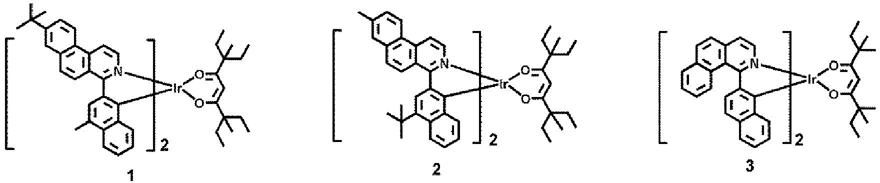

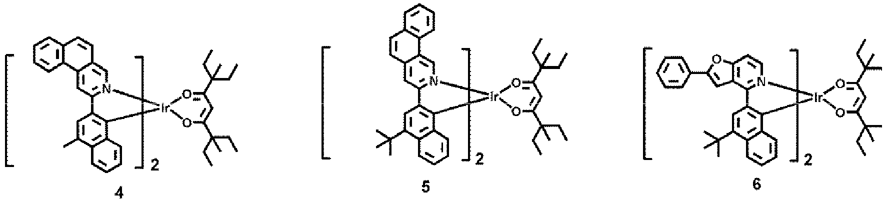

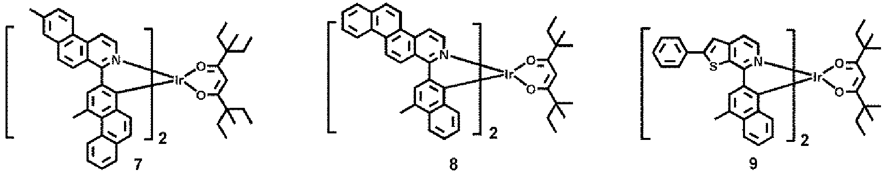

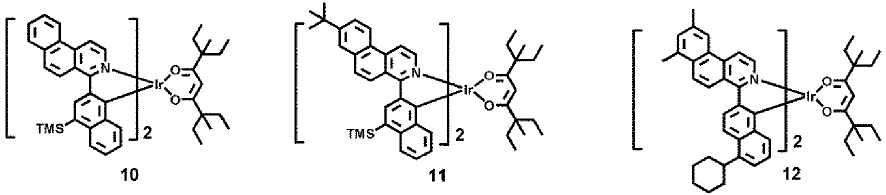

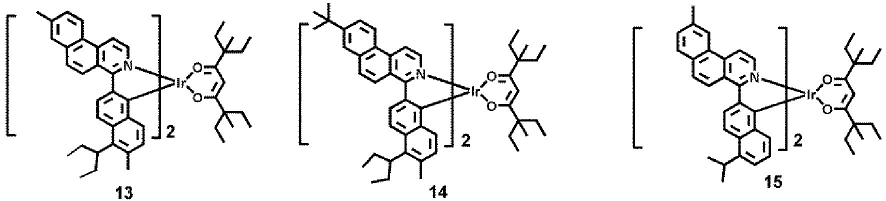

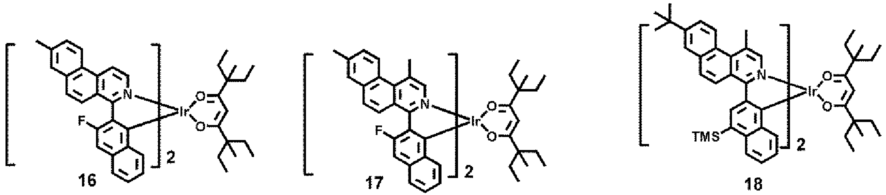

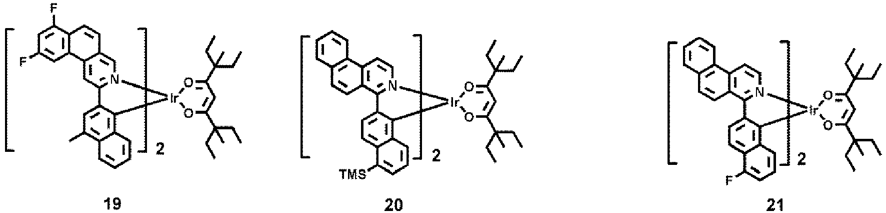

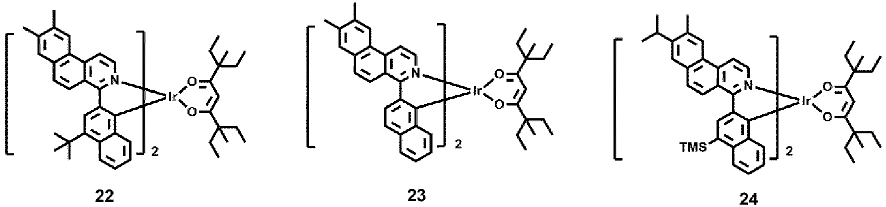

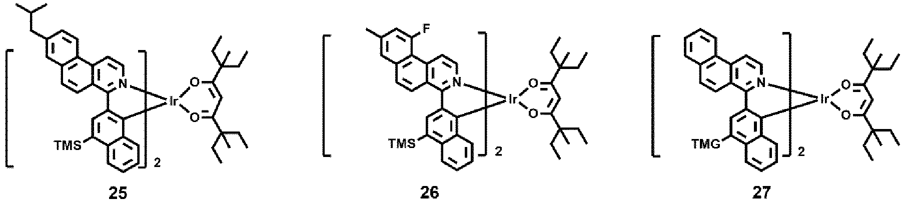

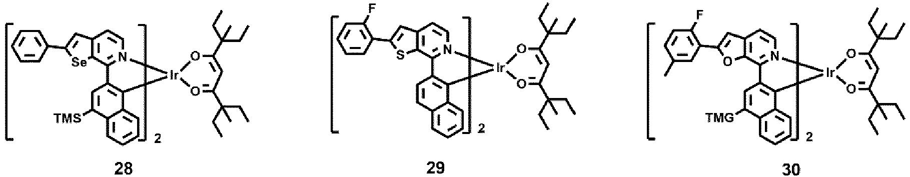

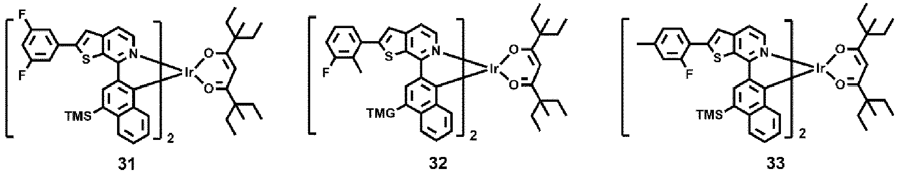

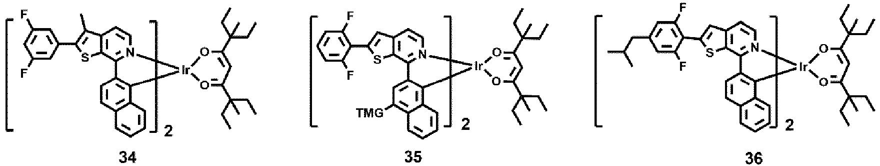

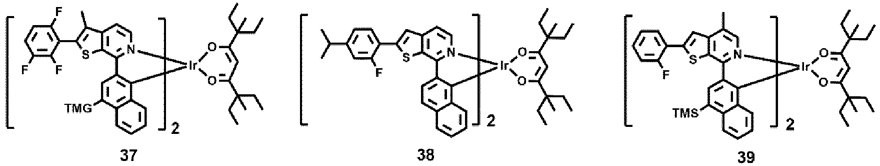

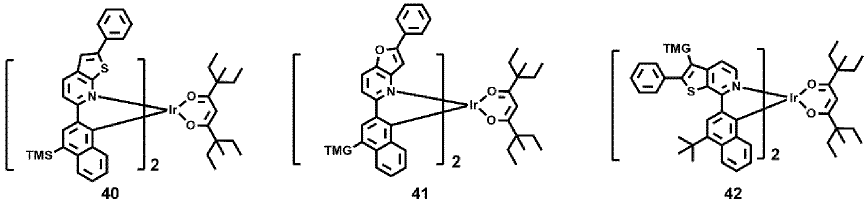

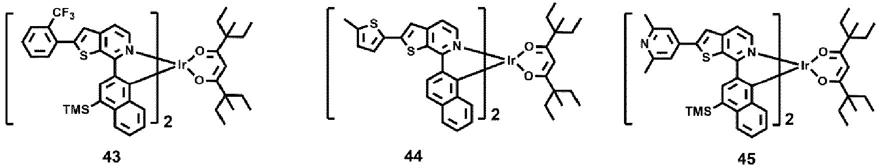

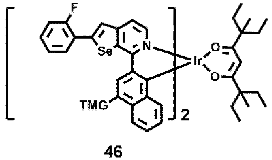

13. An organic light-emitting device comprising:
a first electrode,
a second electrode; and
an organic layer located between the first electrode and the second electrode and comprising an emission layer,
wherein the organic layer comprises at least one of the organometallic compound of any of claims 1-12;
preferably wherein the first electrode is an anode,
the second electrode is a cathode,
the organic layer further comprises a hole transport region between the first electrode and the emission layer and an electron transport region between the emission layer and the second electrode,
the hole transport region comprises a hole injection layer, a hole transport layer, an electron blocking layer, a buffer layer, or any combination thereof, and
the electron transport region comprises a hole blocking layer, an electron transport layer, an electron injection layer, or any combination thereof.

14. The organic light-emitting device of claim 13, wherein the organometallic compound is included in the emission layer,
preferably wherein the emission layer further comprises a host, and the amount of the host is greater than the amount of the organometallic compound.

15. An electronic apparatus comprising the organic light-emitting device of claims 13 or 14.

## Patentansprüche

1. Organometallische Verbindung, dargestellt durch die Formel 1: 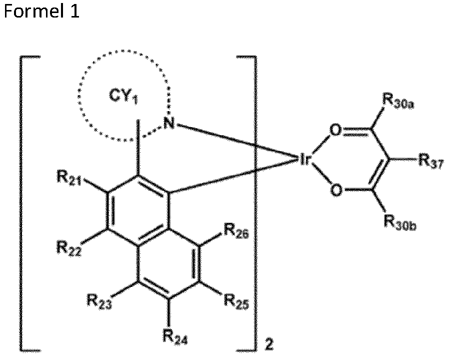
wobei, bezüglich Formel 1, Ring CY₁ eine Gruppe ist, die durch eine der Formeln CY1-1 bis CY1-9 dargestellt wird, 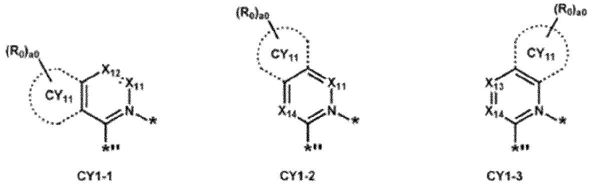 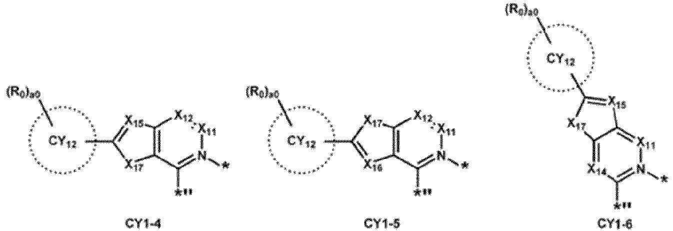 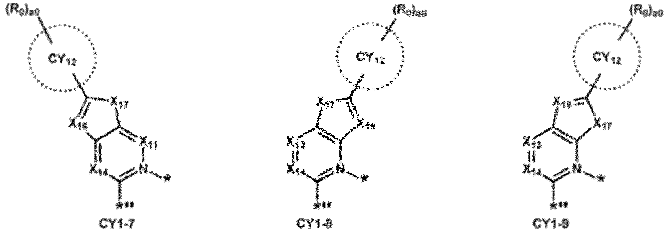
* in Formel CY1 -1 bis CY1 -9 eine Bindungsstelle an Ir in Formel 1 anzeigt und *" eine Bindungsstelle an ein benachbartes Kohlenstoffatom anzeigt,
Ring CY₁₁ in Formel CY1-1 bis CY1-3 eine polycyclische Gruppe ist, in der zwei oder mehr cyclische Gruppen miteinander kondensiert sind,
die cyclischen Gruppen und der Ring CY₁₂ in den Formeln CY1-4 bis CY1-9 jeweils eine C₅-C₃₀ -carbocyklische Gruppe oder eine C₁-C₃₀ -heterocyklische Gruppe sind,
in den Formeln CY1-1 bis CY1-9, X₁₁ C(R₁₁) oder N ist, X₁₂ C(R₁₂) oder N ist, X₁₃ C(R₁₃) oder N ist, X₁₄ C(R₁₄) oder N ist, X₁₅ C(R₁₅) oder N ist, X₁₆ C(R₁₆) oder N ist und X₁₇ O, S, N(R₁₇), C(R₁₈)(R₁₉) oder Si(R₁₈)(R₁₉) ist,
R₃₀ₐ eine Gruppe ist, dargestellt durch *-C(R₃₁)(R₃₂)(R₃₃), eine substituierte oder unsubstituierte C₃-C₁₀ -Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₁C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe,
R_{30b} eine Gruppe ist, dargestellt durch *-C(R₃₄)(R₃₅)(R₃₆),
R₀, R₁₁ bis R₁₉, R₂₁ bis R₂₆ und R₃₁ bis R₃₆ jeweils unabhängig voneinander Wasserstoff, Deuterium, -F, -Cl, -Br, -I, -SFs, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀ -Arylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte einwertige nicht-aromatische kondensierte polycyclische Gruppe, eine substituierte oder unsubstituierte einwertige nicht-aromatische kondensierte heteropolycyclische Gruppe, -N(Q₁)(Q₂), -Si(Q₃)(Q₄)(Q₅), -Ge(Q₃)(Q₄)(Q₅), -B(Q₆)(Q₇), -P(=O)(Q₈)(Q₉) oder -P(Q₈)(Q₉) ist und R₃₁ bis R₃₆ jeweils nicht Wasserstoff ist,
R₃₇ Wasserstoff, Deuterium, eine substituierte oder unsubstituierte C₁-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe ist,
a0 eine ganze Zahl von 0 bis 20 ist,
zwei oder mehr einer Vielzahl von R₀ optional miteinander verbunden sind zum Bilden einer C₅-C₃₀-carbocyclischenGruppe, die unsubstituiert oder substituiert ist mit mindestens einem R₁₀ₐ, oder einer C₁-C₃₀-heterocyclischen Gruppe, die unsubstituiert oder substituiert ist mit mindestens einem R₁₀ₐ,
zwei oder mehr von R₁₁ bis R₁₉ optional miteinander verbunden sind, zum Bilden einer C₅-C₃₀-carbocyclischen Gruppe, die unsubstituiert oder substituiert ist mit mindestens einem R₁₀ₐ, oder einer C₁-C₃₀-heterocyclischen Gruppe, die unsubstituiert oder substituiert ist mit mindestens einem R₁₀ₐ,
zwei oder mehr von R₁₁ bis R₁₉ und R₀ optional miteinander verbunden sind, zum Bilden einer C₅-C₃₀-carbocyclischen Gruppe, die unsubstituiert oder substituiert ist mit mindestens einem R₁₀ₐ, oder einer C₁-C₃₀-heterocyclischen Gruppe, die unsubstituiert oder substituiert ist mit mindestens einem R₁₀ₐ,
zwei oder mehr von R₂₁ bis R₂₆ optional miteinander verbunden sind, zum Bilden einer C₅-C₃₀-carbocyklischen Gruppe, die unsubstituiert oder substituiert ist mit mindestens einem R₁₀ₐ, oder einer C₁-C₃₀-heterocyklischen Gruppe, die unsubstituiert oder substituiert ist mit mindestens einem R₁₀ₐ,
zwei oder mehr von R₃₀ₐ, R_{30b}und R₃₇ optional miteinander verbunden sind, zum Bilden einer C₅-C₃₀-carbocyclischen Gruppe, die unsubstituiert oder substituiert ist mit mindestens einem R₁₀ₐ, oder eine C₁-C₃₀-heterocyclischen Gruppe, die unsubstituiert oder substituiert ist mit mindestens einem R₁₀ₐ,
R₁₀ₐ derselbe ist wie in Verbindung mit R₀beschrieben, und
die Substituenten der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₆-C₆₀-Aryloxygruppe, der substituierten C₆-C₆₀-Arylthiogruppe, der substituierten C₁-C₆₀-Heteroarylgruppe, der substituierten einwertigen nicht-aromatischen kondensierten polycyclischen Gruppe und der substituierten einwertigen nicht-aromatischen kondensierten heteropolycyclischen Gruppe jeweils unabhängig voneinander sind:
Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe oder eine C₁-C₆₀-Alkoxygruppe;
eine C₁-C₆₀-Alkylgruppe, eine C₂-C₆₀-Alkenylgruppe, eine C₂-C₆₀-Alkinylgruppe oder eine C₁-C₆₀-Alkoxygruppe, jeweils substituiert mit Deuterium, -F, -Cl, -Br, -I, -CD₃, -CD₂H, - CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nicht-aromatische kondensierte polycyclische Gruppe, eine einwertige nicht-aromatische kondensierte heteropolycyclische Gruppe, - N(Q₁₁)(Q₁₂), -Si(Q₁₃)(Q₁₄)(Q₁₅), -Ge(Q₁₃)(Q₁₄)(Q₁₅), - B(Q₁₆)(Q₁₇), -P(=O)(Q₁₈)(Q₁₉), -P(Q₁₈)(Q₁₉) oder eine beliebige Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁-C₆₀-Heteroarylgruppe, eine einwertige nicht-aromatische kondensierte polycyclische Gruppe oder eine einwertige nicht-aromatische kondensierte heteropolycyclische Gruppe, jeweils unsubstituiert oder substituiert mit Deuterium, -F, -Cl, -Br, -I, -CD₃, -CD₂H, -CDH₂, -CF₃, -CF₂H, -CFH₂, eine Hydroxylgruppe, eine Cyanogruppe, eine Nitrogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe, eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₆-C₆₀-Aryloxygruppe, eine C₆-C₆₀-Arylthiogruppe, eine C₁C₆₀-Heteroarylgruppe, eine einwertige nicht-aromatische kondensierte polycyclische Gruppe, eine einwertige nicht-aromatische kondensierte heteropolycyclische Gruppe, -N(Q₂₁)(Q₂₂), -Si(Q₂₃)(Q₂₄)(Q₂₅), - Ge(Q₂₃)(Q₂₄)(Q₂₅), -B(Q₂₆)(Q₂₇), -P(=O)(Q₂₈)(Q₂₉), -P(Q₂₈)(Q₂₉) oder eine beliebige Kombination davon;
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), -P(=O)(Q₃₈)(Q₃₉) oder -P(Q₃₈)(Q₃₉); oder
eine beliebige Kombination davon;
wobei Q₁ bis Q₉, Q₁₁ bis Q₁₉, Q₂₁ bis Q₂₉ und Q₃₁ bis Q₃₉ jeweils unabhängig voneinander sind:
Wasserstoff; Deuterium; -F; -Cl; -Br; -I; eine Hydroxylgruppe; eine Cyanogruppe; eine Nitrogruppe; eine Amidinogruppe; eine Hydrazingruppe; eine Hydrazongruppe; eine Carbonsäuregruppe oder ein Salz davon; eine Sulfonsäuregruppe oder ein Salz davon; eine Phosphorsäuregruppe oder ein Salz davon; eine C₁-C₆₀-Alkylgruppe, die unsubstituiert oder substituiert ist mit Deuterium, eine C₁-C₆₀-Alkylgruppe, eine C₆-C₆₀-Arylgruppe oder eine beliebige Kombination davon; eine C₂-C₆₀-Alkenylgruppe; eine C₂-C₆₀-Alkinylgruppe; eine C₁-C₆₀-Alkoxygruppe; eine C₃-C₆₀-Cycloalkylgruppe; eine C₁-C₆₀-Heterocycloalkylgruppe; eine C₃-C₆₀-Cycloalkenylgruppe; eine C₁-C₆₀-Heterocycloalkenylgruppe; eine C₆-C₆₀-Arylgruppe, die unsubstituiert oder substituiert ist mit Deuterium, eine C₁-C₆₀-Alkylgruppe, eine C₆-C₆₀-Arylgruppe oder eine beliebige Kombination davon; eine C₆-C₆₀-Aryloxygruppe; eine C₆-C₆₀-Arylthiogruppe; eine C₁-C₆₀-Heteroarylgruppe; eine einwertige nicht-aromatische kondensierte polycyclische Gruppe; oder eine einwertige nicht-aromatische kondensierte heteropolycyclische Gruppe.

2. Organometallische Verbindung nach Anspruch 1, wobei Ring CY₁₁ in den Formeln CY1-1 bis CY1-3 a) eine kondensierte cyclische Gruppe ist, in der zwei oder mehr erste Ringe miteinander kondensiert sind, b) eine kondensierte cyclische Gruppe, in der zwei oder mehrere zweite Ringe miteinander kondensiert sind, oder c) eine kondensierte cyclische Gruppe, in der mindestens ein erster Ring mit mindestens einem zweiten Ring kondensiert ist,
Ring CY₁₂ in den Formeln CY1-4 bis CY1-9 i) ein erster Ring, ii) ein zweiter Ring, iii) eine kondensierte cyclische Gruppe, in der zwei oder mehr erste Ringe miteinander kondensiert sind, iv) eine kondensierte cyclische Gruppe ist, in der zwei oder mehr zweite Ringe miteinander kondensiert sind, oder v) eine kondensierte cyclische Gruppe, in der mindestens ein erster Ring mit mindestens einem zweiten Ring kondensiert ist,
der erste Ring eine Cyclopentangruppe, eine Cyclopentengruppe, eine Furangruppe, eine Thiopengruppe, eine Pyrrolgruppe, eine Silolgruppe, eine Germolgruppe, eine Borolgruppe, eine Selenophenengruppe, eine Phospholgruppe, eine Oxazolgruppe, eine Oxadiazolgruppe, eine Oxatriazolgruppe, eine Thiazolgruppe, eine Thiadiazolgruppe, eine Thiatriazolgruppe, eine Pyrazolgruppe, eine Imidazolgruppe, eine Triazolgruppe, eine Tetrazolgruppe, eine Azasilolgruppe, eine Azagermolgruppe, eine Azaborolgruppe, eine Azaselenophengruppe oder eine Azaphospholgruppe ist, und
der zweite Ring eine Adamantangruppe, eine Norbornangruppe, eine Norbornenegruppe, eine Bicyclo[1.1.1]pentangruppe, eine Bicyclo[2.1.1]hexangruppe, eine Bicyclo[2.2.2]octangruppe, eine Cyclohexangruppe, eine Cyclohexengruppe, eine Benzolgruppe, eine Pyridingruppe, eine Pyrimidingruppe, eine Pyrazingruppe, eine Pyridazin- oder eine Triazingruppe ist.

3. Organometallische Verbindung nach Anspruch 1 oder 2, wobei R₀, R₁₁ bis R₁₉, R₂₁ bis R₂₆, R₃₁ bis R₃₃ und R_{30b} jeweils unabhängig voneinander sind:
Wasserstoff, Deuterium, -F oder eine Cyanogruppe;
eine C₁-C₂₀-Alkylgruppe, unsubstituiert oder substituiert mit Deuterium, -F, eine Cyanogruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁C₂₀-Alkyl)C₃-C₁₀-Cycloalkylgruppe, eine C₁-C₁₀-Heterocycloalkylgruppe, eine deuterierte C₁-C₁₀-Heterocycloalkylgruppe, eine fluorierte C₁-C₁₀-Heterocycloalkylgruppe, eine (C₁-C₂₀-Alkyl)C₁-C₁₀-Heterocycloalkylgruppe, eine Phenylgruppe, eine deuterierte Phenylgruppe, eine fluorierte Phenylgruppe, eine (C₁-C₂₀-Alkyl)phenylgruppe, eine Biphenylgruppe, eine deuterierte Biphenylgruppe, eine fluorierte Biphenylgruppe, eine (C₁-C₂₀-Alkyl)biphenylgruppe, eine Dibenzofuranylgruppe, eine deuterierte Dibenzofuranylgruppe, eine fluorierte Dibenzofuranylgruppe, eine (C₁-C₂₀-Alkyl)dibenzofuranylgruppe, eine Dibenzothiophenylgruppe, eine deuterierte Dibenzothiophenylgruppe, eine fluorierte Dibenzothiophenylgruppe, eine (C₁-C₂₀-Alkyl)dibenzothiophenylgruppe oder eine beliebige Kombination davon;
eine C₃-C₁₀-Cycloalkylgruppe, eine C₁-C₁₀-Heterocycloalkylgruppe, eine Phenylgruppe, eine Biphenylgruppe, eine Naphthylgruppe, eine Pyridinylgruppe, eine Fluorenylgruppe, eine Carbazolylgruppe, eine Dibenzofuranylgruppe oder eine Bibenzothiophenylgruppe, die unsubstituiert oder substituiert mit Deuterium ist, -F, eine Cyanogruppe, eine C₁-C₂₀-Alkylgruppe, eine deuterierte C₁-C₂₀-Alkylgruppe, eine C₁-C₂₀-fluorierte Alkylgruppe, eine C₁-C₂₀-Alkoxygruppe, eine deuterierte C₁-C₂₀-Alkoxygruppe, eine C₁-C₂₀ fluorierte Alkoxygruppe, eine C₃-C₁₀-Cycloalkylgruppe, eine deuterierte ₃-C₁₀-Cycloalkylgruppe, eine fluorierte C₃-C₁₀-Cycloalkylgruppe, eine (C₁-C₂₀-Alkyl) C₃-C₁₀-Cycloalkylgruppe, eine C₁-C₁₀-Heterocycloalkylgruppe, eine deuterierte C₁-C₁₀ - Heterocycloalkylgruppe, eine fluorierte C₁-C₁₀-Heterocycloalkylgruppe, eine (C₁-C₂₀-Cycloalkylgruppe, eine C₁-C₁₀-heterocyclische Alkylgruppe, eine Phenylgruppe, eine deuterierte Phenylgruppe, eine fluorierte Phenylgruppe, eine (C₁-C₂₀-Alkyl)phenylgruppe, eine Biphenylgruppe, eine deuterierte Biphenylgruppe, eine fluorierte Biphenylgruppe, eine (C₁-C₂₀-Alkyl)biphenylgruppe, eine Dibenzofuranylgruppe, eine deuterierte Dibenzofuranylgruppe, eine fluorierte Dibenzofuranylgruppe, eine (C₁-C₂₀-Alkyl)dibenzofuranylgruppe, eine Dibenzothiophenylgruppe, eine deuterierte Dibenzothiophenylgruppe, eine fluorierte Dibenzothiophenylgruppe, eine (C₁-C₂₀-Alkyl)dibenzothiophenylgruppe oder eine beliebige Kombination davon; oder
-Si(Q₃)(Q₄)(Q₅) oder -Ge(Q₃)(Q₄)(Q₅);
wobei R₃₁ bis R₃₃ jeweils nicht Wasserstoff ist.

4. Organometallische Verbindung nach einem der Ansprüche 1-3, wobei mindestens einer von R₂₁ bis R₂₆ nicht Wasserstoff ist.

5. Organometallische Verbindung nach einem der Ansprüche 1-4, wobei mindestens einer von R₂₁ bis R₂₆ Folgendes ist:
Deuterium, -F oder eine Cyanogruppe;
eine C₁-C₂₀-Alkylgruppe, unsubstituiert oder substituiert mit Deuterium, -F, eine Cyanogruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀ -Alkyl) C₃-C₁₀-Cycloalkylgruppe, eine C₁-C₁₀-Heterocycloalkylgruppe, eine deuterierte C₁-C₁₀-Heterocycloalkylgruppe, eine fluorierte C₁-C₁₀-Heterocycloalkylgruppe, eine (C₁-C₂₀-Alkyl)C₁-C₁₀-Heterocycloalkylgruppe, eine Phenylgruppe, eine deuterierte Phenylgruppe, eine fluorierte Phenylgruppe, eine (C₁-C₂₀-Alkyl)phenylgruppe, eine Biphenylgruppe, eine deuterierte Biphenylgruppe, eine fluorierte Biphenylgruppe, eine (C₁-C₂₀-Alkyl)biphenylgruppe, eine Dibenzofuranylgruppe, eine deuterierte Dibenzofuranylgruppe, eine fluorierte Dibenzofuranylgruppe, eine (C₁-C₂₀-Alkyl)dibenzofuranylgruppe, eine Dibenzothiophenylgruppe, eine deuterierte Dibenzothiophenylgruppe, eine fluorierte Dibenzothiophenylgruppe, eine (C₁-C₂₀-Alkyl)dibenzothiophenylgruppe oder eine beliebige Kombination davon;
eine C₃-C₁₀-Cycloalkylgruppe, eine C₁-C₁₀-Heterocycloalkylgruppe, eine Phenylgruppe, eine Biphenylgruppe, eine Naphthylgruppe, eine Pyridinylgruppe, eine Fluorenylgruppe, eine Carbazolylgruppe, eine Dibenzofuranylgruppe oder eine Bibenzothiophenylgruppe, die unsubstituiert oder mit Deuterium substituiert ist, -F, eine Cyanogruppe, eine C₁-C₂₀-Alkylgruppe, eine deuterierte C₁-C₂₀-Alkylgruppe, eine C₁-C₂₀-fluorierte Alkylgruppe, eine C₁-C₂₀-Alkoxygruppe, eine deuterierte C₁-C₂₀-Alkoxygruppe, eine C₁-C₂₀ fluorierte Alkoxygruppe, eine C₃-C₁₀-Cycloalkylgruppe, eine deuterierte C₃-C₁₀-Cycloalkylgruppe, eine fluorierte C₃-C₁₀-Cycloalkylgruppe, eine (C₁-C₂₀-Alkyl)C₃-C₁₀-Cycloalkylgruppe, eine C₁-C₁₀-Heterocycloalkylgruppe, eine deuterierte C₁-C₁₀-Heterocycloalkylgruppe, eine fluorierte C₁-C₁₀-Heterocycloalkylgruppe, eine (C₁-C₂₀-Alkyl)C₁-C₁₀-heterocyclische Alkylgruppe, eine Phenylgruppe, eine deuterierte Phenylgruppe, eine fluorierte Phenylgruppe, eine (C₁-C₂₀-Alkyl)phenylgruppe, eine Biphenylgruppe, eine deuterierte Biphenylgruppe, eine fluorierte Biphenylgruppe, eine (C₁C₂₀-Alkyl)biphenylgruppe, eine Dibenzofuranylgruppe, eine deuterierte Dibenzofuranylgruppe, eine fluorierte Dibenzofuranylgruppe, eine (C₁-C₂₀-Alkyl)dibenzofuranylgruppe, eine Dibenzothiophenylgruppe, eine deuterierte Dibenzothiophenylgruppe, eine fluorierte Dibenzothiophenylgruppe, eine (C₁-C₂₀-Alkyl)dibenzothiophenylgruppe oder eine beliebige Kombination davon; oder
-Si(Q₃)(Q₄)(Q₅) oder -Ge(Q₃)(Q₄)(Q₅).

6. Organometallische Verbindung nach einem der Ansprüche 1-5, wobei Ring CY₁ eine Gruppe ist, die durch eine der Formeln CY1-1 bis CY1-3 dargestellt wird, und
mindestens einer von R₀(s) in der Anzahl a0 in den Formeln CY1-1 bis CY1-3 jeweils unabhängig voneinander Deuterium, -F, eine substituierte oder unsubstituierte C₁-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe ist; oder
wobei Ring CY₁ eine Gruppe ist, die durch eine der Formeln CY1-1 bis CY1-3 dargestellt wird, und mindestens einer von R₂₃ bis R₂₆ nicht Wasserstoff ist.

7. Organometallische Verbindung nach einem der Ansprüche 1-6, wobei eine Gruppe, die durch eine der Formeln CY1-1 bis CY1-3 dargestellt ist, eine Gruppe ist, die durch eine der Formeln CY1(1) bis CY1(15) dargestellt ist: 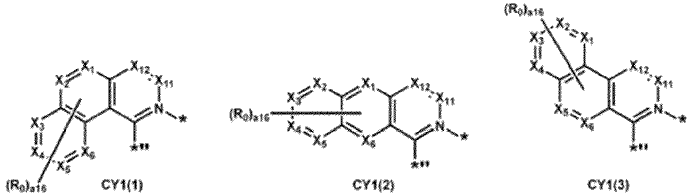 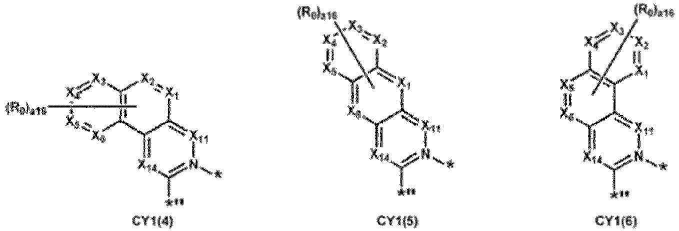 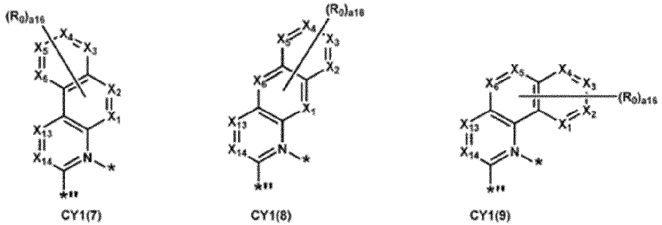 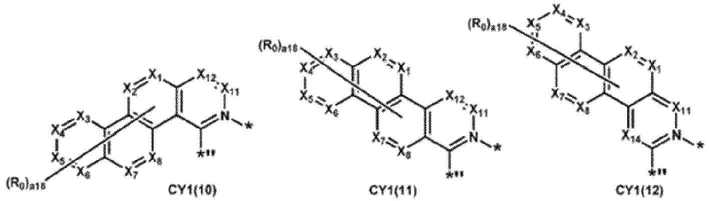 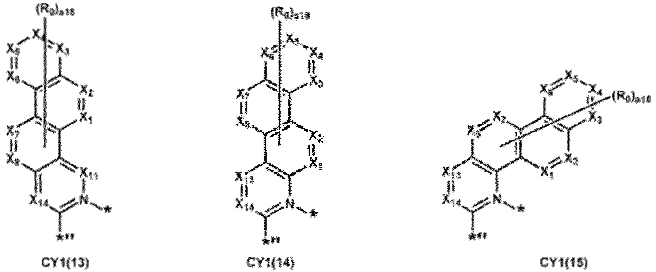 wobei, in den Formeln CY1(1) bis CY1(15),
X₁₁ bis X₁₄ und R₀ dieselben sind wie in Anspruch 1 beschrieben,
X₁ bis X₈ jeweils unabhängig C oder N sind, mindestens eines von X₁ bis X₆ der Formeln CY1 (1) bis CY1 (9) C ist und mindestens eines von X₁ bis X₈ der Formeln CY1 (10) bis CY1 (15) C ist,
a16 eine ganze Zahl von 0 bis 6 ist,
a18 eine ganze Zahl von 0 bis 8 ist,
* eine Bindungsstelle an Ir in Formel 1 ist, und
*" eine Bindungsstelle an ein benachbartes Kohlenstoffatom in Formel 1 ist; und/oder
wobei eine Gruppe, die durch in 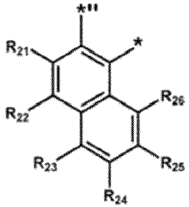 Formel 1 dargestellt ist,
eine Gruppe ist,
dargestellt durch eine der Formeln CY2-1 bis CY2-59: 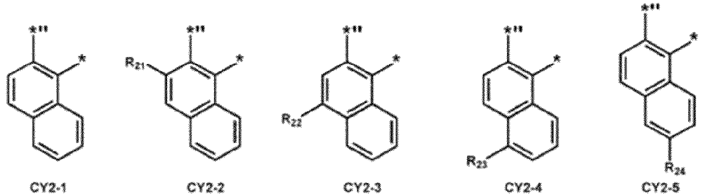 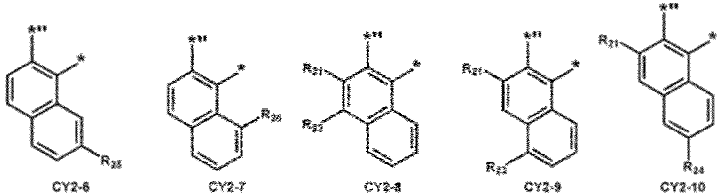 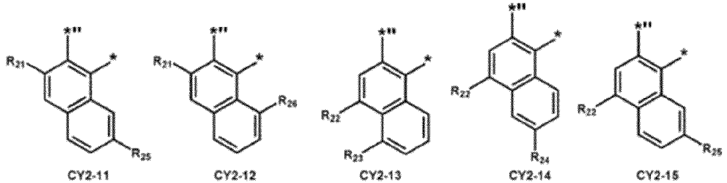 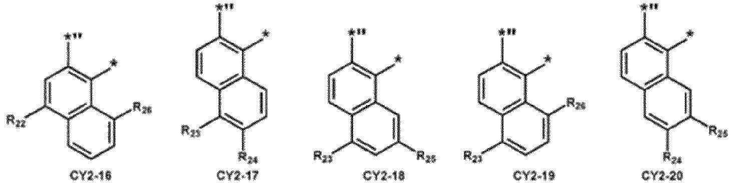 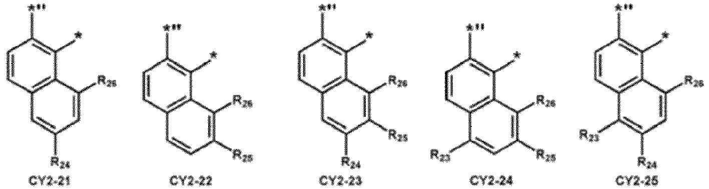 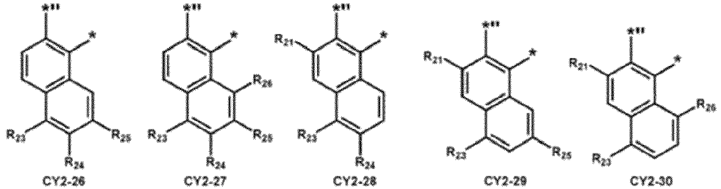 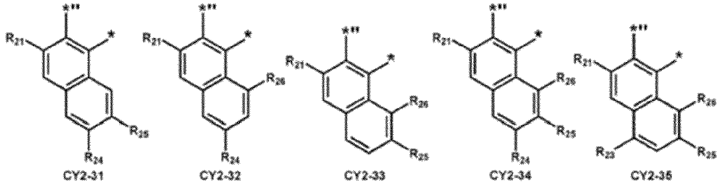 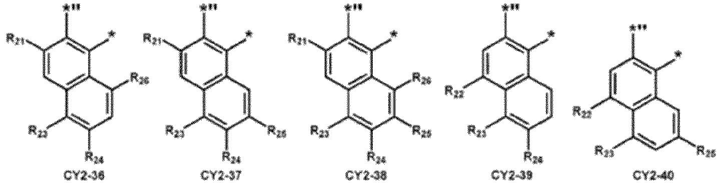 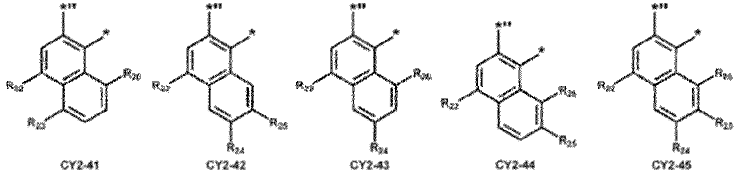 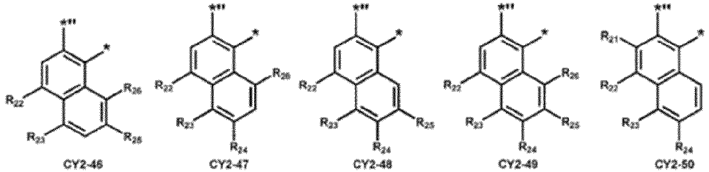 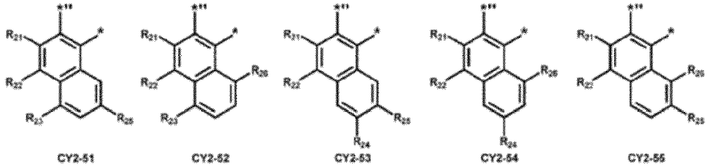 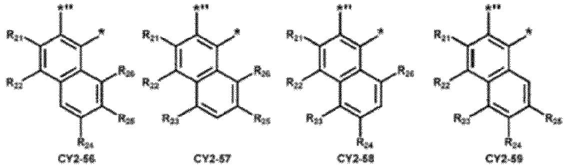
wobei in den Formeln CY2-1 bis CY2-59
R₂₁ bis R₂₆ dieselben sind wie in Anspruch 1 beschrieben, und R₂₁ bis R₂₆ jeweils nicht Wasserstoff ist,
* eine Bindungsstelle an Ir in Formel 1 ist, und
*" eine Bindungsstelle an ein benachbartes Atom in Formel 1 ist.

8. Organometallische Verbindung nach einem der Ansprüche 1 bis 7, wobei eine Gruppe dargestellt durch 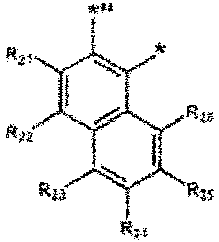 in Formel 1 eine Gruppe ist, dargestellt durch eine der Formeln 4-1 bis 4-3: 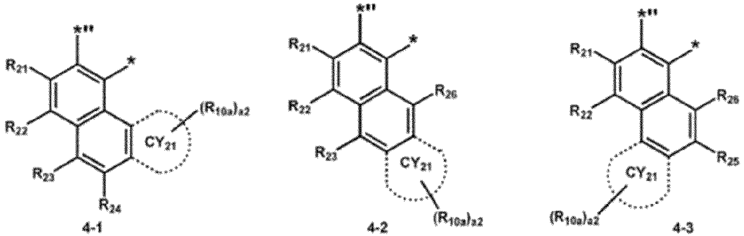 wobei, in den Formeln 4-1 bis 4-3
R₂₁ bis R₂₆ und R₁₀ₐ dieselben sind wie in Anspruch 1 beschrieben,
Ring CY₂₁ eine C₅-C₃₀-carbocyclische Gruppe oder eine C₁-C₃₀-heterocyclische Gruppe ist,
a2 eine ganze Zahl von 0 bis 20 ist,
* eine Bindungsstelle an Ir in Formel 1 ist, und
*" eine Bindungsstelle an ein benachbartes Atom in Formel 1 ist.

9. Organometallische Verbindung nach einem der Ansprüche 1-8, wobei R₃₀ₐ eine Gruppe ist, die dargestellt wird durch *-C(R₃₁)(R₃₂)(R₃₃), und mindestens einer von R₃₁ bis R₃₃ keine Methylgruppe ist.

10. Organometallische Verbindung nach einem der Ansprüche 1-9, wobei mindestens eine von <Bedingung A1> bis <Bedingung A3> erfüllt ist, oder
<Bedingung A1> und <Bedingung A2> jeweils erfüllt sind:
<Bedingung A1>
R₃₀ₐ ist eine Gruppe, dargestellt durch *-C(R₃₁)(R₃₂(R₃₃) und
R₃₁ bis R₃₃ sind jeweils unabhängig voneinander eine substituierte oder unsubstituierte C₁-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe,
<Bedingung A2>
R₃₀ₐ ist eine Gruppe, dargestellt durch *-C(R₃₁)(R₃₂)(R₃₃) und
jeder von mindestens einem von R₃₁ bis R₃₃ ist unabhängig voneinander eine substituierte oder unsubstituierte C₂-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe, und
<Bedingung A3>
R₃₀ₐ ist eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe.

11. Organometallische Verbindung nach einem der Ansprüche 1-10, wobei mindestens eine von < Bedingung B1> bis < Bedingung B3> erfüllt ist, oder
<Bedingung B1> und <Bedingung B2> jeweils erfüllt sind:
<Bedingung B1>
R_{30b} ist eine Gruppe, dargestellt durch *-C(R₃₄)(R₃₅)(R₃₆), und
R₃₄ bis R₃₆ sind jeweils unabhängig voneinander eine substituierte oder unsubstituierte C₁-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe,
<Bedingung B2>
R_{30b} ist eine Gruppe, dargestellt durch *-C(R₃₄)(R₃₅)(R₃₆), und
jeder von mindestens einem von R₃₄ bis R₃₆ ist jeweils unabhängig eine substituierte oder unsubstituierte C₂-C₆₀-Alkylgruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe, und
<Bedingung B3>
R_{30b} ist eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₁-C₆₀-Heteroarylgruppe, eine substituierte oder unsubstituierte einwertige nicht-aromatische kondensierte polycyclische Gruppe oder eine substituierte oder unsubstituierte einwertige nicht-aromatische kondensierte heteropolycyclische Gruppe.

12. Organometallische Verbindung nach Anspruch 1, wobei die organometallische Verbindung eine der nachfolgenden Verbindungen 1 bis 46 ist:

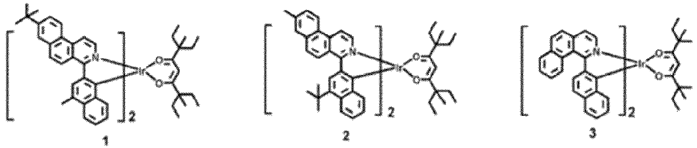

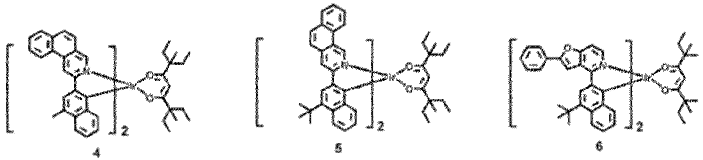

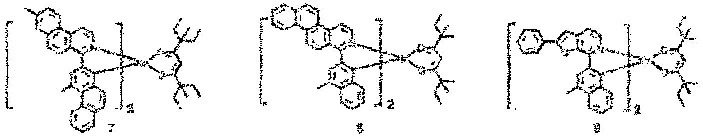

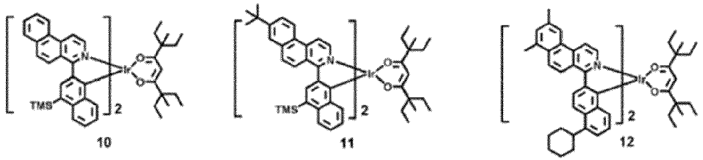

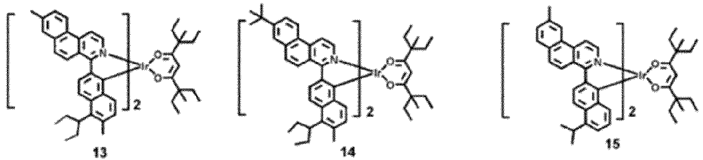

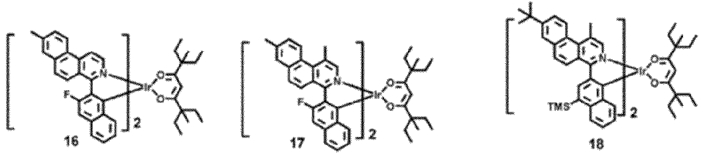

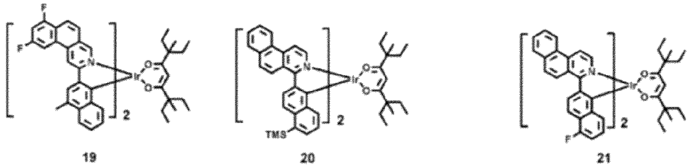

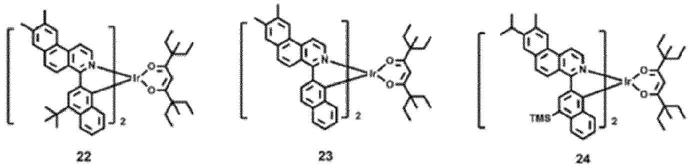

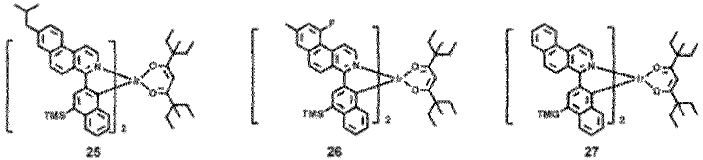

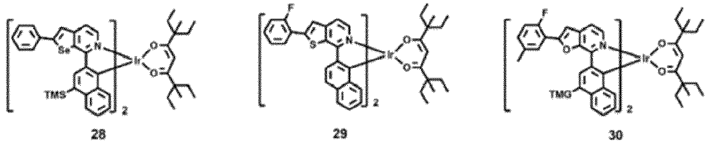

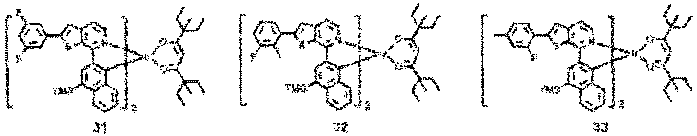

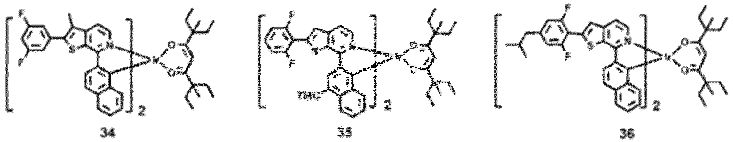

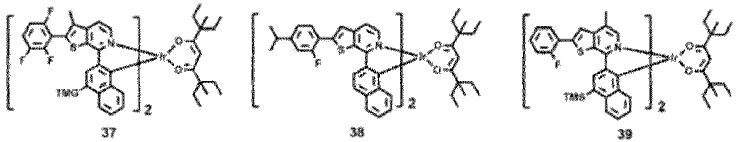

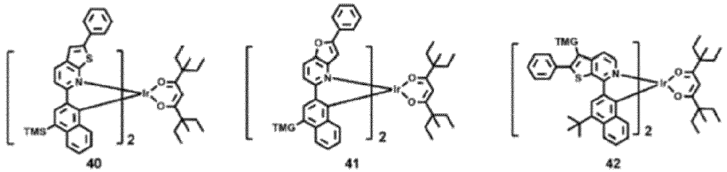

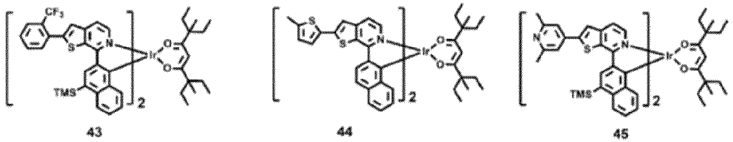

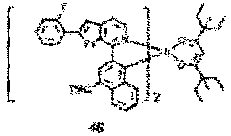

13. Organische lichtemittierende Vorrichtung, umfassend:
eine erste Elektrode,
eine zweite Elektrode; und
eine organische Schicht, die zwischen der ersten Elektrode und der zweiten Elektrode angeordnet ist und eine Emissionsschicht umfasst,
wobei die organische Schicht mindestens eine der organometallischen Verbindung nach einem der Ansprüche 1-12 umfasst;
wobei die erste Elektrode bevorzugt eine Anode ist,
die zweite Elektrode eine Kathode ist,
die organische Schicht weiter einen Lochtransportbereich zwischen der ersten Elektrode und der Emissionsschicht und einen Elektronentransportbereich zwischen der Emissionsschicht und der zweiten Elektrode umfasst,
der Lochtransportbereich eine Lochinjektionsschicht, eine Lochtransportschicht, eine Elektronenblockierschicht, eine Pufferschicht oder eine beliebige Kombination davon umfasst, und
der Elektronentransportbereich eine Lochblockierschicht, eine Elektronentransportschicht, eine Elektroneninjektionsschicht oder eine beliebige Kombination davon umfasst.

14. Organische lichtemittierende Vorrichtung nach Anspruch 13, wobei die organometallische Verbindung in der Emissionsschicht eingeschlossen ist;
wobei bevorzugt die Emissionsschicht weiter einen Wirt umfasst und die Menge des Wirts größer als die Menge der organometallischen Verbindung ist.

15. Elektronische Einrichtung, umfassend die organische lichtemittierende Vorrichtung nach Anspruch 13 oder 14.

## Revendications

1. Composé organométallique représenté par la Formule 1 : 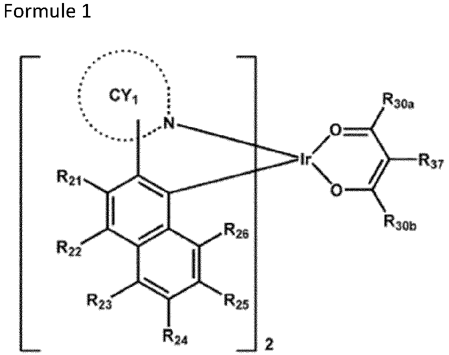
dans lequel, concernant la Formule 1, le cycle CY₁ est un groupe représenté par l'une des Formules CY1-1 à CY1-9, 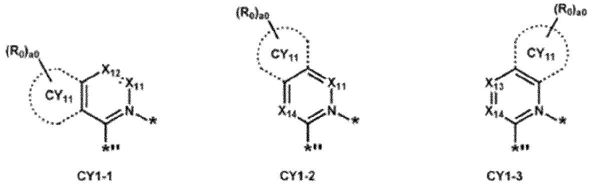 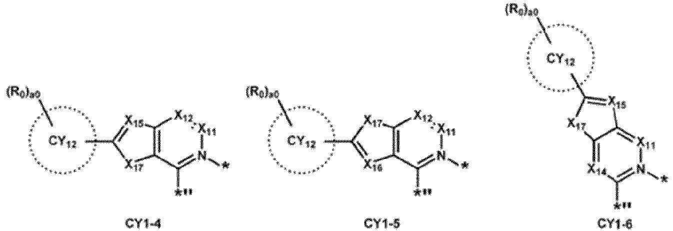 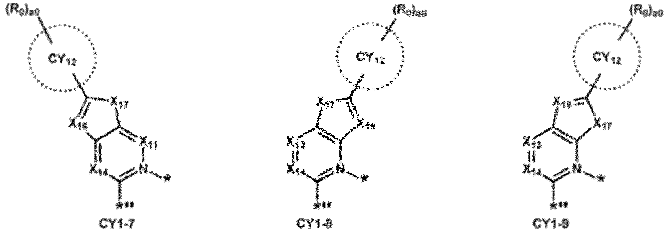
dans la Formule CY1 -1 à CY1 -9 * indique un site de liaison à Ir dans la Formule 1, et *" indique un site de liaison à un atome de carbone voisin,
le cycle CY₁₁ dans la Formule CY1-1 à CY1-3 est un groupe polycyclique dans lequel deux groupes cycliques, ou plus, sont condensés l'un avec l'autre ou les uns avec les autres,
les groupes cycliques et le cycle CY₁₂ dans les Formules CY1-4 à CY1-9 sont chacun un groupe carbocyclique en C₅-C₃₀ ou un groupe hétérocyclique en C₁-C₃₀,
dans les Formules CY1-1 à CY1-9, X₁₁ est C(R₁₁) ou N, X₁₂ est C(R₁₂) ou N, X₁₃ est C(R₁₃) ou N, X₁₄ est C(R₁₄) ou N, X₁₅ est C(R₁₃) ou N, X₁₆ est C(R₁₆) ou N, et X₁₇ est O, S, N(R₁₇), C(R₁₈)(R₁₉) ou Si(R₁₈)(R₁₉),
R₃₀ₐ est un groupe représenté par *-C(R₃₁)(R₃₂)(R₃₃), un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué,
R_{30b} est un groupe représenté par *-C(R₃₄)(R₃₅)(R₃₆),
R₀, R₁₁ à R₁₉, R₂₁ à R₂₆ et R₃₁ à R₃₆ sont chacun indépendamment de l'hydrogène, du deutérium, -F, -CI, -Br, -I, -SFs, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀ substitué ou non substitué, un groupe alcényle en C₂-C₆₀ substitué ou non substitué, un groupe alcynyle en C₂-C₆₀ substitué ou non substitué, un groupe alcoxy en C₁-C₆₀ substitué ou non substitué, un groupe alkylthio en C₁-C₆₀ substitué ou non substitué, un groupe cycloalkyle **en** C₃-C₁₀ non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe aryloxy en C₆-C₆₀ substitué ou non substitué, un groupe arylthio en C₆-C₆₀ substitué ou non substitué, un groupe hétéroaryle en C₁-C₆₀ substitué ou non substitué, un groupe polycyclique condensé non aromatique monovalent substitué ou non substitué, un groupe hétéropolycyclique condensé non aromatique monovalent substitué ou non substitué, -N(Q₁)(Q₂), -Si(Q₃)(Q₄)(Q₅), - Ge(Q₃)(Q₄)(Q₅), -B(Q₆)(Q₇), -P(=O)(Q₈)(Q₉), ou -P(Q₈)(Q₉), et chacun des R₃₁ à R₃₆ n'est pas hydrogène,
R₃₇ est de l'hydrogène, du deutérium, un groupe alkyle en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué,
A0 est un entier de 0 à 20,
deux, ou plus, d'une pluralité de R₀ sont éventuellement liés pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux des R₁₁ à R₁₉, ou plus, sont éventuellement liés pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux des R₁₁ à R₁₉ et R₀, ou plus, sont éventuellement liés pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux, des R₂₁ à R₂₆, ou plus, sont éventuellement liés pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
deux, des R₃₀ₐ, R_{30b}et R₃₇, ou plus, sont éventuellement liés pour former un groupe carbocyclique en C₅-C₃₀ qui est non substitué ou substitué par au moins un R₁₀ₐ ou un groupe hétérocyclique en C₁-C₃₀ qui est non substitué ou substitué par au moins un R₁₀ₐ,
R₁₀ₐ est le même que celui décrit en relation avec R₀, et
les substituants du groupe alkyle en C₁-C₆₀ substitué, du groupe alcényle en C₂-C₆₀ substitué, du groupe alcynyle en C₂-C₆₀ substitué, du groupe alcoxy en C₁-C₆₀ substitué, du groupe alkylthio en C₁-C₆₀ substitué, du groupe cycloalkyle en C₃-C₁₀ substitué, du groupe hétérocycloalkyle en C₁-C₁₀ substitué, du groupe cycloalcényle en C₃-C₁₀ substitué, du groupe hétérocycloalcényle en C₁-C₁₀substitué, du groupe aryle en C₆-C₆₀ substitué, du groupe aryloxy en C₆-C₆₀ substitué, du groupe arylthio en C₆-C₆₀ substitué, du groupe hétéroaryle en C₁-C₆₀ substitué, le groupe polycyclique condensé non aromatique monovalent substitué et le groupe hétéropolycyclique condensé non aromatique monovalent substitué sont chacun indépendamment :
du deutérium, -F, -CI, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀ ou un groupe alcoxy en C₁-C₆₀;
un groupe alkyle en C₁-C₆₀, un groupe alcényle en C₂-C₆₀, un groupe alcynyle en C₂-C₆₀ ou un groupe alcoxy en C₁-C₆₀, chacun substitué par du deutérium, -F, -CI, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆ -C₆₀, un groupe arylthio en C₆ -C₆₀, un groupe hétéroaryle en C₁-C₆₀, un groupe polycyclique condensé non aromatique monovalent, un groupe hétéropolycyclique condensé non aromatique monovalent, - N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(=O)(Q₁₈)(Q₁₉), -P(Q₁₈)(Q₁₉), ou n'importe quelle combinaison de ceux-ci ;
un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent ou un groupe hétéropolycyclique condensé non aromatique monovalent, chacun non substitué ou substitué par du deutérium, -F, -CI, -Br, -I, -CD₃, -CD₂H, -CDH₂, -CF₃, -CF₂H, -CFH₂, un groupe hydroxyle, un groupe cyano, un groupe nitro, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁-C₆₀, un groupe alcényle en C₂-C₆₀, un groupe alcynyle en C₂-C₆₀, un groupe alcoxy en C₁-C₆₀, un groupe cycloalkyle en C₃-C₁₀, un groupe hétérocycloalkyle en C₁-C₁₀, un groupe cycloalcényle en C₃-C₁₀, un groupe hétérocycloalcényle en C₁-C₁₀, un groupe aryle en C₆-C₆₀, un groupe aryloxy en C₆-C₆₀, un groupe arylthio en C₆-C₆₀, un groupe hétéroaryle en C₁-C₆₀, un groupe polycyclique condensé non aromatique monovalent, un groupe hétéropolycyclique condensé non aromatique monovalent, - N(Q₂₁)(Q₂₂), -Si(Q₂₃)(Q₂₄)(Q₂₅), -Ge(Q₂₃)(Q₂₄)(Q₂₅), -B(Q₂₆)(Q₂₇), -P(=O)(Q₂₈)(O₂₉), - P(Q₂₈)(O₂₉), ou n'importe quelle combinaison de ceux-ci ;
-N(Q₃₁)(Q₃₂), -Si(Q₃₃)(Q₃₄)(Q₃₅), -Ge(Q₃₃)(Q₃₃)(Q₃₅), -B(Q₃₆)(Q₃₇), -P(=O)(Q₃₈)(Q_{b9}), ou -P(Q₃₈)(Q₃₉) ; ou
n'importe quelle combinaison de ceux-ci.
dans lequel Q₁ à Q₉, Q₁₁ à Q₁₉, Q₂₁ à Q₂₉ et Q₃₁ à Q₃₉ sont chacun indépendamment :
de l'hydrogène ; du deutérium ; -F ; -C I ; -Br ; -I ; un groupe hydroxyle ; un groupe cyano ; un groupe nitro ; un groupe amidino ; un groupe hydrazine ; un groupe hydrazone ; un groupe acide carboxylique ou un sel de celui-ci ; un groupe acide sulfonique ou un sel de celui-ci ; un groupe acide phosphorique ou un sel de celui-ci ; un groupe alkyle en C₁-C₆₀ qui est non substitué ou substitué par du deutérium, un groupe alkyle en C₁-C₆₀, un groupe aryle en C₆-C₆₀ ou n'importe quelle combinaison de ceux-ci ; un groupe alcényle en C₂-C₆₀; un groupe alcynyle en C₂-C₆₀; un groupe alcoxy en C₁-C₆₀; un groupe cycloalkyle en C₃-C₆₀ ; un groupe hétérocycloalkyle en C₁-C₆₀ ; un groupe cycloalcényle en C₃-C₆₀ ; un groupe hétérocycloalcényle en C₁-C₆₀ ; un groupe aryle en C₆-C₆₀ qui est non substitué ou substitué par du deutérium, un groupe alkyle en C₁-C₆₀, un groupe aryle en C₆-C₆₀ ou n'importe quelle combinaison de ceux-ci ; un groupe aryloxy en C₆-C₆₀ ; un groupe arylthio en C₆-C₆₀ ; un groupe hétéroaryle en C₁-C₆₀ ; un groupe polycyclique condensé non aromatique monovalent ; ou un groupe hétéropolycyclique condensé non aromatique monovalent.

2. Composé organométallique selon la revendication 1, dans lequel le cycle CY₁₁ dans les Formules CY1-1 à CY1-3 est a) un groupe cyclique condensé dans lequel deux premiers cycles ou plus sont condensés l'un avec l'autre, ou les uns avec les autres, b) un groupe cyclique condensé dans lequel deux seconds cycles ou plus sont condensés l'un avec l'autre, ou les uns avec les autres, ou c) un groupe cyclique condensé dans lequel au moins un premier cycle est condensé avec au moins un second cycle,
le cycle CY₁₂ dans les Formules CY1-4 à CY1-9 est i) un premier cycle, ii) un second cycle, iii) un groupe cyclique condensé dans lequel deux premiers cycles ou plus sont condensés l'un avec l'autre, ou les uns avec les autres, iv) un groupe cyclique condensé dans lequel deux seconds cycles ou plus sont condensés l'un avec l'autre, ou les uns avec les autres, ou v) un groupe cyclique condensé dans lequel au moins un premier cycle est condensé avec au moins un second cycle,
le premier cycle est un groupe cyclopentane, un groupe cyclopentène, un groupe furane, un groupe thiophène, un groupe pyrrole, un groupe silole, un groupe germole, un groupe borole, un groupe sélénophène, un groupe phosphole, un groupe oxazole, un groupe oxadiazole, un groupe oxatriazole, un groupe thiazole, un groupe thiadiazole, un groupe thiatriazole, un groupe pyrazole, un groupe imidazole, un groupe triazole, un groupe tétrazole, un groupe azasilole, un groupe azagermole, un groupe azaborole, un groupe azasélénophène ou un groupe azaphosphole, et
le second cycle est un groupe adamantane, un groupe norbornane, un groupe norbornène, un bicyclo[1.1.1]pentane groupe, un bicyclo[2.1.1]hexane groupe, un bicyclo[2.2.2]octane groupe, un groupe cyclohexane, un groupe cyclohexène, un groupe benzène, un groupe pyridine, un groupe pyrimidine, un groupe pyrazine, un groupe pyridazine ou un groupe triazine.

3. Composé organométallique selon les revendications 1 ou 2, dans lequel R₀, R₁₁ à R₁₉, R₂₁ à R₂₆, R₃₁ à R₃₃et R_{30b} sont chacun indépendamment :
de l'hydrogène, du deutérium, -F ou un groupe cyano ;
un groupe alkyle en C₁-C₂₀ non substitué ou substitué par du deutérium, -F, un groupe cyano, un groupe cycloalkyle en C₃-C₁₀, un groupe cycloalkyle en C₃-C₁₀ deutéré, un groupe cycloalkyle en C₃-C₁₀ fluoré, un groupe cycloalkyle (alkyle en C₁-C₂₀) en C₃-C₁₀, un groupe hétérocycloalkyle en C₁-C₁₀, un groupe hétérocycloalkyle en C₁-C₁₀deutéré, un groupe hétérocycloalkyle en C₁-C₁₀fluoré, un groupe hétérocycloalkyle (alkyle en C₁-C₂₀) en C₁-C₁₀, un groupe phényle, un groupe phényle deutéré, un groupe phényle fluoré, un groupe phényle (alkyle en C₁-C₂₀), un groupe biphényle, un groupe biphényle deutéré, un groupe biphényle fluoré, un groupe (alkyle en C₁-C₂₀)biphényle, un groupe dibenzofuranyle, un groupe dibenzofuranyle deutéré, un groupe dibenzofuranyle fluoré, un groupe (alkyle en C₁-C₂₀)dibenzofuranyle, un groupe dibenzothiophényle, un groupe dibenzothiophényle deutéré, un groupe dibenzothiophényle fluoré, un groupe (alkyle en C₁-C₂₀)dibenzothiophényle, ou n'importe quelle combinaison de ceux-ci ;
un groupe cycloalkyle en C₃-C₁₀, un groupe hétérocycloalkyle en C₁-C₁₀, un groupe phényle, un groupe biphényle, un groupe naphtyle, un groupe pyridinyle, un groupe fluorényle, un groupe carbazolyle, un groupe dibenzofuranyle ou un groupe bibenzothiophényle, non substitué ou substitué par du deutérium, -F, un groupe cyano, un groupe alkyle en C₁-C₂₀, un groupe alkyle en C₁-C₂₀ deutéré, un groupe alkyle fluoré en C₁-C₂₀, un groupe alcoxy en C₁-C₂₀, un groupe alcoxy en C₁-C₂₀ deutéré, un groupe alcoxy fluoré en C₁-C₂₀, un groupe cycloalkyle en C₃-C₁₀, un groupe cycloalkyle en C₃-C₁₀ deutéré, un cycloalkyle en C₃-C₁₀ fluoré groupe, un groupe cycloalkyle (alkyle en C₁-C₂₀ ) en C₃-C₁₀, un groupe hétérocycloalkyle en C₁-C₁₀, un groupe hétérocycloalkyle en C₁-C₁₀ deutéré, un groupe hétérocycloalkyle en C₁-C₁₀fluoré, un groupe (alkyle en C₁-C₂₀) hétérocycloalkyle en C₁-C₁₀, un groupe phényle, un groupe phényle deutéré, un groupe phényle fluoré, un groupe (alkyle en C₁-C₂₀) phényle, un groupe biphényle, un groupe biphényle deutéré, un groupe biphényle fluoré, un groupe (alkyle en C₁-C₂₀) biphényle, un groupe dibenzofuranyle, un groupe dibenzofuranyle deutéré, un groupe dibenzofuranyle fluoré, un groupe (alkyle en C₁-C₂₀) dibenzofuranyle, un groupe dibenzothiophényle, un groupe dibenzothiophényle deutéré, un groupe dibenzothiophényle fluoré, un groupe (alkyle en C₁-C₂₀)dibenzothiophényle, ou n'importe quelle combinaison de ceux-ci ; ou
-Si(Q₃)(Q₄)(Q₅), ou -Ge(Q₃)(Q₄)(Q₅) ;
dans lequel chacun des R₃₁ à R₃₃ n'est pas de l'hydrogène.

4. Composé organométallique selon l'une quelconque des revendications 1-3, dans lequel au moins un des R₂₁ à R₂₆ n'est pas de l'hydrogène.

5. Composé organométallique selon l'une quelconque des revendications 1-4, dans lequel au moins un des R₂₁ à R₂₆ est :
du deutérium, -F ou un groupe cyano ;
un groupe alkyle en C₁-C₂₀ non substitué ou substitué par du deutérium, -F, un groupe cyano, un groupe cycloalkyle en C₃-C₁₀, un groupe cycloalkyle en C₃-C₁₀ deutéré, un groupe cycloalkyle en C₃-C₁₀ fluoré, un groupe cycloalkyle (alkyle en C₁-C₂₀) en C₃-C₁₀, un groupe hétérocycloalkyle en C₁-C₁₀, un groupe hétérocycloalkyle en C₁-C₁₀deutéré, un groupe hétérocycloalkyle en C₁-C₁₀fluoré, un groupe hétérocycloalkyle (alkyle en C₁-C₂₀) en C₁-C₁₀, un groupe phényle, un groupe phényle deutéré, un groupe phényle fluoré, un groupe phényle (alkyle en C₁-C₂₀), un groupe biphényle, un groupe biphényle deutéré, un groupe biphényle fluoré, un groupe (alkyle en C₁-C₂₀)biphényle, un groupe dibenzofuranyle, un groupe dibenzofuranyle deutéré, un groupe dibenzofuranyle fluoré, un groupe (alkyle en C₁-C₂₀)dibenzofuranyle, un groupe dibenzothiophényle, un groupe dibenzothiophényle deutéré, un groupe dibenzothiophényle fluoré, un groupe (alkyle en C₁-C₂₀)dibenzothiophényle, ou n'importe quelle combinaison de ceux-ci ;
un groupe cycloalkyle en C₃-C₁₀, un groupe hétérocycloalkyle en C₁-C₁₀, un groupe phényle, un groupe biphényle, un groupe naphtyle, un groupe pyridinyle, un groupe fluorényle, un groupe carbazolyle, un groupe dibenzofuranyle ou un groupe bibenzothiophényle, non substitué ou substitué par du deutérium, -F, un groupe cyano, un groupe alkyle en C₁-C₂₀, un groupe alkyle en C₁-C₂₀ deutéré, un groupe alkyle fluoré en C₁-C₂₀, un groupe alcoxy en C₁-C₂₀, un groupe alcoxy en C₁-C₂₀ deutéré, un groupe alcoxy fluoré en C₁-C₂₀, un groupe cycloalkyle en C₃-C₁₀, un groupe cycloalkyle en C₃-C₁₀ deutéré, un cycloalkyle en C₃-C₁₀ fluoré groupe, un groupe cycloalkyle (alkyle en C₁-C₂₀ ) en C₃-C₁₀, un groupe hétérocycloalkyle en C₁-C₁₀, un groupe hétérocycloalkyle en C₁-C₁₀ deutéré, un groupe hétérocycloalkyle en C₁-C₁₀fluoré, un groupe (alkyle en C₁-C₂₀) hétérocycloalkyle en C₁-C₁₀, un groupe phényle, un groupe phényle deutéré, un groupe phényle fluoré, un groupe (alkyle en C₁-C₂₀) phényle, un groupe biphényle, un groupe biphényle deutéré, un groupe biphényle fluoré, un groupe (alkyle en C₁-C₂₀) biphényle, un groupe dibenzofuranyle, un groupe dibenzofuranyle deutéré, un groupe dibenzofuranyle fluoré, un groupe (alkyle en C₁-C₂₀) dibenzofuranyle, un groupe dibenzothiophényle, un groupe dibenzothiophényle deutéré, un groupe dibenzothiophényle fluoré, un groupe (alkyle en C₁-C₂₀)dibenzothiophényle, ou n'importe quelle combinaison de ceux-ci ; ou
-Si(4₃)(Q₄)(Q5), ou -Ge(Q₃)(Q₄)(Q₅).

6. Composé organométallique selon l'une quelconque des revendications 1-5 , dans lequel le cycle CY₁ est un groupe représenté par l'une des Formules CY1-1 à CY1-3, et
au moins un des R₀(s) dans le nombre de a0 dans les Formules CY1-1 à CY1-3 représente chacun indépendamment du deutérium, -F, un groupe alkyle en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué ; ou
dans lequel le cycle CY₁ est un groupe représenté par l'une des Formules CY1-1 à CY1-3, et au moins l'un des R₂₃ à R₂₆ n'est pas hydrogène.

7. Composé organométallique selon l'une quelconque des revendications 1-6, dans lequel un groupe représenté par l'une des Formules CY1-1 à CY1-3 est un groupe représenté par l'une des Formules CY1(1) à CY1(15) : 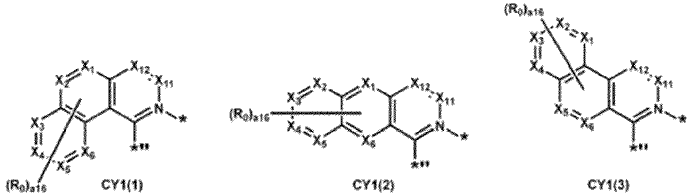 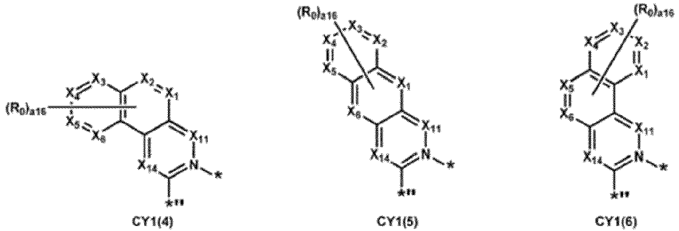 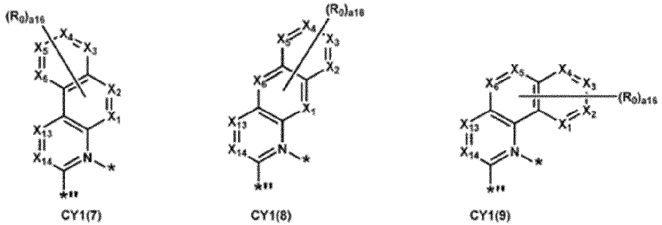 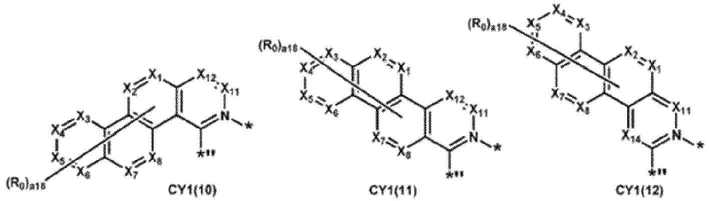 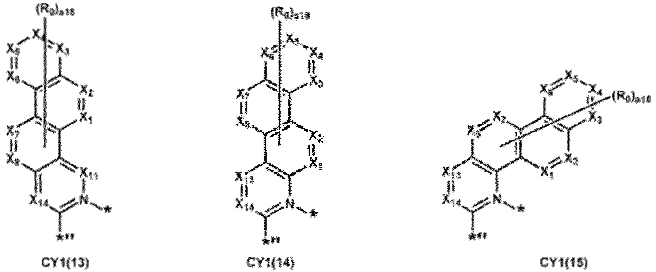 dans lequel, dans les Formules CY1(1) à CY1(15),
X₁₁ à X₁₄ et R₀ sont les mêmes que ceux décrits dans la revendication 1,
X₁ à X₈ sont chacun indépendamment C ou N, au moins un des X₁ à X₆ des Formules CY1 (1) à CY1 (9) est C, et au moins un des X₁ à X₈ des Formules CY1 (10) à CY1 (15) est C,
a16 est un nombre entier allant de 0 à 6,
a18 est un nombre entier allant de 0 à 8,
* est un site de liaison à Ir dans la Formule 1, et
*" est un site de liaison à un atome de carbone voisin dans la Formule 1 ; et/ou
dans lequel un groupe 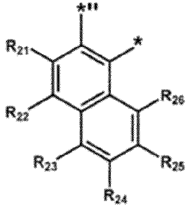 représenté par dans la Formule 1 est un groupe
représenté par l'une des Formules CY2-1 à CY2-59 : 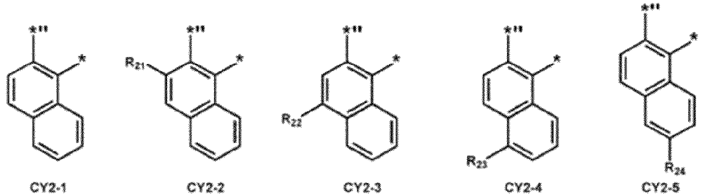 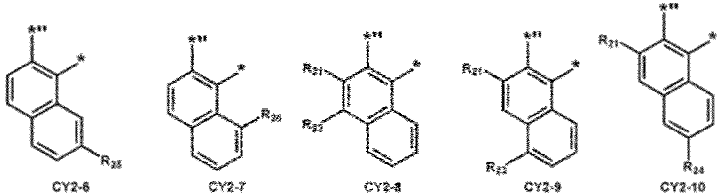 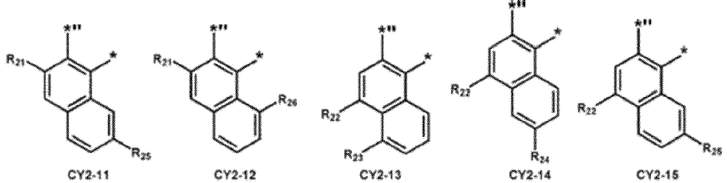 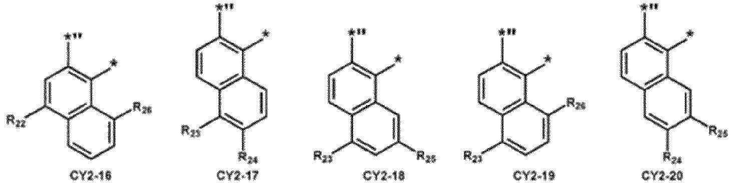 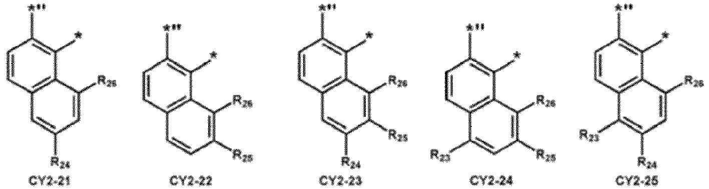 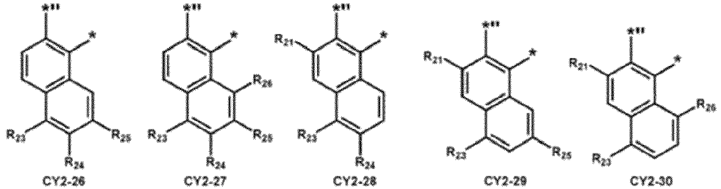 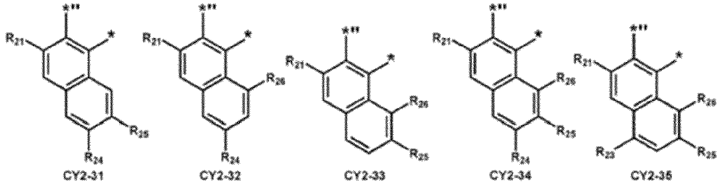 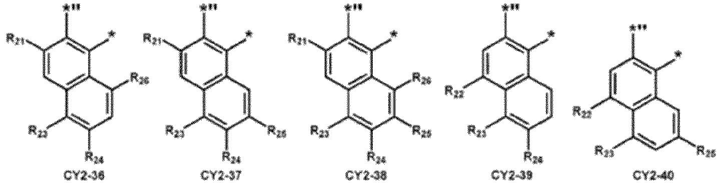 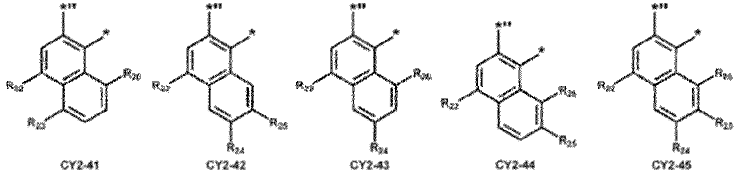 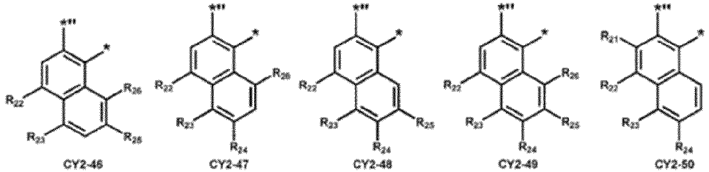 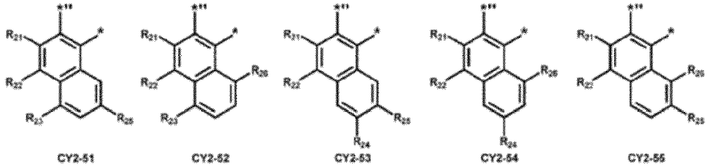 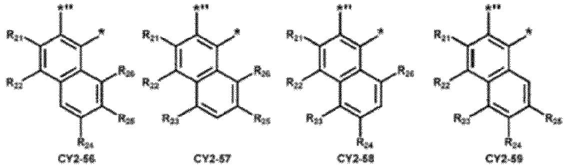 dans lequel, dans les Formules CY2-1 à CY2-59,
R₂₁ à R₂₆ sont les mêmes que ceux décrits dans la revendication 1, et chacun des R₂₁ à R₂₆ n'est pas de l'hydrogène,
* est un site de liaison à Ir dans la Formule 1, et
*" est un site de liaison à un atome voisin dans la Formule 1.

8. Composé organométallique selon l'une quelconque des revendications 1-7, dans lequel un groupe représenté par 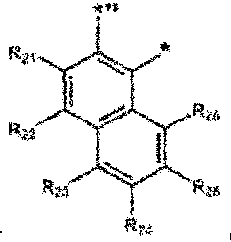 dans la Formule 1 est un groupe représenté par l'une des Formules 4-1 à 4-3 : 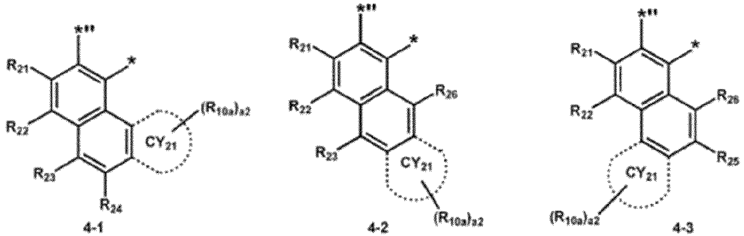 dans lequel, dans les Formules 4-1 à 4-3,
R₂₁ à R₂₆ et R₁₀ₐ sont les mêmes que ceux décrits dans la revendication 1,
le cycle CY₂₁ est un groupe carbocyclique en C₅-C₃₀ou un groupe hétérocyclique en C₁-C₃₀,
a2 est un nombre entier allant de 0 à 20,
* est un site de liaison à Ir dans la Formule 1, et
*" est un site de liaison à un atome voisin dans la Formule 1.

9. Composé organométallique selon l'une quelconque des revendications 1-8, dans lequel R₃₀ₐ est un groupe représenté par *-C(R₃₁)(R₃₂)(R₃₃), et au moins un des R₃₁ à R₃₃ n'est pas un groupe méthyle.

10. Composé organométallique selon l'une quelconque des revendications 1-9, dans lequel au moins une des < Condition A1> à < Condition A3> est remplie, ou
< Condition A1> et < Condition A2> sont chacune remplies :
< Condition A1>
R₃₀ₐ est un groupe représenté par *-C(R₃₁)(R₃₂)(R₃₃), et
R₃₁ à R₃₃ sont chacun indépendamment un groupe alkyle en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué,
< Condition A2>
R₃₀ₐ est un groupe représenté par *-C(R₃₁)(R₃₂)(R₃₃), et
chacun d'au moins un des R₃₁ à R₃₃ est indépendamment un groupe alkyle en C₂-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué, et
< Condition A3>
R₃₀ₐ est un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué.

11. Composé organométallique selon l'une quelconque des revendications 1-10, dans lequel au moins une des < Condition B1> à < Condition B3> est remplie, ou
< Condition B1> et < Condition B2> sont chacune remplies :
< Condition B1>
R_{30b} est un groupe représenté par *-C(R₃₄)(R₃₅)(R₃₆), et
R₃₄ à R₃₆ sont chacun indépendamment un groupe alkyle en C₁-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué,
< Condition B2>
R_{30b} est un groupe représenté par *-C(R₃₄)(R₃₅)(R₃₆), et
chacun d'au moins un des R₃₄ à R₃₆ est indépendamment un groupe alkyle en C₂-C₆₀ substitué ou non substitué, un groupe cycloalkyle en C₃-C₁₀ substitué ou non substitué, un groupe hétérocycloalkyle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué, et
< Condition B3>
R_{30b} est un groupe cycloalkyle en C₃-C₁₀ substitué ou non substitué, un groupe hétérocycloalkyle en C₁-C₁₀ substitué ou non substitué, un groupe cycloalcényle en C₃-C₁₀ substitué ou non substitué, un groupe hétérocycloalcényle en C₁-C₁₀ substitué ou non substitué, un groupe aryle en C₆-C₆₀ substitué ou non substitué, un groupe hétéroaryle en C₁-C₆₀ substitué ou non substitué, un groupe polycyclique condensé non aromatique monovalent substitué ou non substitué, ou un groupe hétéropolycyclique condensé non aromatique monovalent substitué ou non substitué.

12. Composé organométallique selon la revendication 1, dans lequel le composé organométallique est l'un des composés 1 à 46 ci-dessous :

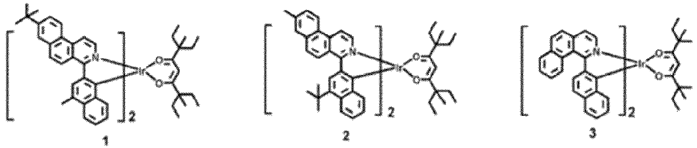

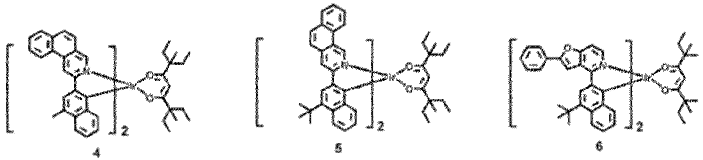

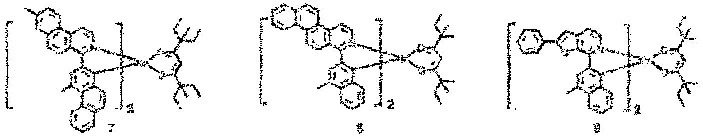

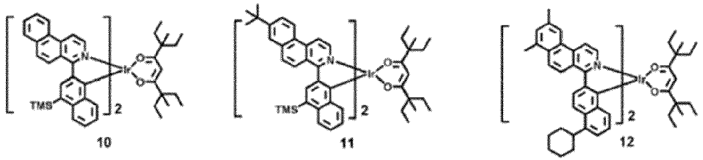

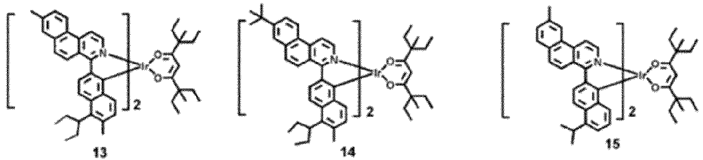

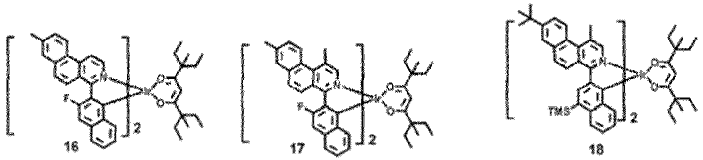

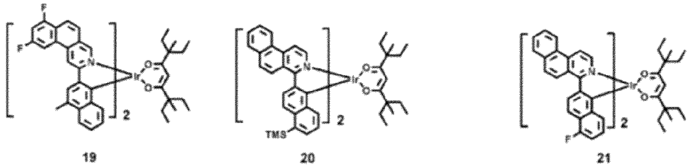

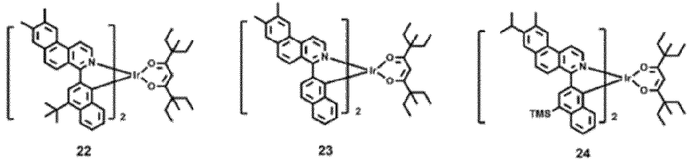

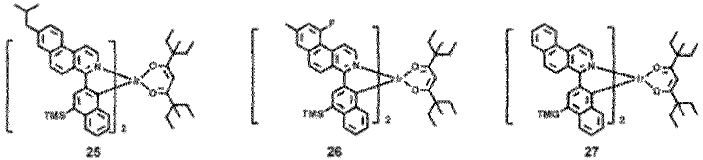

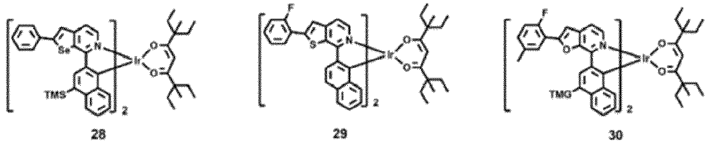

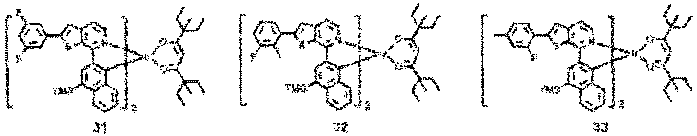

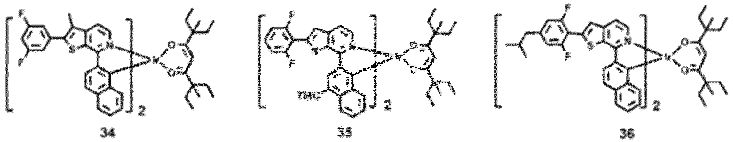

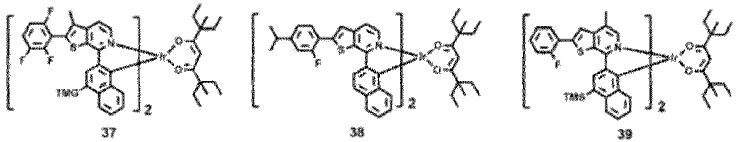

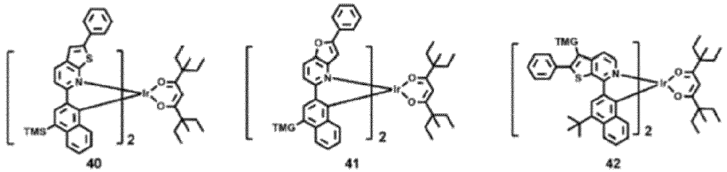

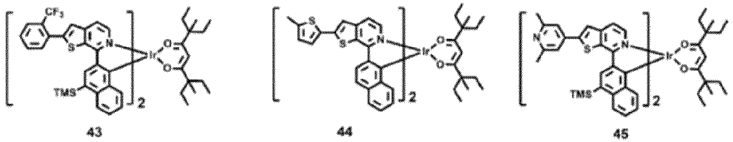

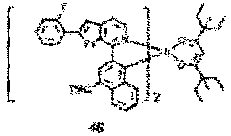

13. Dispositif électroluminescent organique comprenant :
une première électrode,
une seconde électrode ; et
une couche organique située entre la première électrode et la seconde électrode et comprenant une couche d'émission,
dans lequel la couche organique comprend au moins l'un des composés organométalliques selon l'une quelconque des revendications 1-12 ;
de préférence dans lequel la première électrode est une anode,
la seconde électrode est une cathode,
la couche organique comprend en outre une région de transport de trous entre la première électrode et la couche d'émission et une région de transport d'électrons entre la couche d'émission et la seconde électrode,
la région de transport de trous comprend une couche d'injection de trous, une couche de transport de trous, une couche de blocage d'électrons, une couche tampon ou n'importe quelle combinaison de celles-ci, et
la région de transport d'électrons comprend une couche de blocage de trous, une couche de transport d'électrons, une couche d'injection d'électrons ou n'importe quelle combinaison de celles-ci.

14. Dispositif électroluminescent organique selon la revendication 13, dans lequel le composé organométallique est inclus dans la couche d'émission ;
de préférence dans lequel la couche d'émission comprend en outre un hôte et la quantité de l'hôte est plus importante que la quantité du composé organométallique.

15. Appareil électronique comprenant le dispositif électroluminescent organique selon les revendications 13 ou 14.
